(19) Europäisches Patentamt
European Patent Office
Office européen des brevets

(11) Publication number: 0 381 591 A2

(12) **EUROPEAN PATENT APPLICATION**

(21) Application number: 90400299.5

(22) Date of filing: 02.02.90

(51) Int. Cl.5: H01L 29/10, H01L 29/812, H01L 29/82, H01L 29/06, H01L 29/205, H01L 29/60, //H03K19/094,H01L101:00

(30) Priority: 03.02.89 JP 26213/89
28.02.89 JP 46939/89
07.03.89 JP 54523/89
07.03.89 JP 54522/89
07.03.89 JP 54521/89

(43) Date of publication of application: 08.08.90 Bulletin 90/32

(84) Designated Contracting States: DE FR GB

(71) Applicant: FUJITSU LIMITED
1015, Kamikodanaka Nakahara-ku
Kawasaki-shi Kanagawa 211(JP)

(72) Inventor: Yokoyama, Naoki
2557-1-326, Tsumada
Atsugi-shi, Kanagawa 243(JP)
Inventor: Okada, Makoto
119, Shirane
Isehara-shi Kanagawa 259-11(JP)
Inventor: Sasa, Shigehiko
451, Whitman Avenue, No. D
Goleta, California 93117(US)
Inventor: Arimoto, Hiroshi
18-11, Sakuradai, Midori-ku
Yokohama-shi, Kanagawa 227(JP)

(74) Representative: Joly, Jean-Jacques et al
CABINET BEAU DE LOMENIE 55, rue d'Amsterdam
F-75008 Paris(FR)

(54) **Quantum interference semiconductor device.**

(57) A quantum interference semiconductor device for producing an output in response to interference of electron waves comprises a source region (214) for injecting electrons, a drain region (216) for collecting electrons, a passage (217) for flowing the injected electrons from the source region to the drain region, a passage dividing structure (218, 220, 222) provided in the passage for dividing the passage into a first region in contact with the source region and a second region in contact with the drain region by inducing depletion regions in the passage so as to prohibit the electrons flowing through the passage, the passage dividing structure having a longitudinal size approximately equal to or smaller than the inelastic and elastic scattering length of electrons and constructed such that a plurality of spot-like channel regions (224, 226) are provided in the passage dividing structure for passing the electrons from the first region to the second region in a form of electron waves with respective phase shifts, each of the plurality of spot-like channel regions having a lateral width confined approximately equal to or smaller than the de Broglie wavelength of the electrons passing therethrough, and a control structure (218, 220) for controlling the phase of electron waves passing through at least one of the plurality of spot-like channel regions.

EP 0 381 591 A2

# QUANTUM INTERFERENCE SEMICONDUCTOR DEVICE

## BACKGROUND OF THE INVENTION

The present invention generally relates to semiconductor devices and more particularly to a quantum interference semiconductor device utilizing the interference of electron waves.

With the progress of fine lithographic patterning technique, submicron patterning processes are now becoming available. Using such a submicron patterning technique, various semiconductor devices and integrated circuits having a high integration density and a high operational speed are fabricated. Such a success of submicron patterning, intended to realize the high speed semiconductor devices, has on the other hand raised a problem of hitherto rather hypothetical or purely theoretical nature that electrons behave as a quantum mechanical wave in the semiconductor device, as a problem of real concern. Such a wave nature of electrons, when appeared in the conventional type semiconductor devices such as bipolar or MOS transistors, inevitably deteriorates its performance by unwanted interference. In other words, there is an inherent limit, caused by the physical law, in the improvement of operational speed in the conventional type semiconductor devices which cannot be broken through by mere miniaturization of the device size or increase of the integration density, and the improvement of the operational speed of the semiconductor devices according to such a conventional approach is reaching its limit.

On the other hand, there is a different approach to realize super-fast semiconductor devices by utilizing the wave nature of electrons positively. By taking this approach, there is a possibility to realize much faster semiconductor devices with a speed beyond the foregoing limit by further increasing the integration density without being limited or restrained by the problem of excessive miniaturization of the device size. Such a device, when realized successfully, would provide an enormous impact to the human society.

Conventionally, a so-called quantum interference transistor (QUIT) is known which uses the interference of electron waves passed through two different channels. These electron waves have respective phases which may be shifted from each other by using the Aharonov-Bohm effect. According to the Aharonov-Bohm effect, a phase shift is induced in the electron waves in response to the application of electric or magnetic field to the electron waves. Thus, when the electric or magnetic field is applied to the electron waves passing through the foregoing two channels, the phase of one of the electron waves may be shifted relative to the other and various output states are obtained as a result of interference of these electron waves.

FIG.1 shows a known QUIT structure proposed by Bandyopadhyay et al. (Bandyopadhyay, S., Melloch, M.R., Datta, S., Das, B., Cooper Jr. J. A., and Lundstrom, M.S., IEEE IEDM86 76 - 79, 1986).

Referring to FIG.1, the device comprises a source region 11, a drain region 12, and a channel region 13 provided between the source and drain regions 11 and 12. The channel region 13 comprises gallium arsenide (GaAs) with a modulation doped structure and thus, carriers are formed in the region 13. The channel region 13 is divided into a first channel layer 13a and a second channel layer 13b grown on the layer 13a with a same composition and crystal conformity to the underlying layer 13a. The term crystal conformity herein means that there is substantially no physical boundary between the layer 13a and the layer 13b and the layers 13a and 13b behave as if a single crystal. Further, an island-like region 14 of gallium aluminium arsenide (AlGaAs) is provided between the layer 13a and layer 13b at an intermediate location between the source region 11 and the drain region 12. Further, a gate electrode 15 is provided above the channel layer 13b in correspondence to the island-like region 14.

When a gate voltage is applied to the gate electrode 15, there is established a difference in the electric potential between the channel layer 13a and the channel layer 13b as a result of the different distance from the electrode 15. Thus, the electron waves passed through the channel layer 13a and the channel layer 13b experience respective phase shifts when passing by the island-like region 14 as a result of the electrostatic Aharonov-Bohm effect. After passing by the island-like region 14, the electron waves cause interfere with each other upon merging and an output current is obtained from the drain region 12 in a form of the drain current reflecting the effect of interference. As the phase difference between the foregoing electron waves is proportional to the voltage applied to the gate electrode 15, it is predicted that the output drain current changes oscillatory with the gate voltage as shown in FIG.2 in correspondence to the constructive and destructive interference of the electron waves. In other words, the device of FIG.1 controls the drain current in response to the voltage applied to the gate electrode 15.

In this QUIT device, however, there is a problem in that the electron waves propagate in various directions particularly in a plane perpendicular to the plane of FIG.1. These electron waves propagating in different directions travel along different paths and thus the phase of the electron waves is influenced not only by the Aharonov-Bohm effect alone but also by the length of path of the electron waves. Thus, the interference of the electron waves is obscured as a result of a number of electron waves arriving with different paths and it is impossible to obtain the ideal characteristic shown in FIG.2. Note that the characteristic of FIG.2 is obtained by the simulation and does not represent the characteristic of the actually constructed device.

Further, the device of FIG.1 has a practical fabrication problem that its fabrication is extremely difficult. Note that the structure of FIG.1 requires the formation of the island-like region 14 of GaAs in the channel region 13. Such a structure has to be formed by first patterning an AlGaAs layer grown on the channel layer 13a to form the region 14, and further growing the channel layer 13b on the structure thus formed. In order to obtain a clear interference of two electron waves, it is necessary to set the length of the region 14, represented in FIG.1 by a length l, well below the elastic or inelastic scattering length of electrons in the channel region 13. When the elastic scattering of electron occurs, the phase of the electron waves may be changed because of the altered propagation path. When the inelastic scattering occurs, on the other hand, the phase information of the electron waves is lost entirely. In order to avoid the problem of scattering, it is necessary to form the region 14 such that its length l is substantially smaller than 1 µm. However, there is so far no technique available to form such a small region by photolithographic patterning. Note that the region 14 has to be formed such that the region 14 is defined by inclined front and rear edges as shown in FIG.1. Further, even when such a structure is formed, the scattering of electron waves at a boundary 13c formed between the layers 13a and 13b cannot be avoided as it is practically impossible to grow the layer 13b on the layer 13a without any inconformity in the crystal structure at the boundary 13c.

Meanwhile, there is another type of QUIT device operating on the same principle as shown in FIG.3. In this device, a ring structure 23 is provided between a source region 21 and a drain region 22. The ring structure 23 has a first connection part 23a extending in a first direction and connected to the source region 21, and a second connection part 23b extending in a second, opposing direction and connected to the drain region 22. The ring structure 23, including the first and second connection parts 23a and 23b, comprises a ring-shaped semi-insulating GaAs substrate 24, a ring-shaped GaAs channel region 25 grown thereon, and a ring-shaped n-type AlGaAs region 26 further grown on the region 25 for supplying electrons to the channel region 25. The connection parts 23a and 23b also have a similar layered structure.

The electron waves are emitted by the source region 21 responsive to the carrier injection and propagate along the first connection part 23a to the drain region 22. When an electron wave arrives at the ring structure 23, it is divided into first and second electron waves and merge again after passing through the ring structure 23. Thus, there occurs an interference of the first and second electron waves in the second connection part 23.

On one of the paths of the electron waves in the ring structure 23, there is provided an electrode 27 so as to apply an electric field to one of the electron waves. When an electric field applied, the phase of this electron wave is changed by the electrostatic Aharonov-Bohm effect and the interference of the electron waves is controlled similarly to the foregoing case.

In this prior art device, however, there is a problem in that the elastic scattering tends to occur rather frequently because the path of the electron waves is curved in the ring structure 23. As already noted, the elastic scattering changes the direction of propagation of the electron waves and thus the propagation path of the electron waves. As a result, the interference at the second connection part 23b is obscured and only a vague interference effect is observed as shown in FIG.4 which shows the output drain current $I_D$ of the device. Further, it is extremely difficult to form the gate electrode 27 such that the electric field is applied selectively to only one of the paths in the ring structure 23, as the ring structure 23 has to be formed to have an extremely small size such as less than 1 µm in diameter. Note that the gate electrode has to have a correspondingly small size in such a construction. Because of the foregoing reasons, the change in the magnitude of the drain current $I_D$ so far observed is less than 1 % of the total drain current.

Thus, both of the proposed quantum interference semiconductor devices have problems that they are difficult to fabricate and they cannot exhibit a clear interference of the electron waves.

## SUMMARY OF THE INVENTION

Accordingly, it is a general object of the present invention to provide a novel and useful quantum interference semiconductor device wherein the aforementioned problems are eliminated.

Another and more specific object of the present invention is to provide a quantum interference semiconductor device wherein the effect of interference of the electron waves appears clearly and wherein the device has a structure practical for fabrication.

Another object of the present invention is to provide a quantum interference semiconductor device, comprising a plurality of spot-like channel regions each comprising a quantum well structure for passing an electron wave, and means for controlling the phase of the electron waves passing through the spot-like channel regions, wherein the electric current flowing through the device is controlled by the interference of the electron waves passing through these spot-like channel regions. Herein, the spot-like channel region is defined as an extremely confined region formed in a semiconductor layer of which size is sufficiently confined in a first dimension so as to cause separation of the quantum levels in the quantum well structure well beyond the thermal excitation energy of electrons at the temperature at which the device is designed to be operated and is further confined in another dimension so that the spot-like channel region is approximately equal to or less than the elastic or inelastic scattering length of the electrons. According to the present invention, the spot-like channels can be formed without fabrication difficulty and an effective interference of the electron waves can be attained. In one embodiment, the spot-like channel may be provided as a region laterally bounded by a pair of depletion regions. In such a construction of the device, the phase of the electron waves passing through the channel regions can be controlled as desired by controlling the extension of the depletion regions which in turn changes the energy level of quantum states in the quantum well structure as well as by changing the energy level of the quantum states directly by applying a control voltage to the channel regions.

Another object of the present invention is to provide a quantum interference semiconductor device comprising a plurality of spot-like channel regions arranged so as to pass a plurality of electron waves, said plurality of electron waves being formed by splitting of a single electron wave travelling from an upstream side to a downstream side in correspondence to a single electron moving from a source region to a drain region upon passing through the plurality of spot-like channel regions, a gate electrode for controlling the phase of the electron waves thus passing through the plurality of spot-like channels, and another spot-like channel region provided at either one or both of the upstream side and the downstream side of the plurality of spot-like channel regions for defining an initial point and/or final point of the electron wave propagation through the plurality of spot-like channels. According to the present invention, the additional spot-like region provided at either or both of the upstream side and the downstream side of the plurality of spot-like channel regions increases the energetical coherency of these electron waves. Thus, the effect of the interference of the electron waves passing through the spot-like channel regions is augmented. By controlling the phase of the electron waves passing through the plurality of spot-like channel regions by the gate electrode, the phase of the electron waves and thus the current flowing through the device is controlled effectively.

Another object of the present invention is to provide a quantum interference semiconductor device comprising dividing means for dividing a single electron wave propagating from a source region to a drain region into a first and second electron waves travelling along respective paths, a plurality of spot-like channel regions provided at least in one of the paths of the first and second electron waves for passing the electron waves consecutively with phase shifts, and a plurality of gate electrodes provided for controlling the phase of the first and second electron waves, wherein the drain current is controlled by a combination of plurality of gate voltages applied to the plurality of the gate electrodes. According to the present invention, one of the electron waves passing through the plurality of spot-like channels causes a controlled interference with the other of the electron waves in response to the combination of gate voltages applied to the gate electrodes and thereby a logic operation becomes possible in correspondence to the combination of the gate voltages.

Another object of the present invention is to provide a quantum interference semiconductor device comprising dividing means for dividing a single electron wave, propagating from a source region to each of a plurality of drain regions, into a first electron wave and a second electron wave travelling along respective paths for each of the plurality of drain regions, a plurality of spot-like channel regions provided at least in one of the paths of the first and second electron waves for each of the plurality of drain regions for passing the electron waves consecutively with a predetermined phase shift, and a plurality of gate electrodes for controlling the phase of the first and second electron waves passing through the spot-like channel regions. According to the present invention, the flow of electrons can be switched between the plurality of drain regions by applying a combination of voltages to the plurality of gate electrodes. In other words, the quantum interference semiconductor device of the present invention performs a switching of electron flow such that the electrons flow from the source to selected one of the plurality of drains. Thus, the device can be used, individually or in combination, as a logic device performing a logic operation.

Another object of the present invention is to provide a quantum interference semiconductor device comprising dividing means for dividing each of a plurality of electron waves respectively propagating from a plurality of source regions to a plurality of drain regions, into a first electron wave and a second electron wave travelling along respective paths, a plurality of spot-like channel regions provided in the paths of each set of the first and second electron waves for passing the electron waves consecutively with predetermined phase shifts, and a plurality of gate electrodes for controlling the phase of the electron waves passing through said plurality of spot-like channels responsive to a combination of the gate voltages applied to the plurality of gate electrodes. According to the present invention, the flow of electrons is switched so as to flow from a selected source region to a selected drain region responsive to the combination of the gate voltages. Thus, the quantum interference semiconductor device of the present invention can be used, individually or in combination, as a logic device performing a logic operation.

Another object of the present invention is to provide a logic device by using one or a plurality of the quantum interference semiconductor devices. According to the present invention, various logic devices are constructed by using a reduced number of devices as compared to the case of conventional devices using conventional fundamental logic gates. Further, the speed of logic operation achieved by such logic devices is extremely fast because of the inherently small size of the quantum interference semiconductor device used therein. Further, the operational speed of the logic devices thus constructed can be increased without being restricted by the limit of miniaturization in contrast to the case of logic devices constructed by conventional semiconductor devices. Note that such limit in the miniaturization appears in the conventional semiconductor devices because of the wave nature of the electrons.

Other objects and further features of the present invention will become apparent from the following detailed description when read in conjunction with the attached drawings.

## BRIEF DESCRIPTION OF THE DRAWINGS

FIG.1 is a schematical cross-sectional view showing a prior art quantum interference semiconductor device;

FIG.2 is a graph showing a calculated operational characteristic of the device of FIG.1;

FIG.3 is a schematical perspective view showing another prior art quantum interference semiconductor device;

FIG.4 is a graph showing the operational characteristic obtained for the device of FIG.3;

FIG.5A is a plan view showing the principle of the quantum interference semiconductor device according to the present invention;

FIG.5B is a cross-sectional view taken along a line 5A-5A′ of FIG.5A;

FIG.5C is a cross-sectional view taken along a line 5B-5B′ of FIG.5A;

FIGS.6A and 6B are diagrams showing the band structure formed in the device respectively along the line 5A-5A′ and the line 5B-5B′;

FIG.7 is a graph schematically showing the effect of interference of electron waves obtained by the device of FIG.5A;

FIG.8 is a plan view showing a first embodiment of the quantum interference semiconductor device according to the present invention;

FIG.9A is an enlarged plan view showing an essential part of the device of FIG.8;

FIG.9B is a cross-sectional view showing the structure of the device taken along a line 9A-9A′ of FIG.9A;

FIG.10 is a graph showing the operational characteristic of the first embodiment device of the present invention;

FIGS.11A - 11D are cross-sectional views showing the various steps of fabricating the device of FIG.8;

FIG.12A is a plan view showing a second embodiment of the quantum interference semiconductor device of the present invention;

FIG.12B is a cross-sectional view showing the structure of the second embodiment device taken along the line 12A-12A′ of FIG.12A;

FIG.13A is an enlarged plan view showing the essential part of the device of FIG.12A;

FIG.13B is a cross-sectional view of the enlarged part of the device showing in FIG.13A along the lines 13A-13A′;

FIG.14 is a cross-sectional view showing a third embodiment of the quantum interference semiconductor device of the present invention;

FIG.15 is a graph showing the operational characteristic of the third embodiment device of FIG.14;

FIG.16 is a plan view showing the essential part of the quantum interference semiconductor device according to a fourth embodiment device of the present invention;

FIG.17 is a graph showing the operational characteristic of the device of FIG.17;

FIG.18 is a plan view showing a fifth embodiment of the quantum interference semiconductor device of the present invention;

FIG.19 is a plan view showing the essential part of the quantum interference semiconductor device according to a sixth embodiment of the present invention;

FIGS.20A - 20B are tables summarizing the operation of the sixth embodiment semiconductor device of the present invention;

FIGS.21A - 21C are diagrams showing the setting of threshold levels for distinguishing the high output level state and the low output level state respectively in correspondence to the operation shown in FIGS.20A - 20C;

FIG.22 is a plan view showing the essential part of the quantum interference semiconductor device according to a seventh embodiment of the present invention;

FIG.23 is a table summarizing the operation of the seventh embodiment device of the present invention;

FIG.24 is a plan view showing the essential part of the quantum interference semiconductor device according to an eighth embodiment of the present invention;

FIG.25 is a table summarizing the operation of the eighth embodiment device of the present invention;

FIG.26 is a diagram showing the setting of threshold levels for distinguishing the high level output state and the low level output state in the operation shown in the table of FIG.25;

FIG.27A is a plan view showing the essential part of the quantum interference semiconductor device according to a ninth embodiment of the present invention;

FIG.28A is a table summarizing the operation of the ninth embodiment device;

FIG.28B is a table summarizing the operation of the ninth embodiment device in another mode;

FIG.29 is a plan view showing the essential part of the quantum interference semiconductor device according to a tenth embodiment of the present invention;

FIG.30 is a table summarizing the operation of the device of FIG.29;

FIG.31 is a plan view showing the essential part of the quantum interference semiconductor device according to an eleventh embodiment of the present invention;

FIG.32 is a table summarizing the operation of the device of FIG.31;

FIG.33A is a circuit diagram showing the construction of a logic device using the quantum interference semiconductor device of the present invention;

FIG.33B is a table summarizing the operation of the logic device of FIG.33A;

FIG.34A is a circuit diagram showing the construction of another logic device using the quantum interference semiconductor device of the present invention;

FIG.35 is a circuit diagram showing the construction of another logic device using the quantum interference semiconductor device of the present invention;

FIG.36A is a circuit diagram showing the construction of another logic device using the quantum interference semiconductor device of the present invention;

FIG.36B is a table summarizing the operation of the logic device of FIG.36A;

FIG.37A is a circuit diagram showing the construction of another logic device using the quantum interference semiconductor device of the present invention;

FIG.37B is a table summarizing the operation of the logic device of FIG.37A;

FIG.38A is a circuit diagram showing the construction of a comparator using the quantum interference semiconductor device of the present invention;

FIG.38B is a table summarizing the operation of the comparator of FIG.38A;

FIG.39A is a circuit diagram showing the construction of a four-level priority encoder using the quantum interference semiconductor device of the present invention;

FIG.39B is a table summarizing the operation of the priority encoder of FIG.39A;

FIG.40A is a circuit diagram showing a construction of a half-adder using the quantum interference semiconductor device of the present invention;

FIG.40B is a table summarizing the operation of the half-adder of FIG.40A;

FIG.41A is a circuit diagram showing a construction of a full-adder using the quantum interference semiconductor device of the present invention;

FIG.41B is a table summarizing the operation of the full-adder of FIG.41A;

FIG.42A is a circuit diagram showing the construction of a three-bit decoder using the quantum interference semiconductor device of the present invention;

FIG.42B is a table summarizing the operation of the decoder of FIG.42A;

FIG.43A is a circuit diagram showing the construction of a two-bit comparator using the quantum interference semiconductor device of the present invention; and

FIG.43B is a table summarizing the operation of the two-bit comparator of FIG.43A.

## DETAILED DESCRIPTION

First, the principle of quantum interference semiconductor device of the present invention will be described with reference to FIGS.5A - 5C and FIGS.6A and 6B.

Referring to FIG.5A showing a schematical plan view of the simplified quantum interference semiconductor device, a channel region 103 is provided between a source region 101 and a drain region 102. Further, a region 104 which rejects the penetration of electrons and thus rejecting the passage of the electron waves is provided in the channel region 103 so that the channel region 103 is divided into a first region 103a at the side of the source region 101 and a second region 103b at the side of the drain region 102. Such a region 104 may be formed easily by a depletion region and thus, the region 104 will be referred to hereinafter as depletion region 104. This depletion region 104 on the other hand is formed with a pair of minute passages 105 and 106 of the electron waves, and is thus divided into depletion regions 104a - 104c by the passages 105 and 106. Thus, the electron waves can pass from the channel region 103a to the channel region 103b through the passages 105 and 106.

As will be described below, the depletion region 104 has a limited longitudinal length L and the passages 105 and 106 have a limited lateral width W such that the length L is smaller than the elastic or inelastic scattering length of the electrons in the medium forming the channel region 103, and the width W is sufficiently confined such that a quantum well is formed in such a passage. Thus, the passages 105 and 106 form spot-like channels of electron waves. Because of this reason, the passages 105 and 106 will be referred to hereinafter as spot-like channel regions.

FIGS.5B and 5C show the cross-section of the device of FIG.5A respectively taken along a line 5A-5A′ avoiding the depletion region 104 and along a line 5B-5B′ passing the region 104.

Referring to FIG.5B, the device comprises a semi-insulating substrate 110, an undoped active layer 111 grown on the substrate 110, a doped layer 112 of a material having a band gap larger than that of the material forming the doped layer 112 and grown on the active layer 111 for supplying electrons to the active layer 111. As a result of the heterojunction formed at a boundary between the layers 111 and 112, a two-dimensional electron gas schematically represented by a numeral 111a is formed in the active layer 111 adjacent to the foregoing boundary. In the plan view of FIG.5A, this two-dimensional electron gas is formed in the region 103a and the electrons in the electron gas move towards the drain region 102 without experiencing substantial scattering by the dopants.

In FIG.5A, the wave function of a single electron is represented as $\underline{\psi}$. As is well known, the square of the wave function at an arbitrary point represents the probability of finding electron at that point. Thus, the movement of electron is represented by the travelling of the electron wave which in turn is represented by the square of the wave function or $|\underline{\psi}|^2$. When the electron wave has reached the depletion region 104, the electron waves are split into a first electron wave of which wave function is represented as $\underline{\psi}_1$ and a second electron wave of which wave function is represented as $\underline{\psi}_2$. When these electron waves pass through the spot-like channel regions 105 and 106 and reach the region 103b, the electron waves cause an interference according to an equation represented as

$$|\underline{\psi}|^2 = |\underline{\psi}|_1^2 + |\underline{\psi}|_2^2 + 2|\underline{\psi}_1| \cdot |\underline{\psi}_2| \cdot \cos\underline{\phi} \qquad (1)$$

where $\underline{\phi}$ represents the phase difference between the first electron wave and the second electron wave. For the sake of simplicity, the normalization factor 1/4 is omitted from the foregoing equation.

Thus, when the phase difference $\underline{\phi}$ is zero or an even integer multiple of $\underline{\pi}$, there appears a constructive interference of the electron waves and a large drain current is obtained at the drain region 102. On the other hand, when the phase difference $\underline{\phi}$ is $\underline{\pi}$ or an odd integer multiple of $\underline{\pi}$, there appears a destructive interference and the drain current decreases because of the absence of electron. Note that the foregoing interference of the first and second electron waves takes place for each of the electrons emitted from the source region 101. It should be noted that the wavefront of the electron waves shown in FIG.5A does not represent a group of electrons moving in synchronization but the wave front of a single electron moving from the source region 101 to the drain region 102.

When the electron wave of the single electron passes through the spot-like channel regions 105 and 106 as the first and second electron waves, the electron waves are laterally confined by a pair of depletion regions 104a and 104b as well as by a pair of depletion regions 104b and 104c respectively as shown in the cross-sectional view of FIG.5C which is taken along the line 5B-5B′. When the width W of the spot-like channel regions 105 and 106 is comparable to the de Broglie wavelength or less, a quantum well structure is formed in the active layer as shown in FIG.6A. The actual observation of formation of such a quantum well structure in the laterally confined region is reported by van Wees et al. (van Bees, B.J., van Houten, H., Beenakker, C.W.J., and Williamson, J.G., Phys. Rev. Lett. 60, pp.848 - 850, 1988). In FIG.6A, it can be seen that there are formed discrete quantum levels such as $E_{01}$, $E_{01}'$, $E_{02}$, $E_{02}'$. Note that the width W is not only reduced to form the quantum well structure but is reduced to such an extent that the energetical separation ΔE between the adjacent quantum states formed in the quantum well exceeds the thermal excitation energy of electrons so that the thermal excitation does not cause the transition of the electrons from the ground state such as $E_{01}$ or $E_{02}$ to higher

quantum states such as $E_{01}'$ or $E_{02}'$.

Next, the behavior of the electron waves passing through the spot-like channel regions 105 and 106 will be described. As will be understood, FIG.6A shows a state in which the energy level of the ground state such as the levels $E_{01}$ and $E_{02}$ are identical to each other in the spot-like channel regions 105 and 106. When the first and second electron waves having the energy at the Fermi level $E_F$ enter the spot-like channel regions 105 and 106, the electron waves initially having a wave number $k_F$ represented as

$k_F = (2mE_F)^{1/2}/\hbar$ (2)

in the travelling direction now have the wave numbers $k_{F1}$ and $k_{F2}$ represented as

$k_{F1} = [2m(E_F - E_{01})]^{1/2}/\hbar$ (2a)

and

$k_{F2} = [2m(E_F - E_{02})]^{1/2}/\hbar$ (2b)

in the travelling direction, where m represents the mass of electron and $\hbar$ is the Planck's constant.

Thus, when either one of the energy levels $E_{01}$ and $E_{02}$ is changed with respect to the other as illustrated in FIG.6B by suitable means, the wave numbers $k_{F1}$ and $k_{F2}$ are changed from each other. Thereby, the phase of the electron waves arriving at the region 103b passing through the spot-like channel regions 105 and 106 are relatively shifted. Thus, by adjusting the energy levels $E_{01}$ and $E_{02}$, the interference of the first and second electron waves can be made constructive or destructive and the output of the device is controlled accordingly as shown in FIG.7. The energy levels $E_{01}$ and $E_{02}$ of the electron waves in the quantum well structure may be adjusted by controlling the width W of the spot-like channels 105 and 106 which in turn may be caused by adjusting the extension of the depletion regions 104a - 104b, or by applying an electric field to the spot-like channel regions 105 and 106, or by applying a magnetic field to the channel regions 105 and 106.

As will be described with reference to embodiments of the invention below, there may be a plurality of spot-like regions in the passages 105 and 106 each having a longitudinal length well below the length L. Even in such a case, undesirable scattering of electron waves in the passages 105 and 106, which is critical to the operation of the device, is avoided by setting the length L of the region 104 to be smaller than any of the elastic and inelastic scattering lengths, and the effect of electron wave interference is augmented.

Next, a first embodiment of the present invention will be described.

Referring to FIG. 8 showing the overall construction of the quantum interference semiconductor device of the present embodiment, the device comprises an undoped GaAs active layer 208 with a thickness of 500 nm grown on a semi-insulating GaAs substrate 207 which cannot be seen in this drawing (see the cross-sectional view of FIG.9B). On the active layer 208, there is provided an epitaxial layer 210 of n-type AlGaAs with a thickness of 45 nm and an impurity concentration level of 1.4 X $10^{18}$ $cm^{-3}$ for supplying electrons to the active layer 208 as will be described later, and a contact layer 212 of n-type GaAs with an impurity concentration level of also 1.4 X $10^{18}$ $cm^{-3}$ is provided further thereon with a thickness of about 30 nm (see FIG.9B to be described). As a result, a two-dimensional electron gas is formed in the active layer 208 adjacent to the heterojunction between the GaAs layer 208 and the AlGaAs layer 210 with a sheet carrier density of 3 X $10^{11}$ $cm^{-2}$ and a mobility of 300,000 $cm^2$/V.s at the temperature of 77 K. When the temperature is 4.2 K, the sheet carrier density becomes 3 X $10^{11}$ $cm^{-2}$ and the mobility of 700,000 $cm^2$/V.s is reached.

The layers 210 and 212 are patterned to form a mesa structure 217 as outlined in FIG.8 by a line 215 representing the side wall. The mesa structure 217 has a form in conformity with a source electrode 214 and a drain electrode 216 which are provided on the contact layer 212 included in the mesa structure 217 so as to make an ohmic contact therewith. Note that the mesa structure 217 has a pair of enlarged regions 217a and 217b, and a connecting region 217c bridges the regions 217a and 217b. Preferrably, the width of this connecting region 217c is approximately equal to or smaller than 5 $\mu$m. As the electron waves are propagated along this connecting region 217c, the region 217c will be referred to hereinafter as a channel structure. In this plan view, only the patterned layer 212 hatched in the drawing as well as the electrodes 214 and 215 provided thereon are represented in the mesa structure 217 while the layer 210 cannot be seen, as the layer 210 is located immediately below the layer 212. Note that the source and drain electrodes 214 and 216 are formed by stacking a gold-germanium alloy layer of a thickness of 200 Å on a gold layer having a thickness of 2000 Å, and make a desired ohmic contact with the underlying contact layer 212 after a suitable alloying process.

The source electrode 214 comprises a pad region 214a and an elongating region 214b extending towards the drain electrode while the drain electrode 216 comprises a pad region 216a and an elongating region 216b extending towards the source electrode 214. The region 214b of the source electrode 214 and the region 216b of the drain electrode 216 are separated by a minute distance as will be described and a sharply pointed tip end of a pair of generally triangular gate electrodes 218 and 220, provided on the active layer 208 directly at both sides of the mesa structure 217, invades into the channel structure 217c of the mesa structure 217 from both sides in correspondence to the gap between the electrode regions 214b and 216b.

Further, the exposed part of the active layer 208 not covered by the mesa structure 217 or by the gate electrodes 218 and 220 is made non-conductive by ion implantation of oxygen.

FIG.9A shows an enlarged view of a portion of the mesa structure 217 in the vicinity of the channel structure 217c to which the tip ends of the generally triangular gate electrodes 218 and 220 invade. As can be seen in FIG.9A, there are formed a pair of triangular cutouts 212d in the layer 212 such that a neck region 212c with a reduced width is formed in the layer 212 between the pair of opposing cutouts 212d, and the layer 210 located underneath the layer 212 is exposed through these cutouts 212d. The sharp pointed gate electrodes 218 and 220 are provided on these exposed parts of the doped AlGaAs layer 210 in conformity with the triangular shape of the cutouts 212d. In the drawing, the cutouts 212d are exaggerated so as to facilitate the understanding. Thus, one can see a part of the layer 210 at the gap between the edge of the cutout 212d and the rim of the gate electrode 218 or 220 in the drawing. Actually, the gate electrodes 218 and 220 are provided in close contact with the edge of the cutout 212d and no such a layer 210 can be seen in the plan view of the actual device. As the doped AlGaAs layer 210, on which the gate electrodes 218 and 220 are provided, is provided at a level higher than that of the surface of the active layer 208 in correspondence to the mesa structure 217, the electrode 218 extending from the surface of the active layer 208 to the channel structure 217c have a stepped part 218a as shown in FIG.9A and the electrode 218 is divided into a tip part 218b and a base part 218c by the stepped part 218a. Similarly, the gate electrode 220 is divided into a tip part 220b and a base part 220c by a stepped part 220a.

In this embodiment, the tip end of the tip parts 218a and 220a of the gate electrodes 218 and 220 have an angle of about 30 degrees and are separated from each other by about 0.5 µm which is the width of the neck region 212c of the layer 212. The gate electrodes 218 and 220 are made by stacking layers of gold, platinum and titanium respectively (Ti/Pt/Au) with thickensses of 200 Å, 500 Å and 300 Å, and make a Schottky contact with the underlying doped AlGaAs layer 210. Thus, a depletion region extends into the layer 210 and further into the active layer 208 underneath in correspondence to the gate electrodes 218 and 220. Further, a spot like semi-insulating region 222 with a diameter of about 0.1 µm is formed in the contact layer 212 generally in correspondence to a midpoint between the both tip ends of the gate electrodes 218 and 220. This region 222 may be formed by ion implantation of $Be^+$ using a focused ion beam and induces a spot-like depletion region in the layers 210 and 208 underneath as a result of the interface state. Alternatively, the region 222 may be formed as a depression by a focused ion beam etching by removing the material from the layer 210. In this case, too, the spot-like depletion regions is formed as a result of the interface state.

In the depletion regions, the electrons are expelled and thus, regions are formed under the gate electrodes 218 and 220 as well as under the spot-like region 222 where no electron wave can enter. The separation between the spot-like region 222 and the end 214b of the source electrode 214, or the separation between the region 222 and the end 216b of the drain electrode 216 is preferably set to be smaller than about 1 µm.

FIG.9B shows the cross-sectional view of the device taken along a line 9A-9A′ of FIG.9A. In this cross-sectional view, it can be seen that depletion regions 218e, 220e and 222a are formed respectively in correspondence to the gate electrode 218b, 220b and the semi-insulating region 222. These depletion regions extend into the substrate 207 passing through the doped AlGaAs layer 210 and further through the active layer 208 and thereby define a pair of spot-like channel regions 224 and 225 as illustrated. Because of the lateral extension of the depletion regions 218e and 220e, the spot-like channel regions 224 and 226 are confined laterally and typically has a lateral size of about 0.2 µm or less. When the lateral size of the channel regions 224 and 226 are confined as such, a quantum well similar to the one described with reference to FIGS.6A and 6B are formed and the electron wave of electrons in the two-dimensional electron gas, illustrated in FIG.9B by a numeral 227, experiences a change of the wave number upon passage through the spot-like channel regions as already described with reference to Eqs.(2a) and (2b).

In this embodiment, the extension of the depletion regions 218e and 220e is controlled as desired by controlling the gate voltage applied to the gate electrodes 218b and 220b, while the extension of the depletion region 222a is fixed. Thus, the width W of the spot-like channel region can be changed in response to the gate voltage or gate voltages and the energy level of the quantum states such as $E_{01}$ or $E_{02}$ measured from the bottom of the conduction band Ec is changed as shown in FIG.6B. Further, the level of the conduction band Ec itself is changed in response to the gate voltage. As a result, the electron waves passed through the spot-like channel regions 224 and 226 experience respective phase shifts and interfere with each other either constructively or destructively depending on the mutual phase difference.

In more detail, the phase difference $\phi$ between the two electron waves respectively passed through the spot-like channel regions 224 and 226 is represented as

$\phi = (k_{F2} - k_{F1})L = [(2m(E_F - E_{01}))^{1/2} - [(2m(E_F - E_{01}))^{1/2}]L/h$

where L stands for the effective length of the channel regions 224 and 226. Thus, the phase difference $\phi$ is controlled responsive to the gate voltages which in turn control the value of $E_{01}$ and $E_{02}$.

FIG.10 shows a change of the drain current $I_D$ with increase of the gate voltage applied to one of the gate electrodes 218 and 220 while applying a constant gate voltage of - 0.1 volts to the other of the gate electrode. The measurement was conducted at a temperature of 0.5 K while applying a drain voltage $V_D$ of 10 mV across the drain electrode 214 and the source electrode 216. The source electrode 216 was grounded during the measurement. As can be seen in FIG.10, the effect of interference of the electron waves is quite clear and distinct. One reason for this would undoubtedly be the reduced size of the spot-like semi-insulating region 222 of which size or diameter is about 0.1 $\mu$m or less. Note that such a small spot of doped region is easily formed by using a focused ion beam. Another factor would be that the gate electrodes 218 and 220 have the sharp pointed shape at the tip end. As a result, the effective channel length L also takes a size comparable to the size of the region 222. In other words, the length L can be reduced to about 0.1 $\mu$m or less which is comparable to or smaller than the elastic or inelastic scattering length of the electrons in the GaAs active layer 208. Note that the elastic scattering length of electron in the two-dimensional electron gas at a temperature of 4.2 K is 2.3 $\mu$m while the inelastic scattering length at the same temperature is 1.0 um. In such an extremely confined channel region 224 or 226, therefore, the electrons move ballistically without experiencing scattering. Note that the width W of the spot-like channel regions 224 and 226 can be reduced to less than about 0.01 $\mu$m by controlling the extension of the gate voltages.

Next, the process of fabricating the device of FIG.8 will be described with reference to FIGS.11A -11D. These drawings show the cross-sections taken along the line 9A-9A′ of FIG.9A.

Referring first to FIG.11A, the undoped GaAS active layer 208, the n-type AlGaAs layer 210, and the n-type GaAs contact layer 212 are grown consecutively on the semi-insulating GaAs substrate 207 respectively with the thicknesses of 500 nm, 45 nm and 30 nm by molecular beam epitaxy (MBE). As already described, the the AlGaAs layer 210 and the GaAs contact layer 212 are doped to the impurity concentration level of 1.4 X $10^{18}$ $cm^{-3}$.

In a step of FIG.11B, a part of the AlGaAs layer 210 and the GaAs contact layer 212 are removed by a reactive ion etching (RIE) process with the result that the mesa structure 217 comprising the layer 212 and the layer 210 defined by the side wall 215 is left on the surface of the active layer 208. In this drawing, the channel structure 217c is shown as the mesa structure 217, as the cross-section is taken along the line 9A-9A′ of FIG.9A. Further, the exposed surface of the active layer 208 is made unconductive by the ion implantation of oxygen.

Next, a part of the GaAs contact layer 212 is removed by focused ion beam etching and a neck region 212c is formed in the layer 212 in the channel structure 217. At the same time, the semi-insulating region 222 is formed by a focused ion beam implantation of $Be^+$ under an acceleration voltage of 80 keV with the concentration level of 1 X $10^{14}$ $cm^{-2}$. In this process, the etching and ion implantation can be performed in a same apparatus without removing and returning the half-completed device structure shown in FIG.11C to and from the apparatus. Thus, an ideal alignment of the cutout 212d (FIG.9A) and the spot-like region 222 is obtained. Although the region 222 is drawn in FIG.11C as if it is stopped at the interface between the layer 210 and 212, it is not necessary be so but the region 222 may extend into the layer 210 as shown in FIG.9B.

Next, gate electrodes 218 and 220 are provided as shown in FIG.11D wherein the electrodes have stepped surfaces 218a and 220a which divide the electrodes 218 and 220 into the tip part 218b, 220b and the base part 218c, 220c. As already described, these electrodes has a structure comprising stacking of gold, platinum and titanium or the so-called Ti/Pt/Au structure and form the depletion regions 218e and 220e underneath as a result of the Schottky contact.

Next, a second embodiment of the present invention will be described with reference to FIGS.12A and 12B as well as FIGS.13A and 13B. In these drawing, the parts constructed identically to the parts already described with reference to preceding drawings are given identical reference numerals and the description thereof will be omitted.

In this embodiment, a number of grooves 244 -248 with a thickness t (shown in the enlarged view of FIG.13A) of 0.1 $\mu$m are provided across the channel structure 217c so as to extend parallel to each other with a direction traversing the channel structure 217c for a depth of 40 nm as shown in the plan view of FIG.12A. In the grooves, the contact layer 212 and at least a part of the AlGaAs layer 210 are removed while leaving one or more regions referred to hereinafter as "ridges" unetched in each of the grooves. As will be described fully in later, the spot-like channel regions are formed in the active layer 208 in correspondence to such ridges. Further, a gate electrode 258 is provided in correspondence to the groove 246 for controlling the phase of the electron wave passing through one of the spot-like channel regions. The gate electrode 258 has a structure of AuGe/Au similar to the gate electrodes 218 and 220 and therefore further description about the construction of the gate electrode 258 will be omitted. The lateral width of the channel structure 217c may be set to about 5 μm or less similarly to the first embodiment while the size of the source and drain electrodes 214 and 216 is reduced to a few microns in this embodiment as this device is designed to be used in an integrated circuit and the pad region for wire bonding is eliminated.

FIG.12B shows a cross-sectional view of the structure of FIG.12A taken along a line 12A-12A′. In FIG.12B, the gate electrode 258 is omitted for the sake of clarity. As will be understood from this drawing, the groove 246 comprises three groove parts 246a - 246c which are formed by etching of a structure similar to that of FIG.11B such that the etching reaches the active layer 208 in the groove parts 246a and 246c. In one example, the depth of etching may be 40 nm as already described. The only difference between the structure from which the structure of FIG.12B is derived and that of FIG.11B is the provision of a spacer layer 209 of undoped AlGaAs with a thickness of 10 nm of which purpose is to reduce the scattering of the two-dimensional electron wave in the active layer 208 caused by to the influence of the dopants in the doped AlGaAs layer 210. Further, the doped AlGaAs layer 210 remaining at the bottom of the grooves 246a through 246c may be completely removed.

Between the groove 246a and 246b, a ridge structure 254 is left unetched. Similarly, another ridge structure 256 is formed between the groove 246b and 246c. Further, the grooves 246a and 246c are made such that they form an isolation trench structure in the active layer 208 for isolating the channel structure 217c. In the case that the depth of etching is 40 nm, the height of the ridges 254 and 256 becomes also 40 nm. Further, the lateral width W of the ridges 254 and 256 are set to 50 nm and the ridges are separated from each other with a distance D of 0.1 μm. Note that ridges are formed also in the grooves 244 and 248 similarly except that the number of the ridges is only one in each of the grooves 244 and 248. The depth of etching for forming the grooves 244 - 248 is made identical throughout these grooves.

FIG.13A shows an enlarged plan view of the essential part of the semiconductor device of FIG.12A. Referring to this drawing, it can be seen that a ridge 250 is formed between the grooves 244a and 244b. Similarly, a ridge 252 is formed between the grooves 248a and 248b. The grooves 244, 246 and 248 are provided with a mutual separation of about 0.3μm in the direction perpendicularly to the direction of propagation of the electron waves emitted by the source electrode 214. Thus, the ridge 250 is disposed at an upstream side of the electron wave with respect to the ridges 254 and 256 with an identical distance from each of these ridges in the plane of sheet of the drawing. Similarly, the ridge 252 is disposed at a downstream side of the electron wave with respect to the ridges 254 and 256 with an identical separation from each of these ridges.

FIG.13B shows a cross-sectional view of FIG.13A taken along the line 13A-13A′ which coincides to the line 12A-12A′ of FIG.12A. In this embodiment, depletion regions such as regions 246a′, 246b′ and 246c′ are formed in the active layer 208 respectively in correspondence to the grooves 246a, 246b and 246c because of the surface potential or surface barrier which in turn is formed is a result of removal of the doped AlGaAs layer 210 and the contact layer 212. Because the width W of the ridge 254 or 256 is about 50 nm, and because of the lateral extension of the depletion regions 246a′ - 246c′, the width of the regions laterally bounded by the depletion regions in correspondence to the ridges 254 and 256 is further confined to a width of about 30 nm. As a result, a quantum well structure similar to the one already described with reference to FIG.6A is formed in the active layer 208 in correspondence to the ridges 254 and 256. In other words, spot-like channels 254a and 256a are formed in the active layer 208 in correspondence to the ridges 254 and 256. By controlling the gate voltage applied to the gate electrode 258, the extension of the depletion regions 246b′ and 246c′ into the spot-like channel 256a is changed. In other words, the width of the spot-like channel 256a is changed in response to the gate voltage and the energy level of the quantum state $E_{02}$ is changed with respect to the quantum state $E_{01}$ similarly to the case of the first embodiment. Thus, the interference of the electron waves 259a and 259b occurs similarly to the case of the first embodiment. As the thickness t of the groove 246 is about 0.1 μm as already described, the length of the spot-like channels 254a and 256a can also be reduced to about 0.1 μm or less and the electron waves can pass the spot-like channel regions without experiencing elastic or inelastic scattering.

Another feature of the present invention is that similar spot-like channel regions 250a and 252a are formed also in the active layer 208 below the ridges 250 and 252. As the channel regions 250a and 252a are substantailly identical to the channel regions 254a and 256a in that these channel regions are formed also as a result of lateral confinement of the electron waves in a small region, the explanation for these channel regions using the cross-sectional view will be omitted. From the detailed plan view of FIG.13A, it will be seen that the distance between the spot-like region 250a and the spot-like region 254a, and the distance between the spot-like region 250a and the spot-like region 256a are substantially identical to each other. This means that the electron waves 259a and 259b, passed through the spot-like region 250a and split into the two waves, arrive at the spot-like regions 254a and 254b with substantially an identical travel distance. In other words, the probability that the first and second electron waves 259a and 259b arriving at the spot-like channel regions 254a and 256a with an identical phase is substantially increased. The spot-like channel region 252a acts oppositely to the channel region 250a and allows the passage of only the electron waves 259a and 259b which have travelled for an identical distance from the spot-like channel regions 254a and 254b. Thus, the effect of interference of the electron waves 259a and 259b after passing the channel region 252a is augmented.

As the overall separation between the grooves 244 and 248 is smaller than 1 $\mu$m and well below the elastic or inelastic scattering length of electrons, the electron waves do not experience scattering even when passing from the spot-like channel region 250a to the spot-like channel region 252a. This feature of the device will be described further in detail with reference to other embodiments.

As a modification of the second embodiment, one may provide another gate electrode 258′ as shown in FIG.12A so as to control the spot-like channel 254a in addition to the spot-like channel 256a. In this case, the interference of the electron waves is controlled in response to a combination of the gate voltages applied to the first gate electrode 258 and the second gate electrode 258′.

Next a third embodiment of the present invention will be described with reference to FIG.14 which shows the cross-section of the semiconductor device taken along the line 13A-13A′ of FIG.13A. Note that the parts constructed identically to the parts already described with reference to the preceding drawings are given identical reference numerals in FIG.14 and thus, the description thereof will be omitted.

In this embodiment, a semiconductor structure similar to that of the second embodiment shown in FIG.12B is used except that the gate electrode 258 is removed. Instead, a pair of magnets 268 and 270 are provided above and below the foregoing semiconductor structure as shown in FIG.14 such that a stationary magnetic flux B passes through the region between the pair of ridges 254 and 256 in a predetermined direction. In this example, the magnetic flux B passes through the semiconductor structure from the bottom to the top.

When an electron is emitted from the source electrode 214, the electron wave of the emitted electron is splitted into the first and second electron waves 259a and 259b after passing through the spot-like channel region 250a, and the electron waves pass through the spot-like channel regions 254a and 256a while sensing the vector potential A of the magnetic flux B. As is well known in elementary electromagnetic theory, the magnetic flux vector B is related to the vector potential A by the relation

B = rot A,

and the phase difference or the term cos $\underline{\phi}$ in Eq.(1) of the electron waves 259a and 259b arriving at the spot-like channel region 252a is represented as

$$\cos \underline{\phi} = \oint A.ds \quad (4).$$

wherein the path of the line integral is taken so as to surround a central point defined between the spot-like channel regions 254a and 256a where the magnetic flux B passes through, along the path of the electron wave 259a and further along a path opposing to that of the electron wave 259b.

This effect of the magnetic field on the propagation of electron waves is known as the magnetic Aharonov-Bohm effect. Thus, by changing the strength of the magnetic field B, the phase difference $\underline{\phi}$ is controlled and the drain current $I_D$ is changed oscillatory with increasing magnetic field B as shown in FIG.15.

In any of the first through third embodiment of the present invention, the materials forming the active layer 208 and the doped layer 210 is not limited to the combination of undoped GaAs and n-type AlGaAs, but other combinations such as undoped indium gallium arsenide (InGaAs) and n-type indium aluminium gallium arsenide (InAlGaAs) or undoped indium arsenide (InAs) and n-type gallium antimonide (GaSb) may be used. Further, the spacer layer 209 in the second and third embodiment may be omitted.

In the second and third embodiment, it should be understood that one of the grooves 244 and 248 may be omitted, although such a simplification may diminish the interference effect of electron waves. On the other hand, one may provide additional grooves similar to the grooves 244 or 248 at the upstream side or downstream side of the grooves in FIG.12A to enhance the effect of interference.

In the second embodiment, it should be noted that the gate electrode 258 needs not to cover the entire groove 246c and a part of the groove 246b as shown in FIG.13B, but may be provided only on the top of the ridge 256. In this case, control of the width W of the spot-like channel region 256a by the lateral extension of the depletion regions 246b′ and 246c′ responsive to the gate voltage does not function, and the control of the energy level of the quantum state $E_{02}$ occurs only by the modification of the potential level of the conduction band Ec responsive to the change of the gate voltage.

Next, a fourth embodiment of the quantum interference semiconductor device of the present invention will be described with reference to FIG.16 showing the plan view of the device. In FIG.16, the parts already described with reference to the preceding drawings are given identical reference numerals and the description thereof will be omitted. Further, the cross-sectional view of this embodiment will be omitted as the device has a substantially identical structure to that of the device of the first embodiment (FIG.9B) when viewed in cross-section taken along a line 16-16′ in FIG.16, except that the gate electrodes 218b and 220b are replaced by a pair of gate electrodes 316 and 318.

In this embodiment, the gate electrodes 316 and 318 have a generally triangular form similarly to the gate electrodes described previously, and are provided such that the tip ends of the triangular gate electrodes 316 and 318 invade into corresponding cutouts 212d′ provided in the contact layer 212c in the channel structure 217c. In correspondence to the gate electrodes 316 and 318, depletion regions are formed as a result of the Schottky contact similarly to the case of the first embodiment.

In the fourth embodiment, the tip ends of the gate electrodes 316 and 318 are separated by a distance of about 0.5 µm and there is formed a spot-like channel region 322 comprising a quantum well formed between the tip ends of the gate electrodes 316 and 318 with a diameter of about 0.2 µm. Further, there are formed a pair of another spot-like channel regions 324 and 326 respectively between the gate electrode 316 and the region 222 and between the gate electrode 318 and the region 222, wherein each of the spot-like channel regions 324 and 326 has a diameter of about 0.2 µm. The gate electrodes 316 and 318 are disposed with respect to the spot-like region 222 such that the spot-like channel regions 322, 324 and 326 are separated from each other by a distance of 1.0 µm in the maximum. In order to avoid the elastic or inelastic scattering of electron waves, the overall distance between the channel region 322 and channel regions 324, 326 is set to about 1 µm or less, in view of the elastic and inelastic scattering length of electron waves.

In such a construction, the spot-like channel region 322 allows passage of the electron wave by the resonant tunneling effect with a result that the wave number and the energy of the exiting electron wave is sorted according to Eqns. (2a) and (2b). More specifically. the spot-like channel region 322 forms a quantum well structure similar to the one shown in FIG. GA, and passes the electron waves having an energy level substantially identical to that of the quantum state formed in the quantum well structure with high probability because of the increased density of state at that energy level. Thus, when a number of electron waves having a relatively broadened energy spectrum, may be because of the thermal excitation of electrons, are incident, only one of the electron waves that matches the energy level of the quantum state best is preferentially passed. Note that the wave number of such an electron wave is sorted according to Eqs.(2a) or (2b). The energy level of the quantum state in the spot-like channel region 322 is adjusted by setting the distance between the opposing ends of the gate electrodes 316 and 318.

In summary, the phase of the electron waves can be initialized by passing the spot-like channel region 322. Further, the path length of the electron waves travelling from the channel region 322 to the channel region 324 and the path length of the electron waves travelling from the channel region 322 to the channel region 326 become identical to each other. In this respect, the fourth embodiment has a desirable feature similar to the second embodiment which has the additional spot-like channel regions 250 and 252. Thus, the effect of interference of the electron waves after passing through the spot-like channel regions 324 and 326 is enhanced. The principle of control of the phase of the passing electron waves by the spot-like channel regions 324 and 326 is identical to the first embodiment and the description thereof will be omitted.

FIG.17 shows the change of drain current $I_D$ with the gate voltage applied to one of the gate electrode while applying another fixed gate voltage of -0.1 volts to the other gate electrode. Similarly to the case of measurement of FIG.10 the measurement was conducted at 0.5 K while applying a drain voltage of 10 mV to the drain electrode 214 and at the same time grounding the source electrode 216. From FIG.10, the constructive and destructive interference effect of the electron waves is observed clearly which is enhanced twice as compared to the case of FIG.10.

Next, a fifth embodiment of the present invention will be described with reference to FIG.18. In the drawing, the parts already described with reference to previous drawings are given identical reference numerals and the description thereof will be omitted. Further, the description with reference to the cross-sectional view for this embodiment will be omitted as the cross-section taken along the line 18-18′ of FIG.18 is substantially identical to that of the first embodiment (FIG.9B) except that the gate electrodes 218b and 220b are replaced by gate electrodes 316a and 318a.

In this embodiment, the gate electrode 316 comprises three gate electrodes 316a - 316c and the gate electrode 318 comprises three gate electrodes 318a -318c, in which the gate electrodes 316a and 318a, the gate electrodes 316b and 318b, and the gate electrodes 316c and 318c are opposed respectively with each other in the cutouts 212d formed in the layer 212c in the channel structure 217c exposing the layer 210. The pair of gate electrodes 316a and 318a are disposed between the pair of gate electrodes 316b and 318b in the upstream side of the electron flow and the other pair of gate electrodes 316c and 318c in the downstream side of the electron flow. Further, the spot-like semi-insulating region 222 is formed in the contact layer 212c in correspondence to a midpoint between the gate electrode 316a and the gate electrode 318a. Thus, the foregoing spot-like channel region 324 is formed between the gate electrode 316a and the spot-like region 222, and the spot-like channel region 326 is formed between the spot-like region 222 and the gate electrode 318a. Further, an additional spot-like channel region 322 is formed between the gate electrodes 316b and 318b in the upstream side of the channel regions 324 and 326, and another additional spot-like channel region 323 is formed between the gate electrodes 316c and 318c in the downstream side of the channel regions 324 and 326.

In the device of this embodiment, the electron wave incident to the spot-like channel region 322 experiences the sorting of wave number and energy similarly to the foregoing fourth embodiment. Further, the electron wave exiting from the spot-like channel region 323 experiences a similar sorting effect. Further, this sorting effect in the channel regions 322 and 324 can be adjusted independently by changing the gate voltages applied to the gate electrodes 316b, 318b and the gate electrodes 316c, 318c. In addition, the effective path length of the electron wave travelling through the region between the channel region 322 and the channel region 323 becomes identical to each other in the first electron wave passing through the channel region 324 and the second electron wave passing through the channel region 326. The last feature is identical to the case of the second embodiment. The principle of the phase control of the electron waves by the adjustment of the quantum level in the spot-like channel regions 324 and 326 is identical to that of the first embodiment and further description will be omitted.

Next, a sixth embodiment of the present invention will be described with reference to FIG.19. In FIG.19, the parts already described with reference to the previously described drawings will be given identical reference numerals and the description thereof will be omitted. Further, description of the cross-section for this embodiment will be omitted as the cross-section of the device taken along the line 19-19′ is substantially identical to that of the first embodiment (FIG.9B) except that the gate electrodes 218b and 220b are replaced by gate electrodes 408 and 410.

Referring to the plan view of FIG.19, the device of this embodiment comprises three gate electrodes 408, 410 and 412 which are provided in contact with the AlGaAs layer 210 through cutouts $212d_1$ - $212d_3$, wherein the gate electrode 408 is provided at one side of the channel structure 217c and the gate electrodes 410 and 412 are provided at the other side of the channel structure 217c. The spot-like doped region 222 is provided generally at a center of the gate electrodes 408 - 412 with a same distance from each of the gate electrodes 408 - 410.

In such a configuration of the gate electrodes 408 - 412 surrounding the spot-like semi-insulating region 222, it will be understood that there are formed two spot-like channel regions 418 and 420 in the side close to the gate electrodes 410 and 412 with respect to the region 222 while there is only one spot-like channel region 416 at the other side close to the gate electrode 408. Thus, the electron wave splitted at the spot-like region 222 and passing through a path at the side of the gate electrodes 410 and 412 passes through two spot-like channel regions 418 and 420 consecutively while the electron wave passing through the other path between the spot-like region 222 and the gate electrode 408 passes through only one spot-like channel region 416. Thus, the phase of the electron wave passing consecutively through the spot-like channel regions 418 and 420 is controlled with respect to that of the electron wave passing through the single spot-like channel region 416 by a combination of the gate voltages applied to the gate electrodes 410 and 412.

In the device having such a construction, it is possible to control the mutual phase difference between the electron wave passing through the spot-like channel region 416 designated by a path X1 in FIG.19 and the electron wave passing consecutively through the spot-like channel regions 418 and 420 designated by a path X2 in response to a combination of gate voltages applied respectively across the gate electrodes 416 and 418 and across the gate electrodes 416 and 420, such that the mutual phase difference is zero or odd integer multiple of $\pi$ or such that the mutual phase difference is even integer multiple of $\pi$. Responsive thereto, the output state of the drain current is changed between the maximum level and the minimum level as a result of the constructive or destructive interference of the electron waves as already described with reference to FIG.7. In other words, the device constructed as such can perform a logic operation responsive to the combination of state of the gate voltages.

Designating the turn-on state wherein a predetermined voltage is applied across the gate electrode 408 and the gate electrode 410 or across the gate electrode 408 and the gate electrode 412 by an input state "1" and further designating the turn-off state wherein no voltage is applied across the foregoing gate electrode pairs as an input state "0", and by suitably choosing the magnitude of the predetermined voltage in the input state "1", it is possible to set the phase difference between the electron waves passing through the path X1 and the path X2 can be made either to zero, $\pi$, or $2\pi$. This relation is summarized in a form of table in FIG.20A. Note that the output logic state "0" in these tables represents a state of the output drain current exceeding a first predetermined threshold level L1 shown in FIG.21 which shows an output drain current versus phase difference relation similar to FIG.7, while the output logic state "1" represents a state of the output drain current below a second predetermined threshold level L2 lower than the first predetermined threshold level L1. As will be understood from this table of FIG.20A, the quantum interference semiconductor device of the present embodiment operates as a well known exclusive-or or EOR gate.

FIG.20B shows another example of operation of the quantum interference semiconductor device of the present embodiment. In this example, the magnitude of the voltage applied across the gate electrodes 408 and 410 or across the gate electrodes 410 and 412 is set such that there appears a phase difference of $\pi/2$ between the electron waves passing through the paths X1 and X2 in the turn-on state or the input state "1". In this case, the first predetermined level of the output drain current above which the output state "0" is assigned is set higher than the level L1 as shown by a level L1′ in FIG.21B while the second predetermined level below which the output state "1" is assigned is set also higher than the level L2 as shown in FIG.21B by a level L2′. In this case, the relation between the combination of input state to the gate electrodes 410 and 412 and the corresponding output state of the drain current is represented as shown in this table which shows a typical operation of an OR gate.

Further, by setting the magnitude of voltage applied across the gate electrodes 408 and 410 or across the gate electrodes 408 and 412 similarly to the foregoing second embodiment of FIG.20B such that there appears a phase difference of zero, $\pi/2$ and $\pi$ between the electron waves passing through the paths X1 and X2 and further by setting the first and second predetermined levels of the output drain current respectively defining the output logic state "0" and the output logic state "1" as shown in FIG.21C by levels L1" and L2", one obtains an operation of the device as summarized in FIG.20C. Note that the operation of FIG.20C is that of a typical AND gate.

In each of the foregoing operations in FIGS.20B and 20C, one can also obtain an operation of a NAND gate and that of a NOR gate respectively by inverting the logic state in each of the output.

By constructing the logic devices by using the quantum interference semiconductor device, an extremely high speed operation is achieved because of the inherent small size of the device. Note that this device has no lower limit in the device size discussed previously with reference to the conventional, ordinary semiconductor devices.

Next, a seventh embodiment of the present invention will be described with reference to FIG.22. In this embodiment, a pair of almost identical quantum interference semiconductor devices having a structure slightly modified from that of the device of FIG.19 are combined. In FIG.22, the parts constructed identically to the corresponding parts in FIG.19 are given identical reference numerals and the description thereof will be omitted.

In this embodiment, a pair of substantially identical sub-devices 400a and 400b are disposed parallel to each other and combined by the gate electrodes 410 and 412 which bridge across the two devices. In each of the devices, a slightly elongated doped region 414 or 414′ is used in place of the spot-like region 222 for splitting the electron waves. The lateral width of the regions 414 and 414′ is set to about 0.1 µm or less while the length is prefer about 1 µm or less in correspondence to the elastic or inelastic scattering length of the electron wave. Thus, the electron wave propagating from the source electrode 214 in the sub-device 400a is splitt at the region 414 into first and second electron waves respectively passing through a first path Y1 including the spot-like channel region 416 and a second path Y2 including the spot-like channels 418 and 420. Similarly, the electron wave propagating from the source electrode 214′ in the sub-device 400b is splitted at the region 414′ into first and second electron waves respectively passing through a first path X1 including the spot-like channel region 416′ and a second path X2 including spot-like channels 418′ and 420′. As the construction of the spot-like channel regions 416′ - 418′ is identical to that of the regions 416 - 418, further description for these regions will be omitted. Note that the overall length of the region including the spot-like channel regions 418′ and 420′ is about 1 $\mu$m or less, which is smaller than the elastic or inelastic scattering length of electron waves.

Another feature of the device of FIG. 22 is that the gate electrodes 410 and 412 have a generally trapezoidal form, with the base edge of the trapezoid facing the spot-like channel region 418′ or 420′ of the sub-device 400b being enlarged twice as large as the top edge facing the spot-like channel region 418 or 420 of the sub-device 400a. As a result, the spot-like channel regions 418′ and 420′, defined by the base edge of the trapezoidal gate electrodes 410 and 412, have an elongated spot-like form which is extended twice as large as the diameter of the spot-like channel regions 418 and 420 in the direction of the path X2. Further, the gate electrode 408′ has a slightly flattened tip end which creates the spot-like channel region 416′ to have an elongated form extending twice as large as the spot-like channel region 416 in the direction of the path X1. According to such a construction, the phase difference induced in the electron waves passing through the paths X1 and X2 can become twice as large as that of the electron waves passing through the paths Y1 and Y2.

FIG.23 shows the operation of the device of FIG.22 in response to the application of input data "0" and "1" across each of the gate electrode pairs 408 and 410, 408 and 412, 408′ and 410′, and 408′ and 412′. In this operation, the magnitude of the input data "1" is set such that the phase difference between the electron waves passing through the paths Y1 and Y2 is about $\pi$ when the data "1" is applied to one of the gate electrode pairs, 408 and 410, and 408 and 412. On the other hand, the data "0" does not cause any relative phase shifts between the two electron waves. Further, when the electric potential level of the gate electrode 408 is held identical to that of the gate electrode 408′, such an application of the input data "1" induces a phase difference $\pi$ between the electron waves passing through the paths X1 and X2 in the sub-device 400b because of the elongated spot-like channel regions 418′ and 420′. Thus, the sub-device 400a operates identically to the AND gate as shown in FIG.20C and the sub-device 400b operates identically to the EOR gate of FIG.20A. Regarding the output drain current of the sub-device 400b as a logic sum of input data applied to the gate electrodes 410 and 412 with respect to the gate electrodes 408 and 408′ acting as the reference, and further by regarding the output drain current of the sub-device 400a as the carry created as a result of logic sum operation, it will be understood that the device of FIG.22 operates exactly as a half-adder.

Next, an eighth embodiment of the present invention will be described with reference to FIG.24. In FIG.24, the parts described previously with reference to preceding drawings are given identical reference numerals and the description thereof will be omitted.

In this embodiment, the quantum interference semiconductor device comprises a sub-device 400c and a sub-device 400d in which another gate electrode 462 also trapezoidal in form is provided in addition to the gate electrodes 410 and 412 such that the gate electrode 462 is located in the downstream side of the electron flow with respect to the gate electrode 412. In correspondence to the gate electrode 462, additional spot-like channel regions 464 and 464′ are formed. Further, each of the gate electrodes 410, 412 and 462 has a trapezoidal form similar to the gate electrodes in the previous embodiment except that the length of the base edge of the trapezoid is set three times as large as that of the top edge. In correspondence to this, the spot-like channel regions 418′ - 464′ in the sub-device 400d are elongated, with the longitudinal length measured in the propagating direction of the electron waves set three times as long as the diameter of the spot-like channel regions 416 - 464 in the sub-device 400c. Further, the overall length of the doped regions 414 and 454 measured in the travelling direction of the electron wave may be about 1 $\mu$m or less and the lateral width may be about 0.1 $\mu$m or less, similarly to the seventh embodiment.

In operation, the magnitude of gate voltages applied to the gate electrodes 410 - 462 with reference to the gate electrode 408 in correspondence to the input data "1" is set such that the electron wave passing through any one of the spot-like channel regions 418 -464 or the path Y2 (FIG.24) experience a phase shift $\pi/3$ with respect to the electron wave passing through the spot-like channel region 416 or the path Y1. In correspondence to this, the electron wave passing through any one of the spot-like channel regions 418′, 420′ and 464′, or the path X2, experience a phase shift of $\pi$ with respect to the electron wave passing through the spot-like channel region 416′ or the path X1. Further, the magnitude of the gate voltages applied in correspondence to the input data "0" is set such that there is no phase difference in the electron waves passing through the paths Y1 and Y2 or in the electron waves passing through the paths X1 and X2.

FIG.25 summarizes the operation of the quantum interference semiconductor device of FIG.24 in response to the application of the foregoing input data "0" and "1". Note that the threshold levels L1 and L2 for distinguishing the output logic state "0" and the output logic state "1" for the sub-device 400d are set similarly to the case shown in FIG.21A while the threshold levels L1 and L2 for the sub-device 400c are set as shown in FIG.26. Thus, in the sub-device 400c, the phase difference zero (0) provides the output state "0" and the phase difference $\pi$ provides the output state "1". In the sub-device 400d, on the other hand, the phase difference $\pi/3$ provides the output state "1" and the phase difference $\pi$ provides the output state "0".

In FIG.25, note that the column PHASE DIFF ACROSS X1 & X2 represents the phase difference between the electron waves passing through the path X1 and the path X2 in the sub-device 400c, wherein the drain current assumes the logic state "1" in response to the odd integer multiple of $\pi$ in the phase difference of the electron waves and the logic state "0" in response to the even integer multiple of $\pi$. Further, the column PHASE DIFF ACROSS Y1 & Y2 represents the phase difference between the electron waves passing through the path Y1 and the path Y2 in the sub-device 400d, wherein the drain current assumes the output state "1" only when the value of phase difference has reached a range between about $2\pi/3$ and $4\pi/3$.

Thus, it will be understood that the quantum interference semiconductor device of FIG.24 can operate as a full adder by using the output drain current of the sub-device 400d as the logic sum output and by using the output drain current of the sub-device 400c as the carry of the logic sum operation.

Next, a ninth embodiment of the present invention will be described with reference to FIG.27. In the drawing, the parts identical to those already described are given identical reference numerals and the description thereof will be omitted. Further, the cross-sectional view of the device of FIG.27 will be omitted as the cross-section taken along the line 27-27′ is substantially identical to that of FIG.9B except that the gate electrodes 218b and 220b of FIG.9B are replaced by gate electrodes 510 and 512.

In this embodiment, three gate electrodes 510 - 514 each having a narrowed or sharply pointed end are provided about the spot-like doped region 222 with an equi-angular separation. Further, the channel structure 217c is branched into a channel structure part 217c-1 and another channel structure part 217c-2 at the spot-like doped region 222. In each of the channel structure parts 217c-1 and 217c-2, a drain electrode such as a drain electrode 216a or 216b is provided. In order to accept the gate electrodes 510 - 514, the contact layer 212 at the top of the channel structure 217c is removed at three cutout parts 532a - 532c having a shape corresponding to the gate electrodes 510 - 514. Note that the cutout parts 532a - 532c expose the underlying n-type AlGaAs layer 210 and the gate electrodes are provided directly on the layer 210 in the cutout parts 532a - 532c.

The gate electrodes 510 - 514 comprise a material which forms the Schottky contact with the underlying AlGaAs layer 210 similarly to the foregoing embodiments. Thus, depletion regions are formed under the gate electrodes 510 - 514. Note that there is also a depletion region under the spot-like doped region 222 as already described. Thus, there are formed three spot-like channel regions 518 - 522 in correspondence to the gate electrodes 510 - 514. In order to avoid the undesirable scattering of electron waves, the maximum distance between these spot-like channel regions 518 -522 is preferrably set to about 1 µm or less, similarly to the foregoing embodiments.

In such a structure, the electron wave passes from the source electrode 214 to either the drain electrode 216a or the drain electrode 216b after being divided into two waves at the spot-like doped region 222. When the electron wave travels from the source electrode 214 to the drain electrode 216a after being divided into two electron waves, one of the electron waves travels along the path X1 passing through the spot-like channel region 518 while the other of the electron waves travels along the path X2 passing consecutively through the spot-like channel regions 520 and 522. Further, when the electron wave travels from the source electrode 214 to the drain electrode 216b after being divided into two electron waves, one of the electron waves travels along the path Y1 passing through the spot-like channel region 520 while the other of the electron waves travels along the path Y2 passing consecutively through the spot-like channel regions 518 and 522.

Next, the operation of the quantum interference semiconductor device of FIG.27 will be described.

First, a case is considered in which no voltage is applied to the gate electrode 512 in correspondence to an input data "0" while a predetermined negative voltage is applied to the gate electrodes 510 and 514 in correspondence to an input data "1". The magnitude of the predetermined negative bias voltage is set such that a phase shift of $\pi/2$ is induced in the electron waves upon passage of each of the spot-like channel regions 518 and 522. No phase shift occurs when the electron waves pass through the spot-like channel region 520. Under such circumstances, the phase difference between the electron wave passing through the path X1 and the electron wave passing through the path X2 becomes zero and a large drain current is obtained at the drain electrode 216a. By setting the threshold levels discriminating the output state "0" and output state "1" similarly to the levels L1 and L2 of FIG.21A, this output state is interpreted as the output state "1". On the other hand, the phase difference between the electron waves passing through the paths Y1 and Y2 becomes $\pi$ in the same combination of the input gate voltages. Under this condition, the electron waves cancel each other and no virtual drain current flows at the drain electrode 216b. This state is interpreted as the output state "0" of the drain electrode 216b.

When the foregoing gate voltages corresponding to the input data "1" is applied to the gate electrodes 512 and 514 while no gate voltage is applied to the gate electrode 510, the electron waves passing through the path Y1 and the path Y2 have an identical phase and thus interfere constructively, thereby providing a large drain current corresponding to the output state "1" at the gate electrode 216b. On the other hand, the electron waves passing through the paths X1 and X2 have an identical phase and thus cancels each other. Thus, the drain current at the gate electrode 216a becomes minimum in correspondence to the output state "0".

The foregoing operation of the device is summarized in FIG.28A. Thus, the quantum interference semiconductor device of FIG.27 operates such that the electron flow from the source is switched between two drains in response to the combination of gate voltages applied to the gate electrodes 510 - 514.

The combination of gate voltages applied to the gate electrodes 510 - 514 to cause the foregoing switching operation of the electron flow is not limited as listed in the table of FIG.28A. In one example, a suitable gate bias voltage $V_G$ is applied to the gate electrode 510 such that a phase shift of $\pi/2$ is induced in the electron waves passing through the spot-like channel region 518 while zero gate bias voltage is applied to the gate electrode 512 throughout the operation. Under such circumstances, the drain current can be switched between the drain electrode 216a and 216b in response to an input data applied to the gate voltage 514 as the gate voltage, when the magnitude of the input data is chosen that a relative phase shift of - $\pi/2$ is induced in the electron wave passing through the spot-like channel region 522 in response to the input data "1" and that a relative phase shift of $\pi/2$ is induced in response to the input data "0", with respect to the electron waves not passing through the channel region 522.

When the input data "1" is applied to the gate electrode 512, the electron wave passing through the path X2 is advanced by a phase $\pi$ with respect to the electron wave passing through the path X1. Note that no relative phase shift occurs in the latter electron wave upon passage through the spot-like channel region 520. Thus, the electron waves passed through paths X1 and X2 cancel each other and the drain current at the drain electrode 216a becomes minimum. On the other hand, the electron wave passed through the path Y2 has a phase identical to that of the electron wave passed through the path Y1 because of the cancellation of the phase advance and phase delay upon consecutive passage through the spot-like channel regions Y1 and Y2. Thus, a large output drain current is obtained at the drain electrode 216b.

Similarly, when the input data "0" is applied to the gate electrode 514, the drain current at the drain electrode 216a becomes maximum while the drain current at the drain electrode 216b becomes minimum. The operation in this case would be obvious from the foregoing description and further description will be omitted.

The switching of the drain current between the two drain electrodes 216a and 216b in response to the gate voltage applied to the gate electrode 514 is summarized in the table of FIG.28B. In one example, the operation of FIG.28B is obtained by setting the gate bias voltage $V_G$ at about 30 mV. Further, the gate voltage to be applied to the gate electrode 514 in correspondence to the input data "0" may be other than zero volt. In the actual application, the foregoing voltages may be adjusted such that an optimum extension of the depletion regions is realized. In other words, the device of FIG.27 allows a considerable tolerance in the dimension as the deviation from the optimum operation due to the improper formation of the depletion regions is easily compensated by adjusting the gate voltages.

Next, a tenth embodiment of the quantum interference semiconductor device of the present invention will be described with reference to FIG.29. In FIG.29, the parts constructed identically to the parts already described with reference to preceding drawings are given identical reference numerals and the description thereof will be omitted.

In this embodiment, the mesa structure 217 used in the first through ninth embodiments is eliminated and generally triangular cutouts $212d_1$ - $212d_4$ are provided in the contact layer 212 so as to surround the spot-like doped region 222 with an equi-angular arrangement. In the description hereinafter, the part of the contact layer 212 remaining after the formation of the cutouts $212d_1$ - $212d_4$ as well as the doped layer layer 210 and the active layer 208 underneath will be designated as the channel structure 217c, as the electrons move in such a part in a form of the two-deimensional electron gas. Further, gate electrodes 610 - 614 each having a corresponding shape to the cutouts $212d_1$ - $212d_4$ are provided on the n-type AlGaAs layer 210 exposed by the cutouts, forming a Schottky contact therewith. As a result, four spot-like channel regions 618 - 623 are formed in response to the the gate electrodes 610 - 615. Further, there are provided three drain electrodes 216a - 216c in correspondence to the single source electrode 214.

In such a device, the electron waves arriving at the drain electrode 216a - 216c pass one, two, or three spot-like channel regions consecutively. Thus, the electron wave arriving at the drain electrode 216a along the path X1 passes only one spot-like channel region 618 while the other electron wave arriving at the drain electrode 216a along the path X2 pass through the spot-like channel regions 620, 622 and 623 consecutively. Similarly, the electron wave arriving at the drain electrode 216c along the path Y1 pass through the single spot-like channel region 620 while the electron wave arriving at the drain electrode 216c along the path Y2 pass through the spot-like channel regions 618, 623 and 622 consecutively. Further, the electron waves arriving at the drain electrode 216b along the paths Z1 and Z2 pass through two spot-like channel regions, 618 and 623 or 620 and 623.

In operation, gate electrodes 610 - 615 are applied with gate voltages such that the electron wave passing through any one of the spot-like channel regions 618 - 623 is shifted in phase by $\pi/2$ with respect to the electron wave not passing through the spot-like channel region in correspondence to an input data "1", while no gate voltage is applied to the gate electrodes when the input data is "0". Thus, as a result of combination of the gate voltages or input data applied to the gate electrodes 610 - 612, the device of FIG.29 operates as shown in the table of FIG.30. As the principle of operation of the device of FIG.29 outlined in FIG.30 is substantially identical to that of the device of FIG.27, further description will be omitted.

Next, an eleventh embodiment of the quantum interference semiconductor device of the present invention will be described with reference to FIG.31. In FIG.31, the parts already described with reference to previous drawings are given identical reference numerals and the description thereof will be omitted.

As will be easily understood from FIG.31, the device of this embodiment has a construction almost identical to that of the device of FIG.29 except that the electrode 216b in FIG.29 is used as the source electrode. In other words, the device has a pair of opposing source electrodes 214a and 214b and a pair of opposing drain electrodes 216a and 216b.

When operating the device of FIG.31, the gate voltage applied to the gate electrodes 610 - 615 in correspondence to the input data "1" is set such that the electron wave passing through any one of the four spot-like channel regions 618 - 623 experiences a phase shift of $\pi/2$ with respect to the electron waves not passing through the spot-like channel regions. FIG.32 summarizes the operation of the device of FIG.31 in response to such inputs. As will be seen from this table, the device of this embodiment can switch the flow of electrons from the source electrodes 214a and 214b to the drain electrodes 216a and 216b in response to the combination of gate voltages applied to the gate electrodes 610 - 615. In this embodiment, the electron wave from the source region 214a arrives the drain regions 216a and 216b along a pair of paths W1, W2 or X1, X2, while the electron wave from the source region 214b arrives at the drain regions along a pair of paths Y1, Y2 or Z1, Z2.

Next logic circuits constructed using one or more quantum interference semiconductor devices of FIG.27 will be described with reference to FIGS.33A through FIG.43B, in which the quantum interference semiconductor devices are designated as QUID1, QUID2, ... etc. In the circuit diagrams of FIG.33A et seq., it should be noted that the drain electrodes 216a and 216b of the device of FIG.27 are respectively designated as drains D1 and D2 and the single source electrode 214 is designated as S. Further, the gate electrodes 510 and 512 are biased suitably and the device operates similarly to the table of FIG.28B in response to the gate voltage applied to another gate electrode 514, which is designated in FIG.33A as G. In correspondence to the description described with reference to the operation of FIG.38B, the drain current flows through the drain D1 to the source S in response to the input data "0" to the gate G in which no voltage is applied to the gate G, while the drain current flows through the drain D2 to the source S in response to the input data "1" to the gate G in which a predetermined negative voltage is applied to the gate G. This predetermined negative voltage is chosen such that a phase shift of $-\pi/2$ to $\pi/2$ or $\pi/2$ to $-\pi/2$ is induced in the electron wave passing through the spot-like channel region (522 in FIG.27) adjacent to the gate electrode (514 in FIG.27) represented schematically by the gate G. Further, the threshold levels L1 and L2 for distinguishing the output states "0" and "1" are set as already described with reference to FIG.21A.

Referring to the circuit diagram of FIG.33A, the drains D1 and D2 of the device QUID2 are connected to a voltage source $V_{DD}$ via respective resisters R1 and R2 and the drains D1 and D2 of the QUID1 are respectively connected to the drain D1 and the source S of the QUID2. The source S of the QUID1 is connected to the ground. Further, the gate G of the QUID2 is connected to an input terminal B and the gate G of the QUID1 is connected to another input terminal A. From the drain D1 of the QUID2, a first output is obtained at an output terminal X and from the drain D2 of the QUID2, a second output is obtained at another output terminal Y.

FIG.33B shows the operation of the circuit of FIG.33A. In response to a combination of binary inputs to the input terminals A and B, a combination of binary outputs are obtained at the output terminals X and Y as shown. In each of the devices QUID1 and QUID2, the electric current flows from the drain D1 to the source S in response to the application of the input data "0" to the gate G while the current flows from the drain D2 to the source S in response to the application of the input data "1" at the gate G.

When the input data "0" is applied to the gate electrode G of the both devices QUID1 and QUID2, the current flows from the drain D1 to the source S in each of the devices. Thus, current from the voltage source $V_{DD}$ flows to the ground passing through the resister R1, the drain D1, and the source S of the QUID1, while the current from the same voltage source $V_{DD}$, passed through the resister R2, the QUID2 along the drain D1 and the source S, is stopped at the drain D2 of the QUID1. Responsive thereto, the output level at the output terminal X is low providing the output state "1" while the output level at the output terminal Y is high providing the output state "0". When the input data "1" is applied to the input terminal B while maintaining the input data "0" at the input terminal A, the path of the current in the QUID2 is changed from the drain D2 to the source S. In this case, too, the current passed through the QUID2 is stopped at the drain D2 of the QUID1 and the output state at the output terminals X and Y does not change. When the input data "1" is applied to the input terminal A while the input data "0" is applied at the same time to the input terminal B, the current flows from the voltage source $V_{DD}$ after passing through the drain D1 and the source S of the QUID2, and thereafter flows through the drain D2 and the source S of the QUID1 to the ground. The current to the drain D2 of the QUID2 does not flow. Thus, the output state at the output terminals X and Y is the same as in the previous cases. Further, when the input data "1" is applied to the both input terminals A and B, the electric current flows through the devices QUID1 and QUID2 to the ground passing through the drain D2 and the source S in each of the devices while the current supplied to the drain D1 is stopped at each of the devices QUID1 and QUID2. Thus, only in this case, the output state at the output terminal Y becomes low representing the output state "1" and the output state at the output terminal X becomes high representing the output state "0".

From the foregoing description, it will be understood that the output at the output terminal X represents a result of NAND operation of the input data at the terminals A and B, and that the output at the output terminal Y represents a result of AND operation of the same input data. The circuit of this embodiment has an advantage in that the operational speed is inherently fast because of the small size of the devices QUID1 and QUID2. There is no limit to the miniaturization of the device size in contrast to the prior art semiconductor devices conventionally employed for constructing the logic circuits. Another advantage is that the NAND output and AND output are obtained simultaneously.

FIGS.34A and 34B show another logic circuit using the quantum interference semiconductor devices QUID1 and QUID2. In this circuit, the drain D2 of the QUID1 is connected to the voltage source $V_{DD}$ via a resister R2 commonly with the drain D2 of the QUID2 and the source S of the QUID2 is connected to the drain D1 of the QUID1. Further, the drain D1 of the QUID2 is connected to the voltage source $V_{DD}$ via a resister R1. The operation of this circuit is summarized in the table of FIG.34B. Note that the output state at the output terminal X represents the result of NOR operation of the input data to the input terminals A and B while the output state at the output terminal Y represents the result of OR operation. As the operation shown in FIG.34B is easily derived from the operation described with reference to FIG.33B, further description thereof will be omitted.

FIG.35 shows another logic circuit constructed using the quantum interference semiconductor device of FIG.27. In this embodiment, the both drains D1 and D2 are connected to the voltage source $V_{DD}$ via resistors R1 and R2 respectively, and an input terminal A is connected to the gate G of the device while the source S is connected to the ground. Further, the drains D1 and D2 are connected to output terminals X and Y, wherein an inversion of the input data is obtained at the output terminal X and an output identical to the input data is obtained at the output terminal Y. Thus, the circuit of this embodiment operates as an inverter.

FIGS.36A and 36B show another logic circuit constructed using the quantum interference semiconductor device of FIG.27. In this embodiment, a first device QUID1 having its source connected to the voltage source $V_{DD}$ and a second device QUID2 having its source connected to the ground, are coupled each other by connecting the drain D2 of the QUID1 to the drain D2 of the QUID2 and by connecting the drain D1 of the QUID1 to the drain D1 of the QUID2. Further, an input terminal A is connected to the gate G of the QUID1 and another input terminal B is connected to the gate G of the QUID2.

In operation, the current flows through the devices QUID1 and QUID2 passing through the source S and drain D1 of the QUID1 and further passing through the drain D1 and source S of the QUID2 consecutively in response to the input data "0" to the both input terminals A and B. Responsive thereto, an output state "1" is obtained at an output terminal X connected to the source S of the QUID1. Similarly, the output state "1" is obtained also when the input data "1" is applied to the both input terminals A and B. In this case, the current flows from the voltage source $V_{DD}$ to the ground along a path comprising the source S and drain D2 of the QUID1 and the drain D2 and source S of the QUID2 consecutively. When either one of the input data to the input terminal A or to the input terminal B has the logic data "1" while the other of the input data has the logic data "0", on the other hand, the current flowing through the QUID1 and QUID2 are stopped and a high output state corresponding to the output data "0" is obtained at the output terminal X. The foregoing operation of this circuit is summarized in the table of FIG.36B. From FIG.36B, it will be understood that the circuit of this embodiment operates as an EX-NOR circuit.

FIGS.37A and 37B show still another embodiment of the logic circuit constructed by the quantum interference semiconductor device of FIG.27. This circuit is constructed similarly to the circuit of FIG.36B except that the drain D1 of the QUID1 is connected to the drain D2 of the QUID2 and that the drain D2 of the QUID1 is connected to the drain D1 of the QUID2. The operation of this circuit is summarized in the table of FIG.37B. As will be understood from FIG.37B, the circuit operates as an EX-OR circuit. As the operation is easily deduced from the description of the foregoing embodiment with reference to FIG.36B, further description of operation of this circuit will be omitted.

Next, another logic circuit constructed by the quantum interference semiconductor device of FIG.27 will be described with reference to FIGS.38A and 38B. In this embodiment, a first device QUID1 is provided such that its source S is connected to the ground. Further, second and third devices QUID2 and QUID3 are provided such that the source S of the QUID2 is connected to the drain D2 of the QUID1 and the source S of the QUID3 is connected to the drain D1 of the QUID1. The drain D1 and D2 of the QUID2 and QUID3 are connected to the voltage source $V_{DD}$ via respective resistors R1 - R3 in which the drain D2 of the QUID2 and the drain D1 of the QUID3 are connected in common. Further, an input terminal A is connected in common to the gate G of the QUID2 and to the gate G of the QUID3 while another input terminal B is connected of the gate G of the QUID1. Furthermore, an output terminal X is connected to the drain D1 of the QUID2, an output terminal Y to the drain D2 of the QUID2 which in turn is connected to the drain D1 of the QUID3, and another output terminal Z connected to the drain D2 of the QUID3.

When an input data "0" is applied to both the input terminals A and B, only the current flowing through the resistor R2 reaches the ground after passing through the devices QUID3 and QUID1, passing the drain D1 and the source S consecutively in each of the devices while no current flows through the resistors R1 and R2. In correspondence thereto, the output at the terminal Y alone assumes the state "1" and other outputs at the terminals X and Z all assume the state "0". When, on the other hand, an input data "1" is applied to both the input terminals A and B, only the current flowing through the resistor R2 reaches the ground after passing through the devices QUID2 and QUID1, passing the drain D1 and the source S consecutively in each of the devices. In this case, too, the output at the output terminal Y alone assumes the output state "1" while other outputs at the output terminals X and Z assume the output state "0". When the input data to the input terminal B alone takes the logic value "1" and the other input data to the input terminal A takes the logic value "0", the path extending along the drain D2 and the source S of the QUID3, passing through the resistor R3, and further along the drain D1 and the source S of the QUID1 becomes conductive while other paths such as the path extending along the drain D1 and the source S of the device QUID2 and further along the drain D2 and the source S of the QUID1 remain non-conducting. As a result, the output at the terminal Z alone assumes the low output state indicating the output state "1" while the other outputs at the terminals X and Y assume the the high output state indicating that the output state is "0". Similarly, the output at the output terminal X alone assumes the state "1" while the other outputs at the terminals Y and Z assume the state "0" when the input data "1" is applied to the input terminal A and the input data "0" is applied to the input terminal B.

FIG.38B summarizes the foregoing operation. It will be clear from the table of FIG.38B, the circuit of FIG.38A operates as a comparator which compares the input data at the terminals A and B and produce outputs at the output terminals X, Y and Z as a result of comparison such that the output "1" appears at the terminal Y when the input data A and B are equal to each other (A = B), the output "1" appears at the terminal Y when the input data at the terminal A is larger than the input data at the terminal B (A > B), and that the output "1" appears at the terminal Z when the input data at the terminal A is smaller than the input data at the terminal B (A < B).

FIG.39A shows another logic circuit constructed by the quantum interference semiconductor device of FIG.27. In this circuit, a first device QUID1 is provided such that its source S is connected to the ground and its drain D2 is connected to the voltage source $V_{DD}$ through a resistor R1. Further, a second device QUID2 is provided such that its source S is connected to the drain D1 of the first device QUID2 and such that its drain D2 is connected, commonly with the drain D2 of the QUID1, to the voltage source $V_{DD}$ through the resistor R1. Further, third and fourth devices QUID3 and QUID4 are provided such that the source S of the QUID3 is connected to the drain D1 of the second device QUID2 and that the drain D1 of the QUID3 is connected to the source S of the fourth device QUID4. The drain D1 and the drain D2 of the fourth device QUID4 are respectively connected to the voltage source $V_{DD}$ through resistors R3 and R4. Furthermore, there is provided a fifth device QUID5 such that its source S is connected to the voltage source $V_{DD}$ via a resister R2, its drain D2 connected to the voltage source $V_{DD}$ via the resister R1, and its drain D1 connected to the drain D2 of the QUID3. Further, input terminals $A_0$ - $A_3$ are connected to gates G of the devices QUID4, QUID3, QUID2 and QUID1 respectively and output terminals $X_0$, $X_1$ and N are connected respectively to the voltage source $V_{DD}$ via resistors R2, R1 and R3.

FIG.39B shows the operation of the circuit of FIG.39A. As the number of combination of input data is numerous, only the operation in response to typical combination of the input data will be described hereinafter. Operation in response to other input combination will be easily deduced from the following description.

In a typical example, an input data (0, 1, 1, 0) is applied to the input terminals $A_0$ - $A_3$. In other words, the data "0" is applied to the input terminals $A_0$ and $A_3$ and the data "1" is applied to the input terminals $A_1$ and $A_2$. In this case, the current flowing through the resister R3 and further through the QUID4 along the drain D1 and the source S in response to the gate voltage applied at the input terminal $A_0$ is stopped at the QUID3 in response to the input data "1" applied to the input terminal $A_1$. Further, the current flowing through the resistor R4 is stopped at the QUID4 in response to the foregoing input data "0" to the input terminal $A_0$. On the other hand, the QUID2 allows the passage of the current along the drain D2 and the source S in response to the input data "1" to the input terminal $A_2$ and the QUID3 allows the passage of the current along the drain D1 to the source S in response to the input data "0" to the input terminal $A_3$. Thus, the current flows only through the resistor R1 and thus, the output at the terminal $X_1$ alone assumes a low level state indicating the output state "1". The other outputs at the output terminals $X_0$ and N all assume the state "0". In FIG.39A, the path of the current in correspondence to this case is represented by a thick line.

In another typical case, an input data (1, 1, 0, 0) is applied to the input terminals $A_0$ - $A_3$. In this case, input data "1" is applied to the input terminals $A_2$ and $A_3$ while input data "0" is applied to the input terminals $A_0$ and $A_1$. In response to the input data "0" at the input terminal $A_0$, a current flows from the voltage source $V_{DD}$ through the resistor R3 and further through the QUID4 along the drain D1 and source S. This current is further overtaken by the QUID3 and flows to the drain D1 of the QUID2 along a path extending along the drain D2 and the source S of the QUID3. The current, however, is stopped at the QUID2 as this device is applied with the input data "1" at its gate G and prohibits the current supplied to the drain D1 to the source S. Thus, the current does not flow through the resister R3 and the output state of the output terminal N becomes "0". The QUID2, applied with the input data "0", prohibits the passage of the current from its drain D1 to its source S while allows the current to flow from its drain D2 to its source S and thus the current is supplied to the drain D1 of the QUID1 from the voltage source $V_{DD}$ after flowing through the resistor R1. This current is stopped at the QUID1, as the device is applied with the input data "1" at its gate G and prohibits the current to flow from its source D1 to its drain S connected to the ground. On the other hand, the QUID1 allows the current supplied to its drain D2 from the voltage source $V_{DD}$, to its source S in response to the input date "1" applied to its gate G. Thus, the output level at the drain D2 of the QUID1 becomes low and the output at the terminal $X_1$ assumes the output state "1". Further, the QUID5, supplied with the input date "1" at its gate from the input terminal $A_3$ together with the QUID1, also passes the current supplied to its source S from the voltage source $V_{DD}$ via the resistor R2 to the drain D2 of the QUID1. As this drain D2 is connected to the ground via the source S of the same QUID1 in this state, the level at the source S of the QUID5 becomes also low and in correspondence thereto, an output "1" is obtained at the output terminal $X_0$.

Operation of the circuit of FIG.39A for other combinations of input data is easily derived similarly to the foregoing examples. As will be seen from FIG.39B, the circuit of FIG.39A operates as a four-level priority encoder.

Next, another logic circuit using the quantum interference semiconductor device of FIG.27 will be described with reference to FIGS.40A and 40B. In this circuit, three quantum interference semiconductor devices QUID1 - QUID3 are provided such that the source S of the QUID1 is connected to the ground, the drain D1 connected to the source S of the QUID3, and the drain D2 of the QUID1 connected to the source S of the QUID2. The drain D2 of the QUID2 is connected to the voltage source $V_{DD}$ via a resistor R1, the drain D1 of the QUID2 and the drain D2 of the QUID3 connected commonly to the voltage source $V_{DD}$ via a resistor R2, and the drain D1 of the QUID3 connected to the voltage source $V_{DD}$ via another resistor R3. Further, an input terminal A is connected to the gates G of the devices QUID2 and QUID3 in common while another input terminal B is connected to the gate G of the QUID1. Thus, the circuit of FIG.40A looks similar to the circuit of FIG.38A although there is a definite difference in the connection of the drains D1 and D2 of the devices QUID2 and QUID3.

FIG.40B shows the operation of the circuit of FIG.40A in response to the application of input data to the input terminals A and B. As will be understood from the table of FIG.40B, the circuit operates as a half-adder. The operation summarized in this table is easily deduced from the foregoing descriptions and therefore, the description thereof will be omitted except for a case in which an input data "1" is applied to the input terminal A and an input data "0" is applied to the input terminal B.

In this case, the current flows from the voltage source $V_{DD}$ after passing through the resistor R2, the drain D2 and the source S of the QUID3, and further through the drain D1 and the source S of the QUID1. In response thereto, the output state at the output terminal S becomes low and an output "1" is obtained at the terminal S. On the other hand, the current flowing from the voltage source $V_{DD}$ through the resistor R1 and further through the drain D2 and the source S of the QUID1 is stopped at the drain D2 of the QUID1 to which the input data "0" is supplied, and the output state at the output terminal S becomes high or "1".

Next, another logic circuit constructed by the quantum interference semiconductor device of FIG.27 will be described with reference to FIGS.41A and 41B. In this embodiment, first and second devices QUID1 and QUID2 are connected parallel to each other such that the sources S thereof are connected in common to the ground and the gates G are connected in common to an input terminal A. Above the devices QUID1 and QUID2, a group of third through sixth devices QUID3 - QUID6 are provided such that the source S of the QUID3 is connected to the drain D2 of the QUID1, the source S of the QUID4 is connected to the drain D1 of the QUID1, the source S of the QUID5 is connected to the drain D2 of the QUID2, and the source S of the QUID6 is connected to the drain D1 of the QUID2. Further, gates G of the devices QUID3 - QUID6 are connected in common to an input terminal B. The drain D2 of the QUID3 is connected to the voltage source $V_{DD}$ via a resistor R1 and the drain D1 of the QUID4 is connected to the voltage source $V_{DD}$ via another resistor R2. Further, there are provided seventh through ninth devices QUID7 -QUID9 above the layer of third through sixth devices such that the source S of the QUID7 is connected commonly to the drain D1 of the QUID3 and to the drain D2 of the QUID4, the drain D2 of the QUID7 connected, commonly to the drain D2 of QUID3, to the voltage source $V_{DD}$ via the resistor R1, and the drain D1 of the QUID7 connected, commonly to the drain D1 of the QUID4, to the voltage source $V_{DD}$ via the resistor R2. Further, the QUID8 has its drain D2 connected, commonly to the drain D2 of the QUID7, to the voltage source $V_{DD}$ via the resistor R1, its source S connected to the drain D2 of the QUID5 and to the drain D1 of the QUID6, and its drain D1 connected to the voltage source $V_{DD}$ via a resistor R3. Furthermore, the QUID9 has its source S connected to the drain D1 of the QUID5 and further to the drain D2 of the QUID6, its drain D1 connected, commonly with the drain D2 of the QUID7, to the voltage source $V_{DD}$ via the resister R1, and its drain D2 connected, commonly to the drain D1 of the QUID8, to the voltage source $V_{DD}$ via the resistor R3. Further, the gates G of the devices QUID7 - QUID 9 are all connected commonly to an input terminal C.

FIG.41B summarizes the operation of the circuit of FIG.41A. As the operation listed is easily derived from the foregoing description, only an operation for a typical input (1, 0, 0) in which an input data "1" is applied to the input terminal A and an input data "0" is applied at the same time to the input terminals B and C, will be described. In response to the input data "0" to the input terminal C, the input data "0" to the input terminal B, and the input data "1" to the input terminal A, a current path shown in FIG.41A by a broken line is established. At the same time, another current path represented by a one-dotted line passing through the resistor R3 is also established. No other current path is formed in the circuit. As a result, the output state at the output terminal S becomes low indicating that the output state is "1". Further, the output state at the output terminal $C_+$ becomes high because of no current flowing through the resistor R2, indicating that the output data at the terminal $C_+$ is "0". Note that the operation of the table in FIG.41B represents the operation of a full-adder.

Next, another logic circuit constructed by using the quantum interference semiconductor device of FIG.27 will be described with reference to FIGS.42A and 42B. In this embodiment, quantum interference semiconductor devices QUID1 - QUID6 are arranged similarly to the corresponding devices of the circuit of FIG.41A except that the source S of the QUID1 as well as the source S of the QUID2 of this circuit are connected respectively to the drains D1 and D2 of another device QUID7 of which source S is connected to the ground. Further, the respective drains D1 of the devices QUID3, QUID4, QUID5 and QUID6 are connected to the voltage source $V_{DD}$ via resistors R1, R3, R5 and R7, respectively, and the respective drains D2 of the devices QUID3, QUID4, QUID5 and QUID6 are connected to the voltage source $V_{DD}$ via resistors R2, R4, R6 and R8. Note that the gate G of the QUID7 is connected to an input terminal $z_1$, the gates G of the QUID1 and QUID2 are connected to an input terminal $z_2$, and the gates G of the devices QUID3 - QUID6 are connected commonly to an input terminal $z_3$. Further, output terminals $x_1$ - $x_8$ are connected respectively to the drain D1 and drain D2 of the QUID3, the drain D1 and drain D2 of the QUID4, the drain D1 and drain D2 of the QUID5, and the drain D1 and drain D2 of the QUID6.

In operation, an output "1" is provided at one of the output terminals $x_1$ - $x_6$ in response to a combination of input data to the input terminals $z_1$ - $z_3$. For example, a current flows consecutively through the resister R3 and the devices QUID4, QUID1 and QUID7 to the ground along a dotted line in FIG.42A in response to a combination of input (0, 1, 0) in which an input data "0" is applied to the input terminals $z_1$ and $z_3$ and an input data "1" is applied to the input terminal $z_2$. As a result, the output data "1" appears only on the diagonal line in the table of FIG.42B in response to the input data to the input terminals $z_1$ -$z_3$ while the non-diagonal elements disappear. The operation summarized in the table of FIG.42B represents that of a three-bit decoder. In FIG.42B, the description for other combination of input data is omitted as such an operation can be easily derived from the foregoing description.

Next, still another logic circuit obtained by using the quantum interference semiconductor device of FIG.27 will be described with reference to FIGS.43A and 43B. In this circuit, a first device QUID1 is provided such that its source S is connected to the ground and its gate G is connected to a first input terminal $A_1$. Further, second and third devices QUID2 and QUID3 are provided such that their sources S are connected respectively to the drain D2 and the drain D1 of the device QUID1 and such that their gates G are connected commonly to a second input terminal $B_1$. Further, there is provided a fourth device QUID4 such that its source S is connected to the drain D2 of the QUID2 and further to the drain D1 of the QUID3 and such that its gate G is connected to a third input terminal $A_0$. Furthermore, fifth and sixth devices QUID5 and QUID6 are provided such that their sources S are respectively connected to the drains D2 and D1 of the device QUID4 and such that the drain D1 of the QUID5 is connected to the voltage source $V_{DD}$ via a resistor R1, the drain D2 of the QUID5 and the drain D1 of the QUID6 are connected commonly to the voltage source $V_{DD}$ via a resistor R2, and the drain D2 of the QUID6 is connected to the voltage source $V_{DD}$ via a resistor R3. Further. the drain D1 of the QUID5 and the drain D1 of the QUID2 are connected in common, and the drain D2 of the QUID6 and the drain D2 of the QUID3 are connected in common.

The operation of this circuit is summarized in the table of FIG.43B. As the operation in this table is easily derived from the foregoing descriptions, the description of the operation of this circuit in response to a combination of input data at the input terminals $A_0$, $B_0$, $A_1$ and $B_1$ will be omitted except for a typical case in which an input data "0" is applied to the input terminals $A_1$ and $B_0$ and an input data "1" is applied to the input terminals $A_0$ and $B_1$. In this case, the current from the voltage source $V_{DD}$ flows along a path shown in FIG.43A by a broken line to the ground, passing through the devices QUID3 and QUID1 while no other current flows. Thus, the low level output indicating the output state "1" appears only at an output terminal Z connected to the resistor R3 while there appears the high level outputs indicating the output state "0" at output terminals X and Y connected respectively to the resistors R1 and R2. The operation summarized in FIG.43B represents the operation of a typical two-bit comparator.

## Claims

1. A quantum interference semiconductor device for producing an output in response to interference of electron waves, comprising: a source region (214) for injecting electrons, a drain region (216) for collecting electrons, passage means (217c) for flowing the injected electrons from the source region to the drain region, and passage dividing means (218, 220, 222) provided in the passage means for dividing the passage means into a first region in contact with the source region and a second region in contact with the drain region by inducing depletion regions (218e, 220e, 222a) in the passage means so as to prohibit the electrons flowing therethrough;
characterized in that said passage dividing means having a longitudinal size (L) measured in the direction of flow of electrons from the source region to the drain region to be approximately equal to or smaller than the inelastic and elastic scattering length of electrons, said passage dividing means being constructed such that there are formed a plurality of channels (224, 226) between the depletion regions induced by passage dividing means for passing the electrons from the first region to the second region by dividing each of the electrons into a plurality of electron waves (227) respectively passing through the plurality of channels, said passage dividing means being further constructed such that at least one spot-like channel region (224, 226) is formed in each of the plurality of channels so as to be isolated from each other for passing the electron wave with a predetermined phase shift, each of said spot-like channel regions being bounded by a pair of depletion regions defining the channels with a lateral width (W) measured perpendicularly to the general direction of movement of electrons from the source region to the drain region such that the lateral width is confined approximately equal to or smaller than the de Broglie wavelength of the electrons passing therethrough, and control means (218, 220) for controlling the phase of electron waves passing through at least one of the plurality of spot-like channel regions.

2. A device as claimed in claim 1 characterized in that each of the spot-like channel regions (224, 226) has a lateral width (W) confined such that a quantum well structure is formed in the spot-like channel region with an energetical separation ($\Delta E$) between adjacent quantum levels ($E_{01}$, $E_{02}$) larger than the thermal energy of electrons.

3. A device as claimed in claim 1 characterized in that said passage means (217c) has a modulation doped structure inducing a two-dimensional electron gas (111a), so that the electrons flow through the passage means in a form of two-dimensional electron gas.

4. A device as claimed in claim 1 characterized in that said passage dividing means comprises a pair of gate electrodes (218, 220) provided on the passage means so as to face each other in a direction generally perpendicularly to the direction of flow of electrons from the source region to the drain region for inducing the depletion regions (218e, 220e) in the passage means (217c) underneath by making a Schottky contact therewith, and a spot-like surface region (222) provided on the surface of the passage means between the pair of gate electrodes so as to induce another depletion region in the passage means underneath.

5. A device as claimed in claim 4 characterized in that one of the spot-like channel regions (224) is formed in coincidence to a first channel defined between the depletion region (218e) induced by one of the gate electrodes (218) and the depletion region (222a) induced by the spot-like surface region, and the other of the spot-like regions (226) is formed in coincidence to a second channel defined between the depletion region (220e) induced by the other of the gate electrodes (220) and the depletion region (222a) induced by the spot-like surface region (222).

6. A device as claimed in claim 4 characterized in that each of the gate electrodes (218, 220) has a sharp-pointed end facing with each other separated by the spot-like surface region (222).

7. A device as claimed in claim 6 characterized in that said spot-like surface region (222) is located substantially on the line connecting the sharp-pointed ends of the gate electrodes (218, 220).

8. A device as claimed in claim 6 characterized in that said spot-like surface region (222) is provided at a position offset from the line connecting the sharp-pointed ends of the gate electrodes (316, 318).

9. A device as claimed in claim 8 characterized in that an additional spot-like channel region (322) is provided between the pair of sharp-pointed ends of the gate electrodes (316, 318).

10. A device as claimed in claim 4 characterized in that said spot-like surface region (222) on the passage means (217c) is formed by doping.

11. A device as claimed in claim 7 characterized in that said spot-like surface region (222) has a size of about 0.1 $\mu$m or less.

12. A device as claimed in claim 4 characterized in that one or more of said gate electrodes (218, 220) act also as the control means for controlling the phase of electron waves by controlling the extension of depletion regions (218e, 220e) in the passage means in response to a gate voltage applied thereto.

13. A device as claimed in claim 12 characterized in that each of said spot-like channel regions (224, 226) induces a phase shift of an even integer multiple of $\pi$ including zero to the electron wave passing therethrough in response to a first gate voltage applied to the gate electrode (218, 220) and a phase shift of an odd integer multiple of $\pi$ in response to a second gate voltage.

14. A device as claimed in claim 1 characterized in that said passage dividing means comprises a region (246) formed on the surface of the passage means by modifying the surface for inducing the depletion regions in the passage means (217c) underneath.

15. A device as claimed in claim 14 characterized in that said region (246) inducing the depletion regions comprises a groove (246a, 246b, 246c) formed on the surface of the passage means (217c) so as to traverse the passage means with respect to the general direction of movement of electrons from the source region (214) to the drain region (216), with at least a pair of ungrooved regions (254, 256) remained in correspondence to the spot-like channel regions (254a, 256a).

16. A device as claimed in claim 15 characterized in that a gate electrode (258) is provided as the control means on the groove (246) such that the gate electrode at least covers one of the ungrooved regions (254, 256).

17. A device as claimed in claim 1 characterized in that said control means comprises magnetic means (268, 270) for applying a magnetic field (B) across the passage means such that the magnetic field passes through the passage means at least at the passage dividing means.

18. A device as claimed in claim 1 characterized in that the device further comprises an additional passage dividing means (244, 248) for inducing additional depletion regions at at least one of the upstream side and the downstream side of the first passage dividing means with respect to the general direction of flow of electrons from the source region (214) to the drain region (216) so as to prohibit the electrons passing therethrough, said additional passage dividing means defining an additional spot-like channel region (250a, 252a) having a size approximately identical to that of the spot-like channel regions in the plurality of channels with such a relation that the distance from the additional spot-like channel region to one of the plurality of spot-like channel regions (254a, 256a) is identical to the distance from the additional spot-like channel region to the other of the plurality of spot-like channel regions (254a, 256a).

19. A device as claimed in claim 18 characterized in that said additional spot-like channel region (250a, 252a) is formed in coincidence to an additional channel defined by a pair of depletion regions induced by the additional passage dividing means (244, 248).

20. A device as claimed in claim 19 characterized in that said additional passage dividing means comprises a pair of gate electrodes (316b, 318b; 316c, 318c) making Schottky contact with the passage means for inducing the additional depletion regions defining the additional spot-like channel region (322, 323).

21. A device as claimed in claim 19 characterized in that said additional passage dividing means comprises a pair of grooves (244, 248) provided on the surface of the passage means (217c) in correspondence to the pair of depletion regions (250, 252) so as to induce the additional depletion regions in the passage means.

22. A device as claimed in claim 1 characterized in that said passage dividing means comprises a first gate electrode (408) provided on the passage means at a first lateral side with respect to the flow of electrons from the source region (214) to the drain region (216) and a plurality of other gate electrodes (410, 412) provided on the common passage means at a second lateral side opposite from the first side with respect to the flow of electrons in a manner aligned along the flow of electrons so as to face the first gate electrode, said first gate electrode and said other gate electrodes inducing the depletion regions in the passage means (217c) underneath by making a Schottky contact therewith, said passage dividing means further comprises a surface region (222) provided on the passage means between the first gate electrode and the other gate electrodes for inducing another depletion region in the passage means underneath, said depletion regions induced by the first and other gate electrodes defining the plurality of spot-like channel regions such that one of the spot-like channel regions (416) is formed at the first side with respect to the surface region so as to be defined by the depletion region induced underneath the first gate electrode and the depletion region induced underneath the surface region, and that the other spot-like channel regions (418, 420) are formed at the second side with respect to the surface region consecutively along the flow of electrons between the depletion region induced underneath the surface region and respective depletion regions induced underneath the other gate electrodes.

23. A device as claimed in claim 22 characterized in that said surface region (222) comprises a spot-like doped region having a diameter of about 0.1 $\mu$m or less.

24. A device as claimed in claim 23 characterized in that said other gate electrodes comprise second and third gate electrodes (410, 412), and said first through third gate electrodes are disposed so as to surround the spot-like doped region (222) with an equal separation.

25. A device as claimed in claim 24 characterized in that said first through third gate electrodes (408, 410, 412) have a sharp-pointed tip at the end facing the spot-like doped region (222).

26. A device as claimed in claim 24 in which each of the gate electrodes (408, 410, 412) induces a relative phase shift of zero in the electron wave passing though the corresponding spot-like channel region (416, 418, 420) in response to a first gate voltage while induces a phase shift of an odd integer multiple of $\pi$ in response to a second gate voltage.

27. A quantum interference semiconductor device for supplying a current of electrons to selected one of a plurality of outputs as a result of interference of electron waves,
characterized by a source region (214) for injecting electrons, a plurality of drain regions (216a, 216b), respectively adapted to be connected to the plurality of outputs and separated from each other, for collecting the electrons injected by the source region, passage means (217c) having a modulation doped structure for passing the electrons from the source region to the plurality of drain regions in a form of two-dimensional electron gas, said passage means having a branched construction comprising a plurality of arms in which one of the arms is connected to the source region and the other arms connected to the plurality of drain regions respectively, passage dividing means (222, 510, 512, 514) provided on the passage means between the arm connected to the source region and the other arms connected to the drain regions, for prohibiting passage of electrons therethrough, said passage dividing means being constructed such that channel means (X1, X2, Y1, Y2) is provided in the passage dividing means for passing the electrons from the arm connected to the source region to the other arms connected to the drain regions, said channel means comprising a plurality of spot-like channel regions (518, 520, 522) for passing the electrons in a form of electron waves with controlled phase shifts, said plurality of spot-like channel regions being disposed in the channel means such that each electron passes through the channel means from the arm connected to the source region to the arm connected to any one of the plurality of drain regions in a form of at least two electron waves travelling along respective paths each including one or more of the spot-like channel regions, and means (510, 512, 514) for controlling the phase shift of the electrons passing through the plurality of spot-like channel regions.

28. A device as claimed in claim 27 characterized in that said passage dividing means comprises a plurality of gate electrodes (510, 512, 514) provided on the passage means such that two gate electrodes invade into respective arms from both sides thereof at the portion of the passage means where it is branched into the plurality of arms, with such a configuration that hypothetical extensions of the plurality of gate electrodes intersect with each other at a point in the part of the passage means where the passage means is branched, said plurality of gate electrodes inducing depletion regions in the passage means by making a Schottky contact therewith, and a spot-like surface region (222) provided on the passage means in correspondence to the point where the hypothetical extension of the gate electrodes intersect each other, for inducing a depletion region in the passage means underneath, each of said plurality of channel regions (518, 520, 522) being defined by one of the depletion regions induced by the corresponding gate electrode and the depletion region induced by the spot-like surface region.

29. A device as claimed in claim 28 characterized in that said means for controlling the phase shift comprises the gate electrodes (510, 512, 514) which control the extension of the depletion regions induced underneath in response to gate voltages applied thereon.

30. A device as claimed in claim 28 characterized in that the number of drain regions (216a, 216b) is two, the number of arms connected to the plurality of drain regions is two, one of the paths (X2, Y2) of the electron wave through the channel means includes two spot-like channel regions, and the other path (X1, Y1) includes one spot-like channel region.

31. A device as claimed in claim 30 characterized in that each of the spot-like channel regions (518, 520, 522) in the channel means (X1, X2, Y1, Y2) induces a phase shift of zero in the electron wave passing therethrough in a first state and an odd integer multiple of $\pi$ to the electron waves passing therethrough in a second state.

32. A device as claimed in claim 27 characterized in that the number of drain regions (216a, 216b, 216c) is three, the number of arms connected to the plurality of drain regions is three, one of the paths (X2, Y2) of the electron wave through the channel means includes three spot-like channel regions, and the other path (X1, Y1) includes one spot-like channel region.

33. A device as claimed in claim 32 characterized in that each of the spot-like channel regions (618, 620, 622, 623) in the channel means induces a phase shift of zero in the electron wave passing therethrough in a first state and an odd integer multiple of $\pi/2$ to the electron waves passing therethrough in a second state.

34. A quantum interference semiconductor device for supplying current of electrons from a plurality of input terminals to a plurality of output terminals along respective and selected paths by establishing the selected paths as a result of interference of electron waves,
characterized by a plurality of source regions (214a, 214b) separated from each other and adapted to be connected to input terminals for injecting electrons, a plurality of drain regions (216a, 216b) separated from each other and adapted to be connected to the plurality of outputs for collecting the electrons injected by the source region, passage means (217c) having a modulation doped structure for passing the electrons from the plurality of source region to the plurality of drain regions in a form of two-dimensional electron gas, said passage means having a branched construction comprising a plurality of arms in which a first group of arms are connected to the source region and second group of arms connected to the plurality of drain regions respectively, passage dividing means (222, 610, 612, 614, 615) provided on the passage means between the arms connected to the source region and the arms connected to the drain regions, for prohibiting passage of electrons therethrough, said passage dividing means being constructed such that channel means (X1, X2, Y1, Y2, Z1, Z2, W1, W2) is provided in the passage dividing means for passing the electrons from the arms connected to the plurality of source region to the arms connected to the drain regions, said channel means comprising a plurality of spot-like channel regions (618, 620, 622, 623) for passing the electrons in a form of electron waves with controlled phase shifts, said plurality of spot-like channel regions being disposed in the channel means such that each electron passes through the channel means from one of the arms connected to one of the source regions to the arm connected to any one of the plurality of drain regions in a form of at least two electron waves travelling along respective paths each including one or more of the spot-like channel regions, and means (610, 612, 614, 615) for controlling the phase shift of the electrons passing through the plurality of spot-like channel regions.

35. A half-adder for adding binary input data, characterized by first and second quantum interference semiconductor devices (400a, 400b), each comprising a source electrode (214, 214′) adapted to be connected to a voltage source, a drain electrode (216, 216′) adapted to be connected to an output terminal, passage means (217c, 217c′) provided between the source electrode and the drain electrode for passing a flow of electrons from the source electrode to the drain electrode, elongated passage dividing means (414, 414′) provided on the passage means at an intermediate position between the source electrode and the drain electrode so as to extend along the flow of electrons for a length comparable to or smaller than the elastic and inelastic scattering length of electrons in the passage means, said passage dividing means inducing a correspondingly elongated central depletion region in the passage means for dividing each of the electrons flowing through the passage means into a first electron wave propagating along a first path (X1, Y1) at a first side of the passage dividing means and a second electron wave propagating along a second path (X2, Y2) at a second side opposite from the first side of the passage dividing means, a first gate electrode (408, 408′) provided on the passage means at the first side with respect to the passage dividing means for inducing a first depletion region in the passage means as a result of Schottky contact such that a first spot-like channel region (416, 416′) is defined between the depletion region and the elongated central depletion region with a size approximately equal to or smaller than the de Broglie wavelength of the electrons passing therethrough, second and third gate electrodes (410, 412) provided on the passage means at the second side with respect to the passage dividing means consecutively along the direction of flow of electrons for inducing respective depletion regions in the passage means as a result of Schottky contact, said second and third gate electrodes defining second and third spot-like channel regions (418, 420, 418′, 420′) between the depletion regions corresponding to the second and third gate electrodes and the depletion region induced underneath the elongated passage dividing means such that the second and third spot-like channel regions are aligned consecutively along the second path of the electron wave, each of said second and third gate electrodes being adapted to be supplied with the input data and changes the extension of the depletion region in response thereto, wherein each of the second and third gate electrodes of the first quantum interference semiconductor device is connected electrically to corresponding second and third gate electrodes of the second quantum interference semiconductor device, and wherein the first through third gate electrodes of the first and second quantum interference semiconductor devices are configured such that the spot-like channel regions formed in the first quantum interference semiconductor device have a longitudinal length, measured in the direction of flow of electrons from the source region to the drain region, twice as large as that of the spot-like channel regions formed in the second quantum interference semiconductor device and such that the electron wave passing through each of the second and third spot-like channel regions in the first quantum interference semiconductor device experiences a relative phase shift of zero with respect to the electron wave passing through the first spot-like channel region of the same first quantum interference semiconductor device when the binary input data at the second and third gate electrodes is in a first state while experiences a relative phase shift of $\pi$ when the binary input data is in a second state, and that the electron wave passing through each of the second and third spot-like channel regions in the second quantum interference semiconductor device experiences a phase shift of zero with respect to the electron wave passing through the first spot-like channel region of the same second quantum interference semiconductor device when the binary input data at the second and third gate electrode is in the first state while experiences a relative phase shift of $\pi/2$ in response to the second state of the binary input data, whereby a result of sum of the input data at the second and third gate electrodes is obtained at the drain of the first quantum interference semiconductor device and a carry produced by the sum operation is obtained at the drain of the second quantum interference semiconductor device.

36. A half-adder as claimed in claim 35 characterized in that each of the second and third gate electrodes (410, 412) has an edge facing the second and third spot-like channel regions (418′, 420′) in the first quantum interference semiconductor device (400b) which is twice as large as an edge of the second and third gate electrodes of the second quantum interference semiconductor device (400a) facing the second and third spot-like channel regions (418, 420) formed therein.

37. A full-adder for adding binary input data, characterized by first and second quantum interference semiconductor devices (400c, 400d), each comprising a source electrode (214, 214′) adapted to be connected to a voltage source, a drain electrode (216, 216′) adapted to be connected to an output terminal, passage means (217c, 217c′) provided between the source electrode and the drain electrode for passing a flow of electrons from the source electrode to the drain electrode, elongated passage dividing means (414) provided on the passage means at an intermediate position between the source electrode and the drain electrode so as to extend along the flow of electrons for a length comparable to or smaller than the elastic and inelastic scattering length of electrons in the passage means, said passage dividing means inducing a correspondingly elongated central depletion region in the passage means for dividing each of the electrons flowing through the passage means into a first electron wave propagating along a first path at a first side of the passage dividing means and a second electron wave propagating along a second path at a second side opposite from the first side of the passage dividing means, a first gate electrode (408, 408′) provided on the passage means at the first side with respect to the passage dividing means for inducing a first depletion region in the passage means as a result of Schottky contact such that a first spot-like channel region (416, 416′) is defined between the depletion region and the elongated central depletion region with a size approximately equal to or smaller than the de Broglie wavelength of the electrons passing therethrough, second through fourth gate electrodes (410, 412, 462) provided on the passage means at the second side with respect to the passage dividing means consecutively along the direction of flow of electrons for inducing respective depletion regions in the passage means as a result of Schottky contact, said second through fourth gate electrodes defining second through fourth spot-like channel regions (418, 420, 464, 418′, 420′, 464′) between the depletion regions corresponding to the second through fourth gate electrodes and the depletion region induced underneath the elongated passage dividing means such that the second through fourth spot-like channel regions are aligned consecutively along the second path of the electron wave, each of said second through fourth gate electrodes being adapted to be supplied with the binary input data and changes the extension of the depletion region in response thereto, wherein each of the second through fourth gate electrodes of the first quantum interference semiconductor device is connected electrically to corresponding second through fourth gate electrodes of the second quantum interference semiconductor device, and wherein the first through fourth gate electrodes of the first and second quantum interference semiconductor devices are configured such that the spot-like channel regions formed in the first quantum interference semiconductor device have a longitudinal length, measured in the direction of flow of electrons from the source region to the drain region, three times as large as that of the spot-like channel regions formed in the second quantum interference semiconductor device and such that the electron wave passing through each of the second through fourth spot-like channel regions in the first quantum interference semiconductor device experiences a relative phase shift of zero with respect to the electron wave passing through the first spot-like channel region in the same first quantum interference semiconductor device when the binary input data at the second through third gate electrodes is in a first state while experiences a relative phase shift of $\pi/3$ when the binary input data is in a second state, and that the electron wave passing through each of the second through fourth spot-like channel regions in the second quantum interference semiconductor device experiences a phase shift of zero with respect to the electron wave passing through the first spot-like channel region of the same second quantum interference semiconductor device when the binary input data at the second through fourth gate electrode is in the first state while experiences a relative phase shift of $\pi/3$ in response to the second state of the binary input data, whereby a result of sum of the input data at the second and third gate electrodes is obtained at the drain of the first quantum interference semiconductor device and a carry produced by the sum operation is obtained at the drain of the second quantum interference semiconductor device.

38. A full-adder as claimed in claim 37 chacaterized in that each of the second through fourth gate electrodes (410, 412, 462) has an edge facing the second and third spot-like channel regions in the first quantum interference semiconductor device (400d) which is three as large as an edge of the second and third gate electrodes of the second quantum interference semiconductor device (400c) facing the second and third spot-like channel regions formed therein.

39. An inverter,
characterized by a quantum interference semiconductor device, which in turn comprises a single source, first and second drains, passage means having a branched construction and branched into first through third arm portions respectively connected to the source and first and second drains, for passing electrons from the single source to the first and second drains, a spot-like surface region provided on the passage means in a correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;

wherein the gate electrode is connected to an input terminal for receiving an input signal, the first drain connected to a voltage source via a first resistor, the second drain connected to the voltage source via a second resistor, and the first and second drains connected to respective output terminals providing the input signal with inversion and without inversion.

40. A logic device for a logic operation of input signals,

characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of split electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the gate electrode of a first device is connected to a first input terminal for receiving an input signal, the source of the first device connected to the ground, the first drain of the first device connected to a voltage source via a first resistor, the second drain of the first device connected to the source of a second device, the first drain of the second device connected to the voltage source via the first resistor, the second drain of the second device connected to the voltage source via the second resister, the gate electrode of the second device connected to a second input terminal for receiving another input signal, the first drains of the first and second devices are connected to a first output terminal providing an AND output of the input signals to the first an second input terminals, and the second drain connected to a second output terminal providing a NAND output of the input signals.

41. A logic device for performing a logic operation of input signals,
characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the source of a first device is connected to the ground, the gate electrode of the first device connected to a first input terminal for receiving an input signal, the first drain of the first device connected to the source of a second device, the second drain of the first device connected to a voltage source via a first resister, the second drain of the second device connected to the voltage source commonly to the second drain of the first device via the first resistor, the gate electrode of the second device connected to a second input terminal for receiving another input signal, the first drain of the second device connected the voltage source via a second resister, and the first and second drains of the second device respectively connected to a first output terminal providing a NOR output of the input signals and a second output terminal providing an OR output of the input signals.

42. A logic device for performing a logic operation of input signals,

characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;

wherein the source of a first device is connected to the ground, the gate electrode of the first device connected to a first input terminal for receiving an input signal, the first drain of the first device connected to the first drain of a second device, the second drain of the first device connected to the second drain of the second device, the gate electrode of the second device connected to a second input terminal for receiving another input signal, the source of the second device connected to a voltage source and further to an output terminal providing an exclusive OR output of the input signals.

43. A logic device for performing a logic operation of input signals,

characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the source of a first device is connected to the ground, the gate electrode of the first device connected to a first input terminal for receiving an input signal, the first drain of the first device connected to the first drain of a second device, the second drain of the first device connected to the second drain of the second device, the gate electrode of the second device connected to a second input terminal for receiving another input signal, the source of the second device connected to a voltage source and further to an output terminal providing an exclusive NOR output of the input signals.

44. A logic device for performing a logic operation of input signals,
characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of split electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the source of a first device is connected to the ground, the gate electrode of the first device connected to a first input terminal for receiving an input signal, the first drain of the first device connected to the second drain of a second device, the second drain of the first device connected to the first drain of the second device, the gate electrode of the second device connected to a second input terminal for receiving another input signal, the source of the second device connected to a voltage source and further to an output terminal providing an exclusive OR output of the input signals.

45. A comparator for comparing first and second input signals and producing a result of comparison selectively at one of three output terminals, characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of split electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;

wherein the source of a first device is connected to the ground, the gate electrode of the first device connected to a first input terminal for receiving the first input signal, the second drain connected to the source of a second device, the first drain connected to the source of a third device, the first drain of the second device connected to a voltage source via a first resister, the second drain of the second device connected to the first drain of the third device and further to the voltage source via a second resistor, the second drain of the third device connected to the voltage source via a third resister, the gate electrodes of the second and third devices connected commonly to another input terminal for receiving the second input signal, and in which the three output terminals are connected such that the first of the output terminals connected to the first drain of the second device, the second of the output terminals connected to the second drain of the second device, and the third of the output terminals connected to the second drain of the third device.

46. A four-level priority encoder for producing first through third output signals at first through third output terminals in response to a combination of input data supplied at first through four input terminals such that a first output data appears at the first and second output terminals in response to a first input data to the first input terminal, the first output data appears only at the first output terminal in response to a second input data to the first input terminal and the first input data to the second input terminal, the first output data appears only at the second output terminal in response to the second input data to the first and second input terminals while the first input data to the third input terminal, a second output data appears to all of the first through third output terminals in response to the first input data to the fourth input terminal while the second input data to the first through third input terminals, and that the first output data appears at the third output terminal in response to the second input data to the first through fourth input terminals, characterized in that the four-level priority encoder comprises a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of split electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the source of a first device is connected to the ground, the gate electrode of the first device connected to the first input terminal, the second drain of the first device connected to a voltage source via a first resistor, the first drain of the first device connected to the source of a second device, the second drain of the second device connected, commonly to the second drain of the first device, to the voltage source via the first resister, the first drain of the second device connected to the source of a third device, the gate electrode of the second device connected to the second input terminal, the first drain of the third device connected to the source of a fourth device, the second drain of the third device connected to the first drain of a fifth device, the gate electrode of the third device connected to the third input terminal, the source of the fifth device connected to the voltage source via a second resistor, the second drain of the fifth device connected to the voltage source, commonly to the second drains of the first and second devices, via the first resister, the gate electrode of the fifth device connected, commonly to the gate electrode of the first device, to the first input terminal, the first drain of the fourth device connected to the voltage source via a third resistor, the second drain of the fourth device connected to the voltage source via a fourth resister, and the gate electrode of the fourth device connected to the fourth input terminal.

47. A half-adder for adding input binary data applied to first and second input terminals, characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of split electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;

wherein the source of a first device is connected to the ground, the gate electrode of the first device connected to the first input terminal, the second drain of the first device connected to a source of the second device, the first drain of the first device connected to the source of the third device, the second drain of a second device connected to a voltage source via a first resister, the first drain of the second device connected to the voltage source via a second resister, the second drain of a third device connected, commonly to the first drain of the second device, to the voltage source via a second resistor, the first drain of the third device connected to the voltage source via a third resistor, the gate electrodes of the second and third devices connected commonly to the second input terminal, the second drain of the third device connected to a first output terminal providing a result of addition of input data applied to the first and second input terminals, and the second drain of the second device connected to a second output terminal providing the carry produced as a result of the addition.

48. A full-adder for adding input binary data applied to first through third input terminals,

characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;

wherein the source of a first device is connected to the ground, the source of a second device is connected to the ground, the gate electrodes of the first and second devices are connected commonly to a first input terminal, the first drain of the first device connected to the source of the second device, the second drain of the first device connected to the source of a fourth device, the first drain of the second device connected to the source of a fifth device, the second drain of the second device connected to the source of a sixth device, the gate electrodes of the third through sixth devices connected commonly to a second input terminal, the first drain of the third device connected to a voltage source via a first resistor, the second drain of the third device connected to the source of a seventh device, the first drain of the fourth device connected, commonly to the second drain of the third device, to the source of the seventh device, the second drain of the fourth device connected to the voltage source via a second resistor, the first drain of the fifth device connected to the source of the eighth device, the second drain of the fifth device connected to the source of the ninth device, the second drain of the sixth device connected, commonly to the first drain of the fifth device, to the source of the eighth device, the first drain of the sixth device connected to the source of the ninth device, the gate electrodes of the seventh through ninth devices connected commonly to a third input terminal, the first drain of the seventh device connected to the voltage source via the first resistor, the second drain of the seventh device connected, commonly to the second drain of the fourth device, to the voltage source via the second resister, the first drain of the eighth device connected, commonly to the first drain of the seventh device, to the voltage source via the first resistor, the second drain of the eighth device connected to the voltage source via a third resistor, the first drain of the ninth device connected, commonly to the second drain of the eighth device, to the voltage source via the third resistor, the second drain of the ninth device connected, commonly to the first drain of the seventh device, to the voltage source via the first resistor, and wherein a first output terminal providing the sum of the addition is connected to the first drain of the ninth device, and a second output terminal providing the carry produced as a result of addition is connected to the second drain of the seventh device.

49. A decoder for producing an output selectively at a plurality of output terminals in response to a combination of input data applied to a plurality of input terminals,
characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the source of a first device is connected to the ground, the gate electrode of the first device is connected to a first input terminal, the first drain of the first device connected to the source of a second device, the second drain of the first device connected to the source of the third device, the gate electrodes of the second and third devices connected commonly to a second input terminal, the first drain of the second device connected to the source of a fourth device, the second drain of the second device connected to the source of a fifth device, the first drain of the third device connected to the source of the sixth device, the second drain of the third device connected to the source of the sixth device, the first drain of the fourth device connected to a voltage source via a first resister, the second drain of the fourth device connected to the voltage source via a second resister, the first drain of the fifth device connected to the voltage source via a third resistor, the second drain of the fifth device connected to the voltage source via a fourth resistor, the first drain of the sixth device connected to the voltage source via a fifth resistor, the second drain of the sixth device connected to the voltage source via a sixth resistor, the first drain of the seventh device connected to the voltage source via a seventh resistor, and the second drain of the seventh device connected to the voltage source via an eighth resistor, the first drain of the fourth device connected to a first output terminal, the second drain of the fourth device connected to a second output terminal, the first drain of the fifth device connected to a third output terminal, the second drain of the fifth device connected to a fourth output terminal, the first drain of the sixth device connected to a fifth output terminal, the second drain of the sixth device connected to a sixth output terminal, the first drain of the seventh device connected to a seventh output terminal, and the second drain of the seventh device connected to an eighth output terminal.

50. A two-bit comparator for comparing a two-bit data supplied to first and second input terminals with another two-bit data supplied to third and fourth input terminals for producing a three-bit output data indicative of the result of comparison,
characterized by a plurality of quantum interference semiconductor devices, each comprising a single source, first and second drains, passage means having a branched construction and branched into first through third arm portions respectively connected to the source and first and second drains, for passing electrons from the single source to the first and second drains, a spot-like surface region provided on the passage means in correspondence to a junction part where the first through third arm portions merge each other for inducing a spot-like depletion region in the junction part, first and second Schottky electrodes provided on the passage means in correspondence to the junction part so as to extend towards the spot-like surface region from both sides of the first arm for inducing first and second depletion regions in the junction part respectively such that the first depletion region defines a first spot-like channel region between the first depletion region and the spot-like depletion region and such that the second depletion region defines a second spot-like channel region between the second depletion region and the spot-like depletion region, said first and second spot-like channel regions passing each of the electrons flowing from the source region in a form of splitted electron waves and having a lateral size measured perpendicularly to the direction of propagation of electron waves such that the lateral size is approximately equal to or smaller than the de Broglie wavelength of electron waves incident thereto, said first and second Schottky electrodes being biased such that a relative phase shift of $\pi/2$ is induced in the electron wave passing through the first spot-like channel region with respect to the electron wave passing through the second spot-like region, and a gate electrode provided on the passage means in correspondence to the junction part between the second and third arms along a boundary between the second and third arms so as to extend towards the spot-like surface region, said gate electrode making Schottky contact with the passage means and inducing a third depletion region in the junction part such that the third depletion region extend towards the spot-like depletion region induced underneath the spot-like surface region for defining a third spot-like channel region between the third depletion region and the spot-like depletion region for passing the electron waves, said spot-like depletion region having the lateral size approximately equal to or smaller than the de Broglie wavelength of the electron waves incident thereto and induces a phase shift of $\pi/2$ in the electron wave passing therethrough in a first state corresponding to a first gate voltage applied to the gate electrode and a phase shift of $-\pi/2$ in a second state corresponding to a second gate voltage at the gate electrode, whereby the electrons flow from the source to the first drain in response to the first gate voltage while flow to the second drain in response to the second gate voltage;
wherein the source of a first device is connected to the ground, the second drain of the first device connected to the source of a second device, the first drain of the first device connected to the source of the third device, the gate electrode of the first device connected to the first input terminal, the gate electrodes of the second and third devices connected commonly to a second input terminal, the first drain of the second device connected to a voltage source via a first resister, the second drain of the second device connected to the source of a fourth device, the first drain of the third device connected, commonly to the second drain of the second device, to the source of the fourth device, the second drain of the third device connected to the voltage source via a second resister, the gate electrode of the fourth device connected to a third input terminal, the second drain of the fourth device connected to the source of a fifth device, the first drain of the fourth device connected to the source of a sixth device, the first drain of the fifth device connected to the voltage source, commonly to the first drain of the second device, to the voltage source via the first resister, the second drain of the fifth device connected to the voltage source via a third resistor, the first drain of the sixth device connected, commonly to the second drain of the fifth device, to the voltage source via the third resistor, the second drain of the sixth device connected to the voltage source via the second resistor, the gate electrodes of the fifth and sixth devices are connected commonly to a fourth input terminal, and wherein a first output terminal is connected to the first drain of the fifth device, a second output terminal is connected to the second drain of the fifth device, and a third output terminal is connected to the second drain of the sixth device.

51. A method of fabricating a quantum interference semiconductor device for producing an output in response to interference of wave function of electrons, comprising steps of providing an semiconductor substrate (207), providing an active layer (208) of undoped semiconductor material, providing a doped layer (210) of semiconductor material doped with an impurity element and having an electron affinity smaller than the active layer, on the active layer, providing a cap layer (212) having a conductive type identical to that of the doped layer on the doped layer, so that a two-dimensional electron gas acting as a passage of electrons is formed at a boundary between the active layer and the doped layer,
characterized in that the method further comprises steps of providing a plurality of electrodes (218, 220), which makes a Schottky when contacted with the doped layer, on the doped layer with a predetermined separation so as to eliminate the two-dimensional electron gas in correspondence to the electrodes, forming a high resistivity region (222) in a part of the cap layer located between the plurality of electrodes by selective ion implantation such that the two-dimensional electron gas is eliminated in correspondence to the high resistivity region, said high resistivity region in combination with the plurality of gate electrode defining a channel of the two-dimensional electron gas which has a length measured in the direction of electron flow approximately equal to or smaller than the elastic and inelastic scattering length of electrons, said channel of the two-dimensional electron gas further having a width measured in the direction perpendicularly to the flow of electrons approximately equal to or smaller than the de Broglie wavelength of the electrons passing therethrough.

52. A method as claimed in claim 1 characterized in that said region (222) of high resistance is formed by irradiation of focused ion beam to the cap layer.

53. A method of fabricating a quantum interference semiconductor device for producing an output in response to interference of wave function of electrons, comprising steps of providing an semiconductor substrate (207), providing an active layer (208) of undoped semiconductor material, providing a doped layer (210) of semiconductor material doped with an impurity element and having an electron affinity smaller than the active layer, on the active layer, and providing a cap layer (212) having a conductive type identical to that of the doped layer on the doped layer so that a two-dimensional electron gas acting as a passage of electrons is formed at a boundary between the active layer and the doped layer,
characterized in that the method further comprises steps of providing a plurality of grooved regions (246) in the doped layer by selective etching so as to eliminate the two-dimensional electron gas in correspondence to the grooves such that the plurality of grooved regions define a channel of the two-dimensional electron gas which has a length measured in the direction of electron flow approximately equal to or smaller than the elastic and inelastic scattering length of electrons, said channel of the two-dimensional electron gas further having a width measured in the direction perpendicularly to the flow of electrons approximately equal to or smaller than the de Broglie wavelength of the electrons passing therethrough.

54. A method as claimed in claim 53 characterized in that the method further comprises a step of forming a region (216b) having a high resistance by selective ion implantation such that the channel is formed between the region of high resistance formed by ion implantation and the groove formed by selective etching.

FIG. 1 PRIOR ART

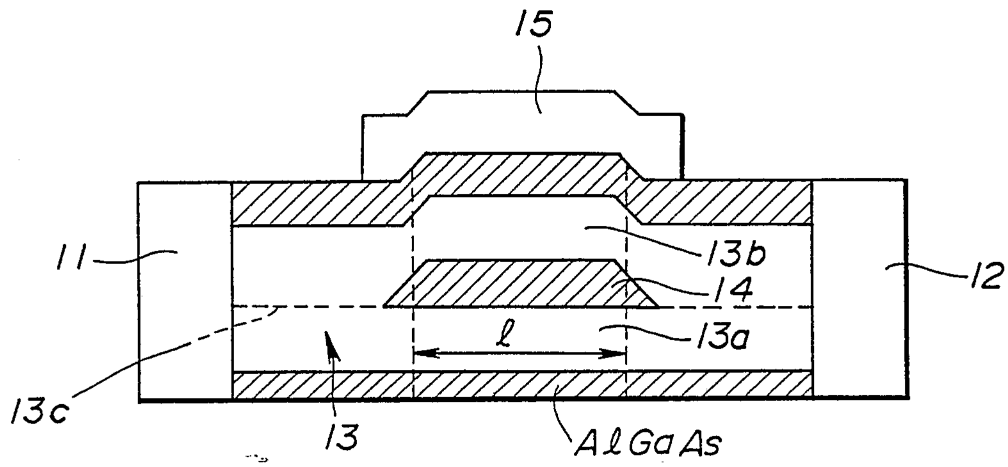


FIG. 2 PRIOR ART

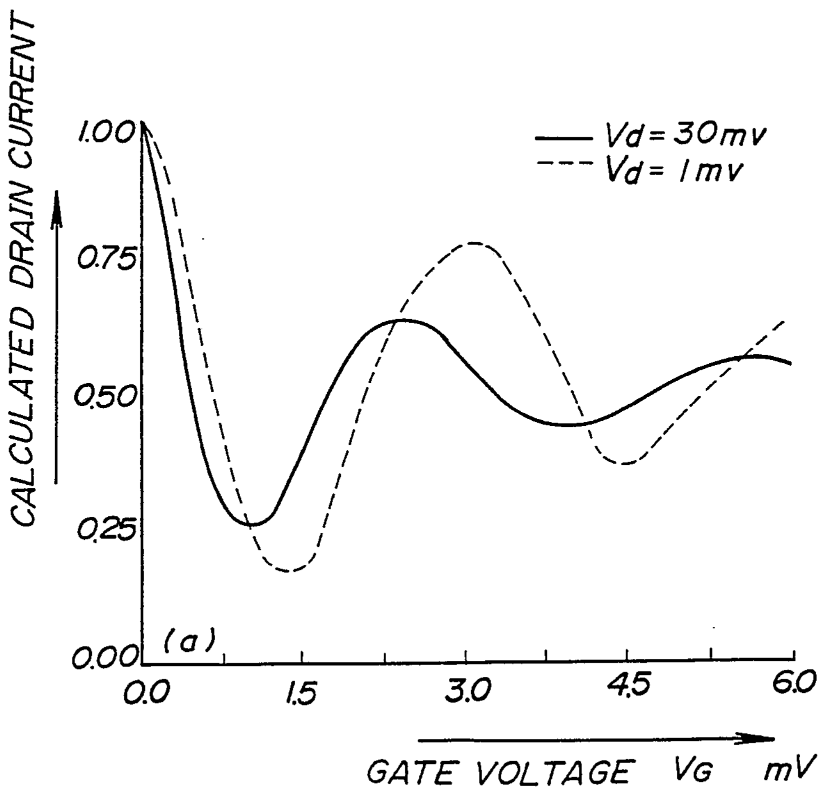

FIG.3 PRIOR ART

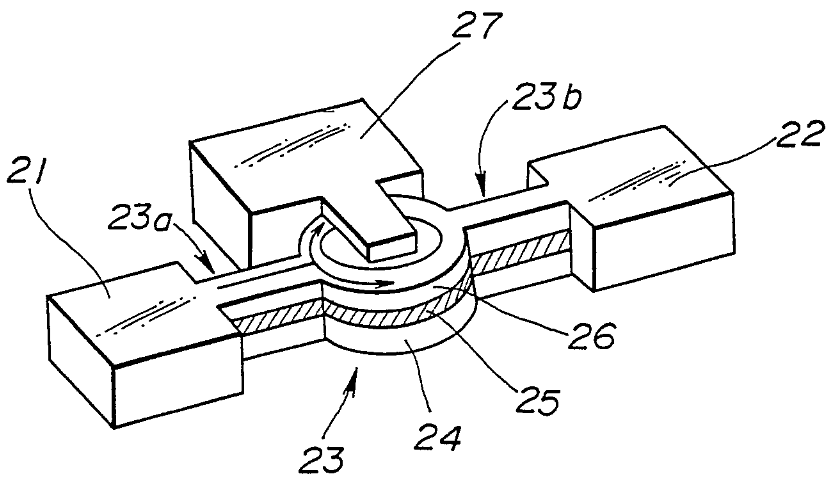


FIG.4 PRIOR ART

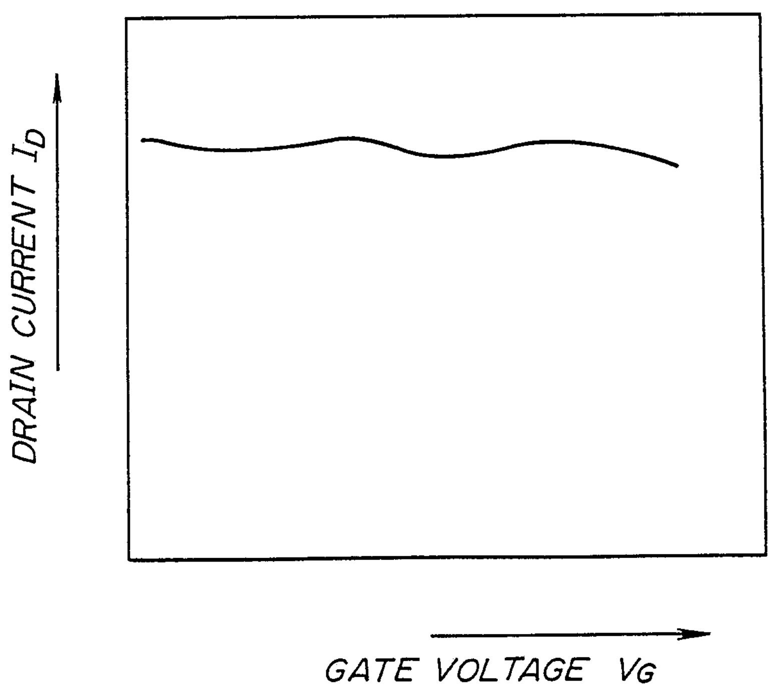

FIG. 5A

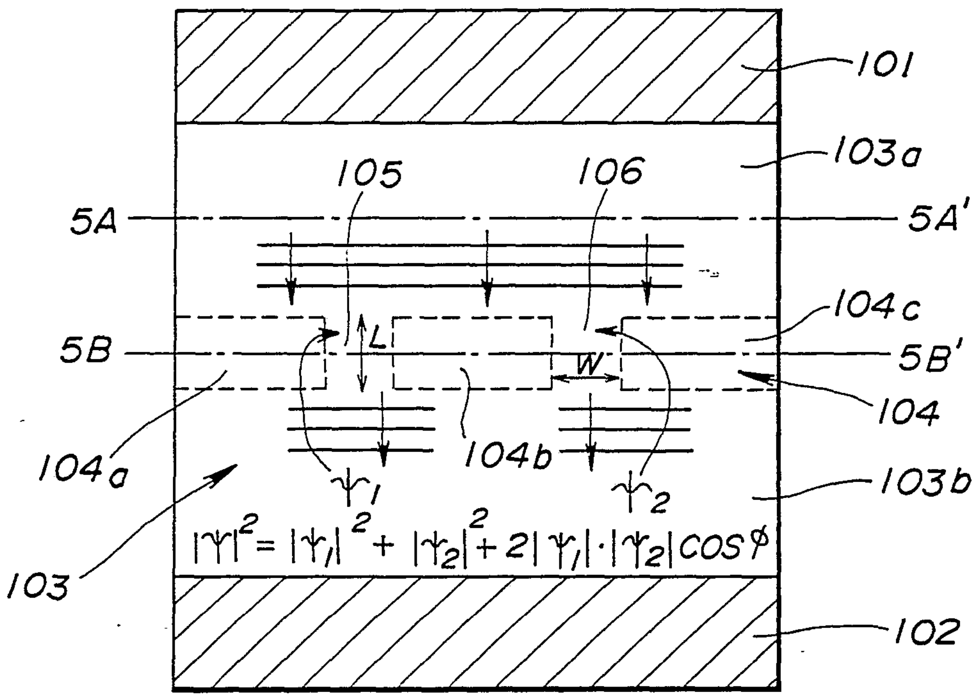
101
103a
105
106
5A
5A'
104c
L
5B
5B'
W
104
104a
104b
103b
ψ1
ψ2
103
|ψ|² = |ψ1|² + |ψ2|² + 2|ψ1|·|ψ2|cos φ
102

FIG.5B

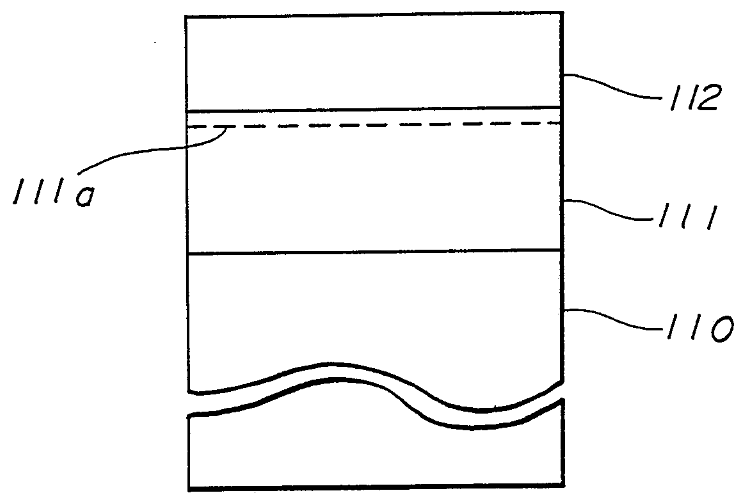


FIG.5C

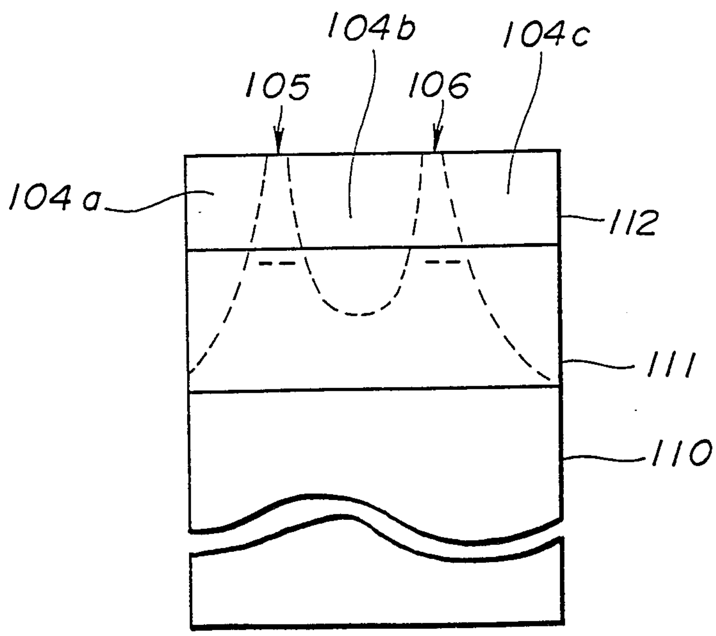

FIG. 6A

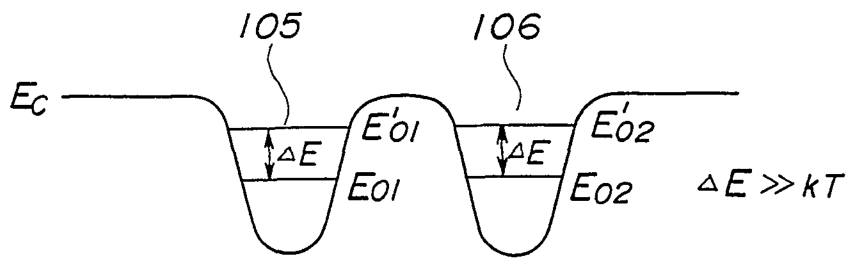


FIG. 6B

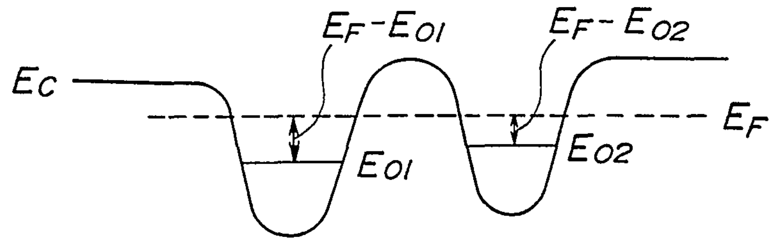


FIG. 7

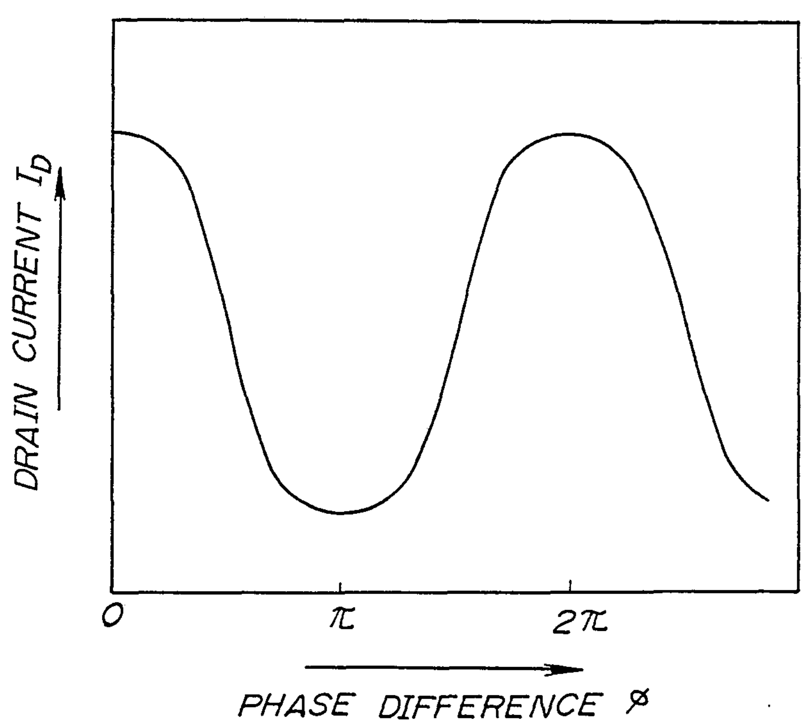

FIG. 8

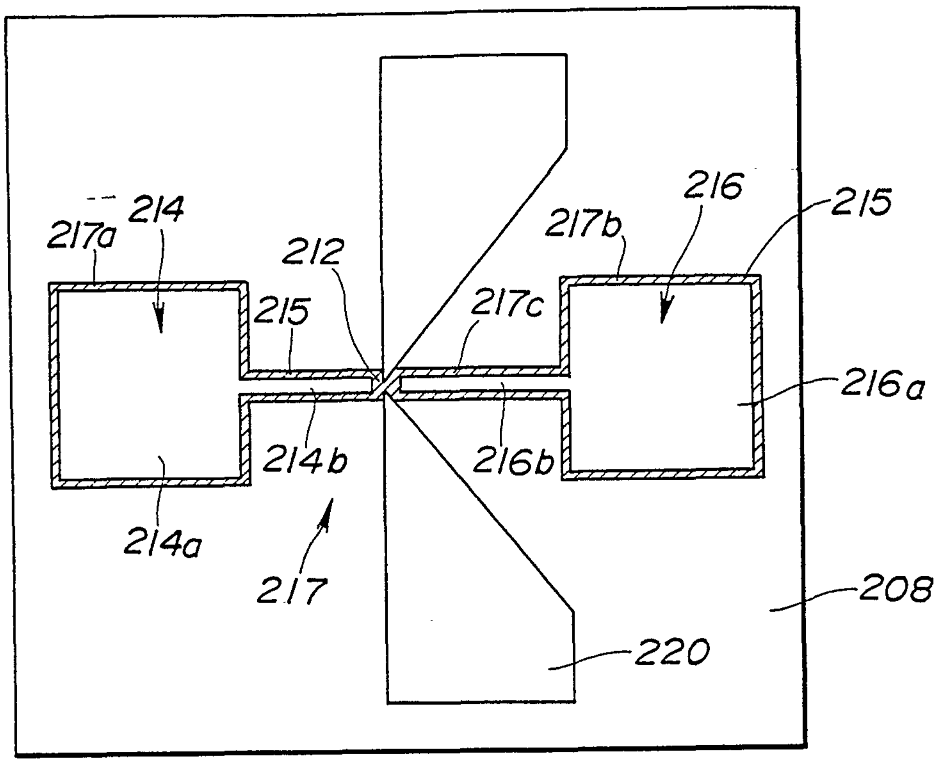
214
217a
212
215
216
215
217b
217c
216a
214b
216b
214a
217
208
220

FIG. 10

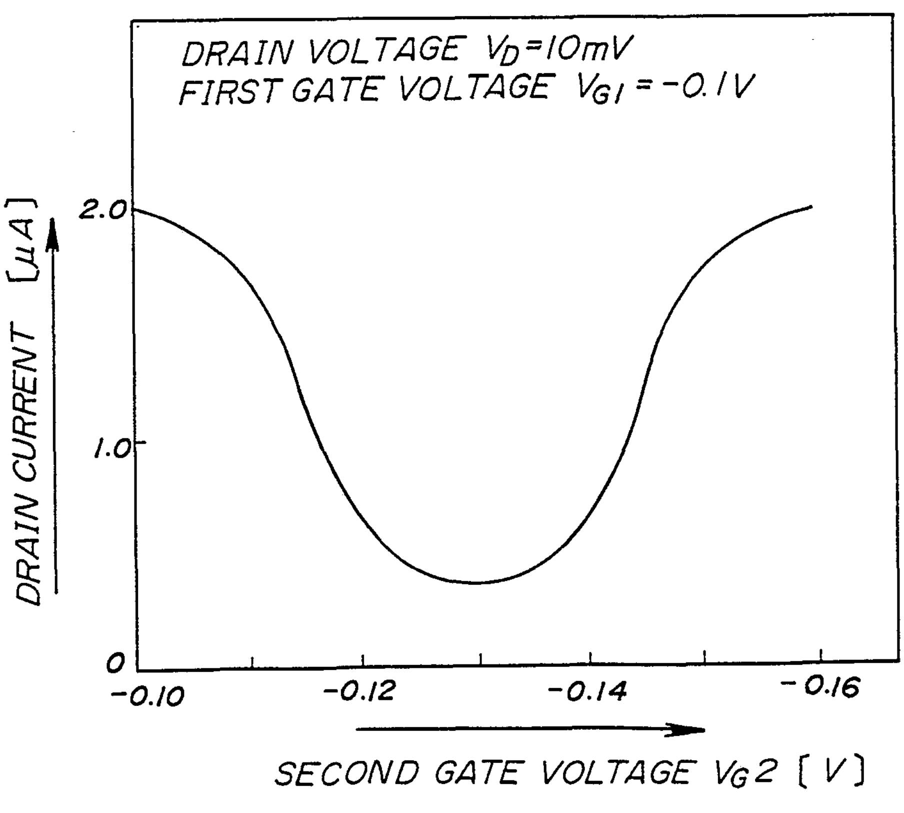
DRAIN VOLTAGE $V_D$=10mV
FIRST GATE VOLTAGE $V_{G1}$=-0.1V
DRAIN CURRENT [μA]
2.0
1.0
0
-0.10
-0.12
-0.14
-0.16
SECOND GATE VOLTAGE $V_G2$ [V]

FIG.9A

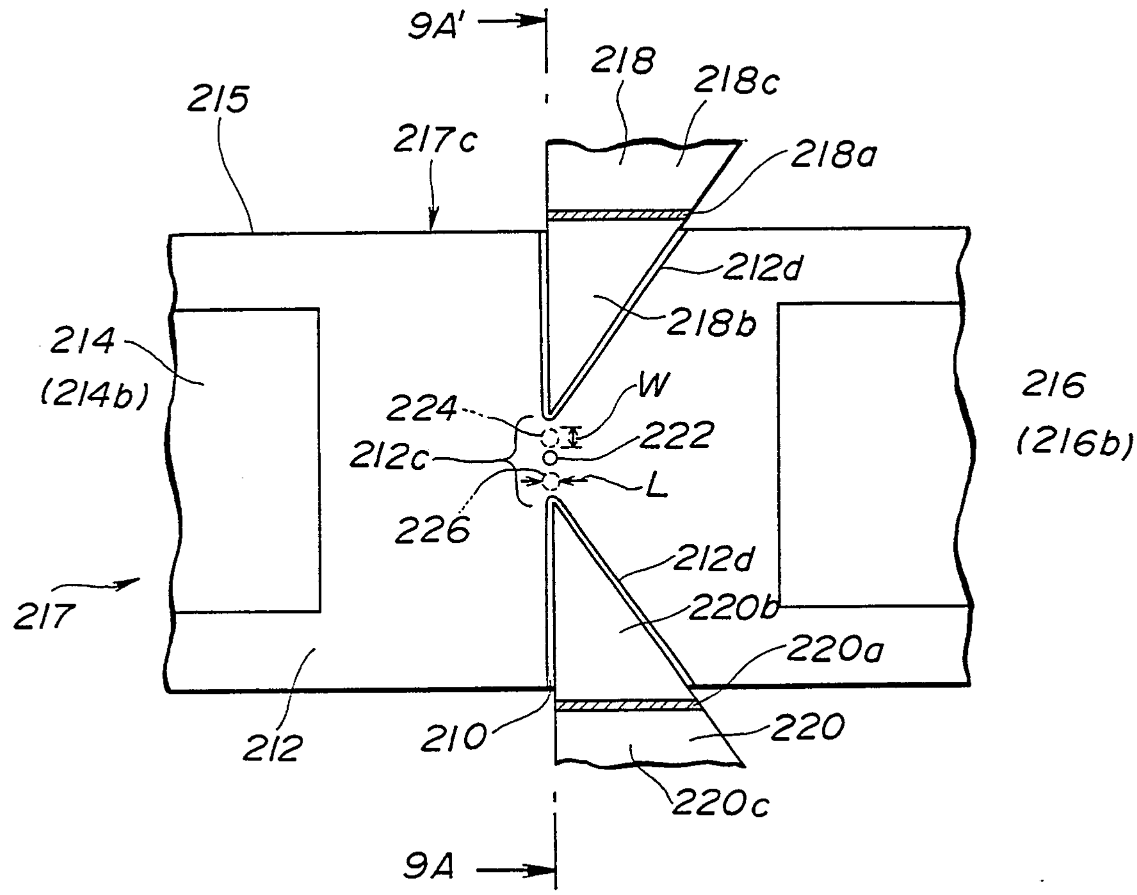
9A'
218
218c
215
217c
218a
212d
214
(214b)
218b
216
(216b)
W
224
222
212c
L
226
212d
217
220b
220a
212
210
220
220c
9A

FIG.9B

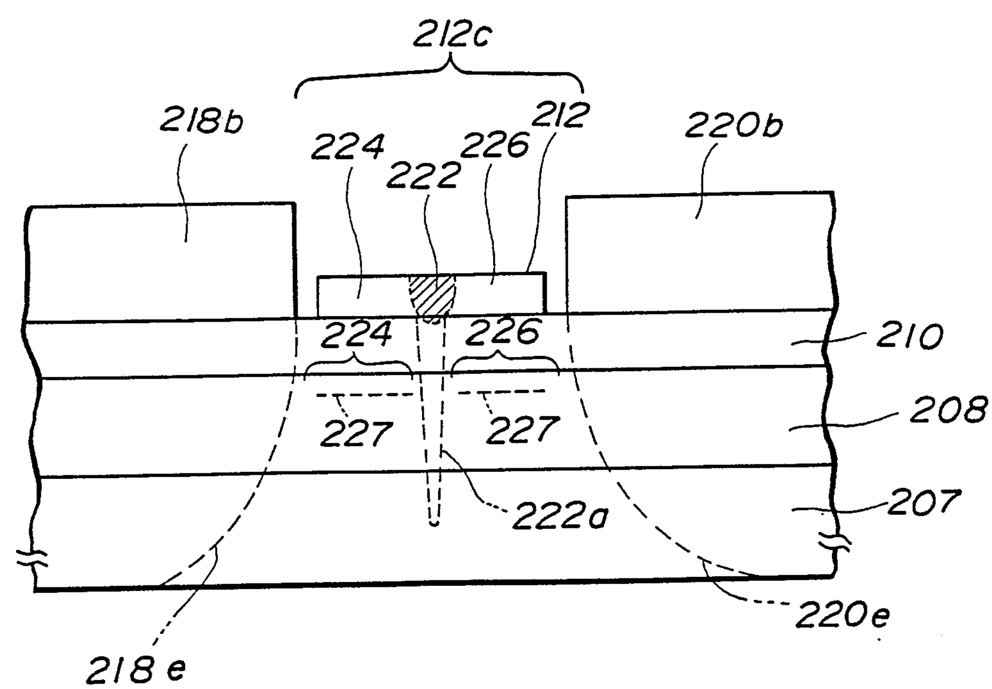
212c
218b
212
220b
224
226
222
224
226
210
208
227
227
222a
207
220e
218 e

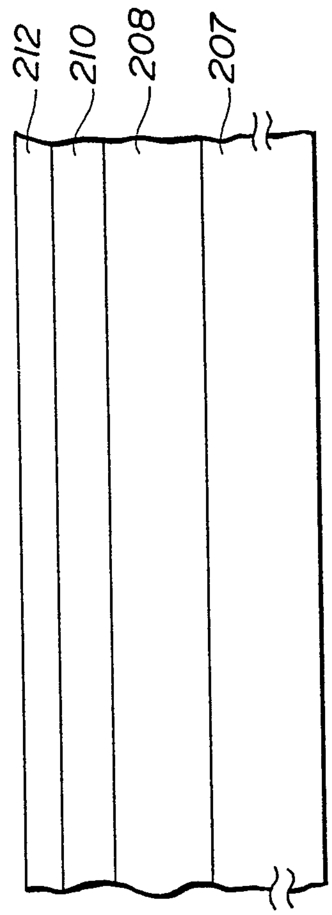


FIG.11A

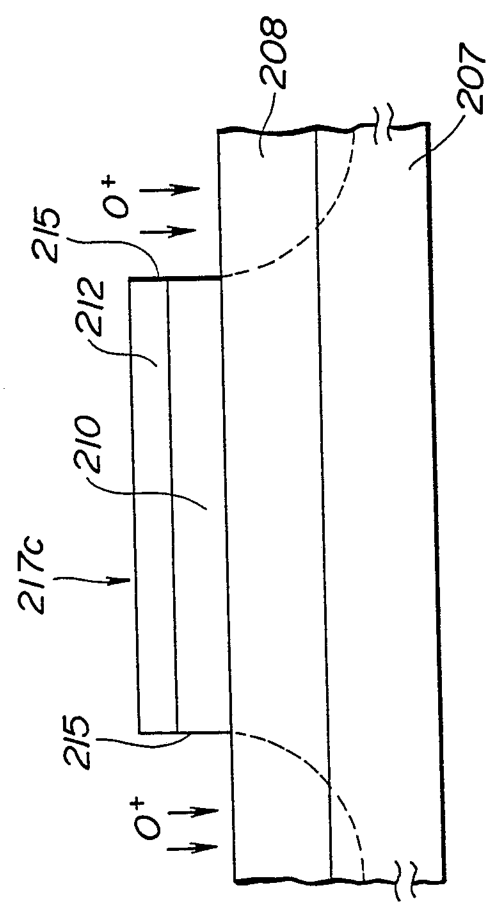


FIG.11B

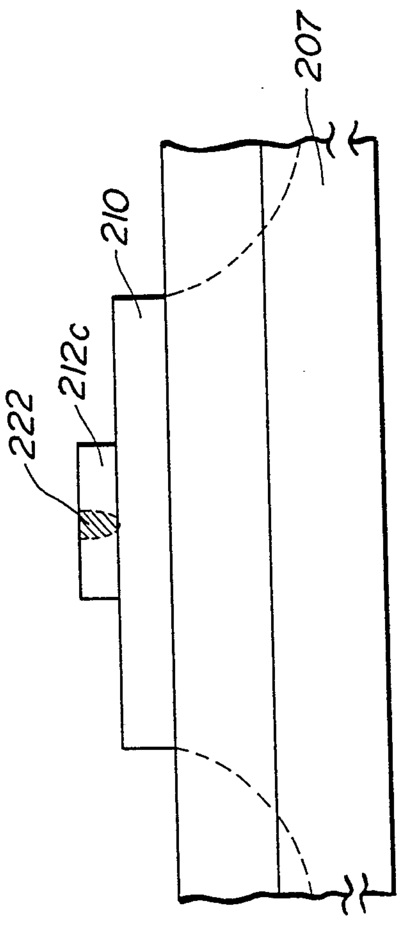


FIG.11C

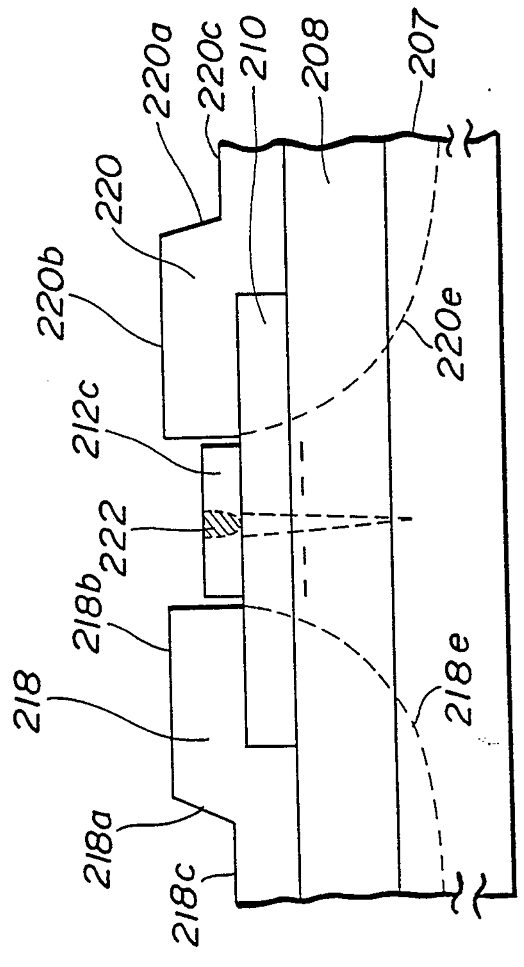


FIG.11D

FIG. 12A

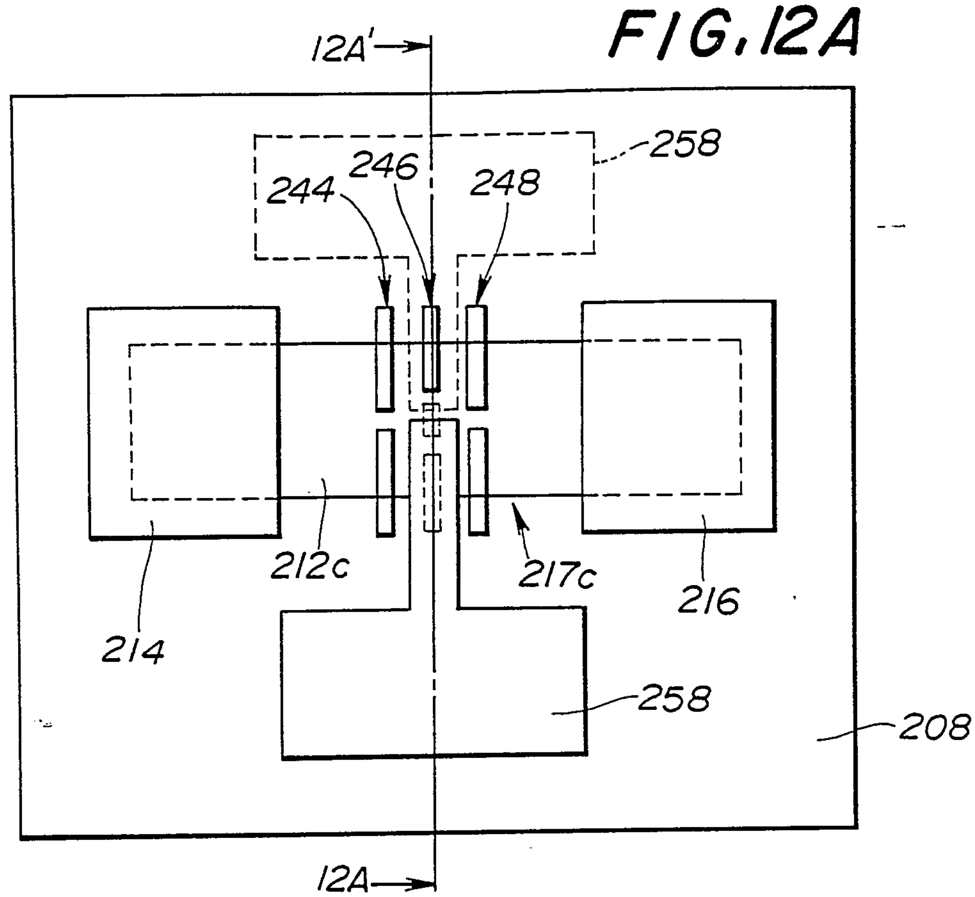


FIG. 12B

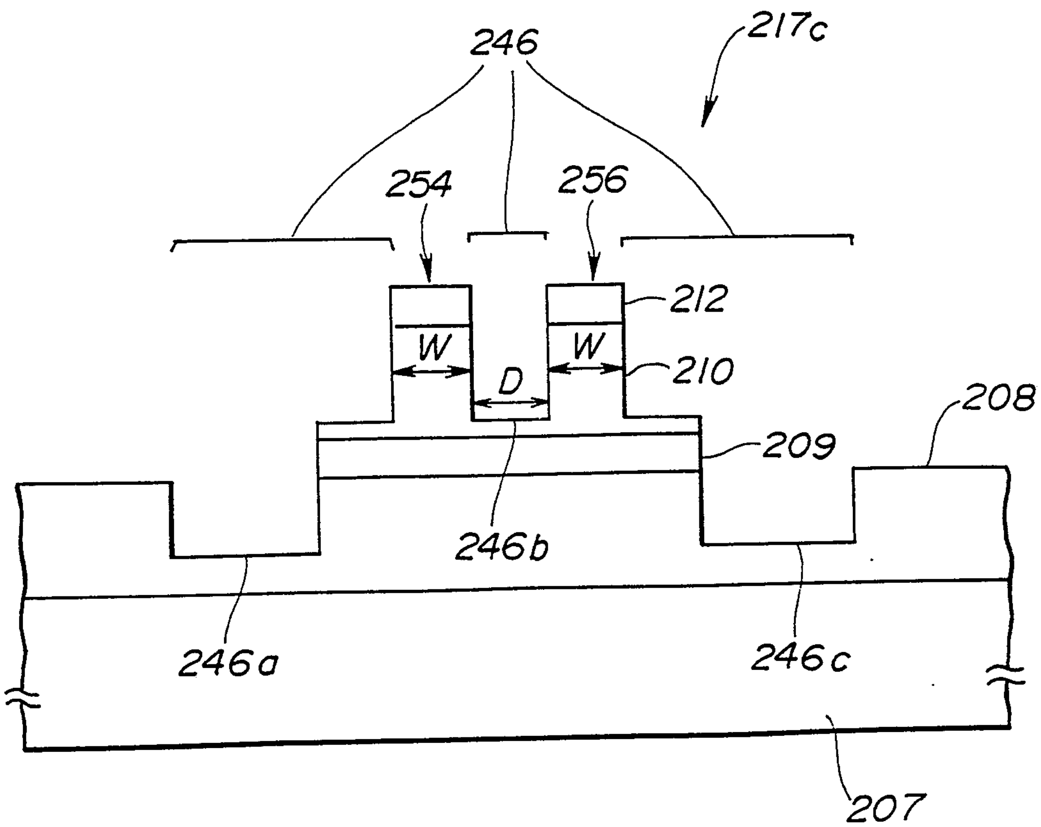

FIG.13A

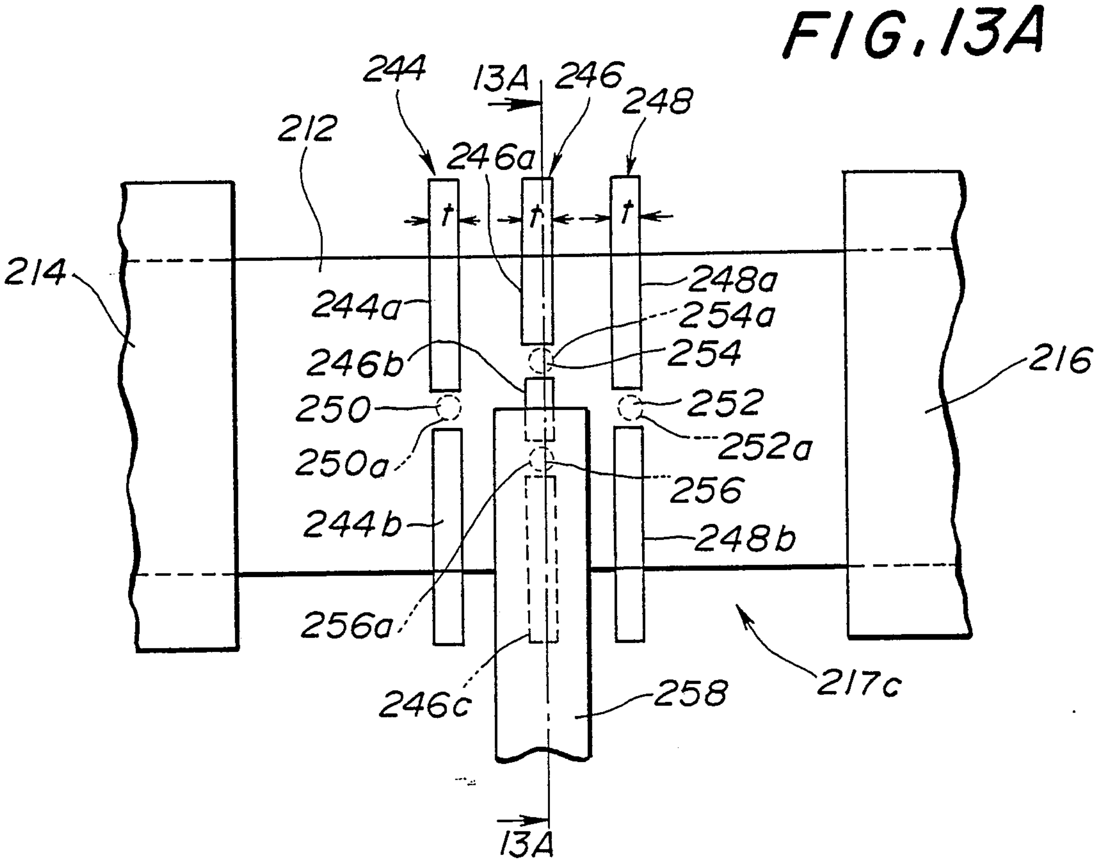


FIG.13B

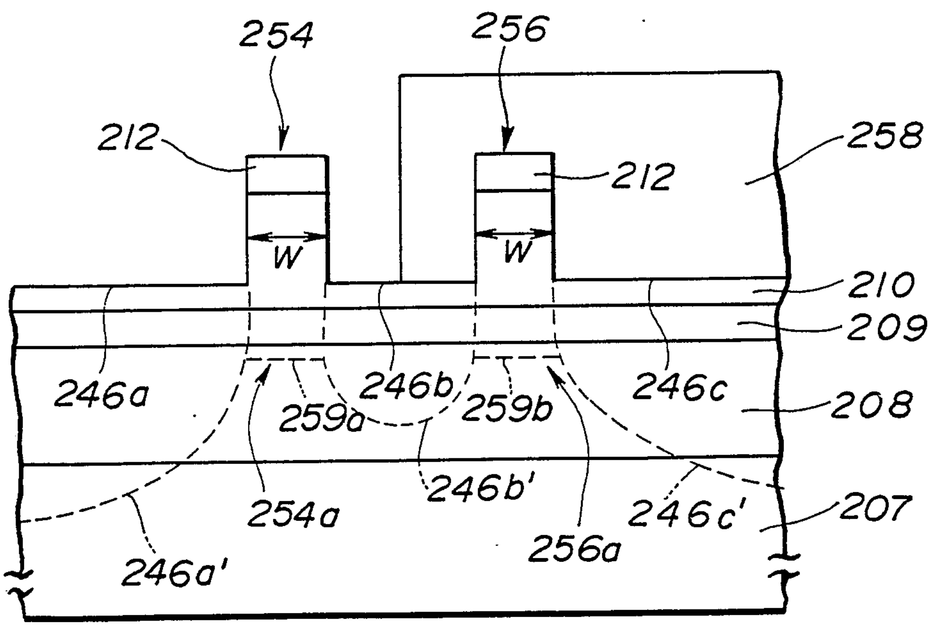

FIG. 14

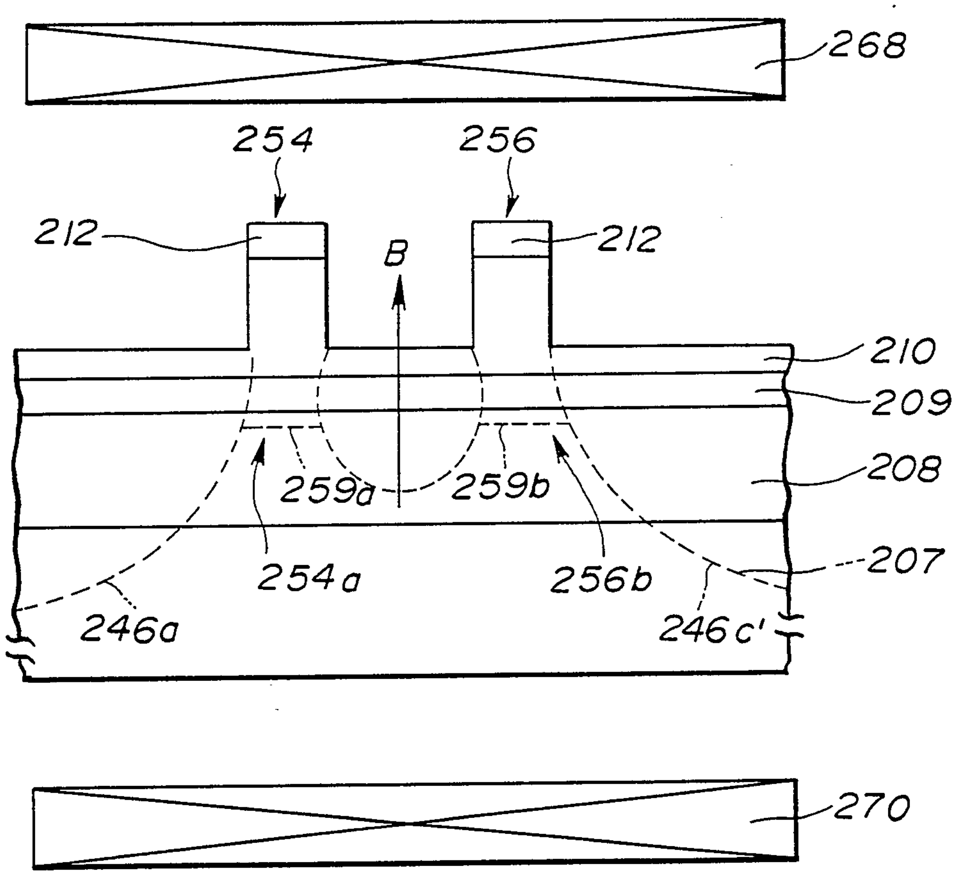
268
254
256
212
212
B
210
209
208
259a
259b
254a
256b
207
246a
246c'
270

FIG.15

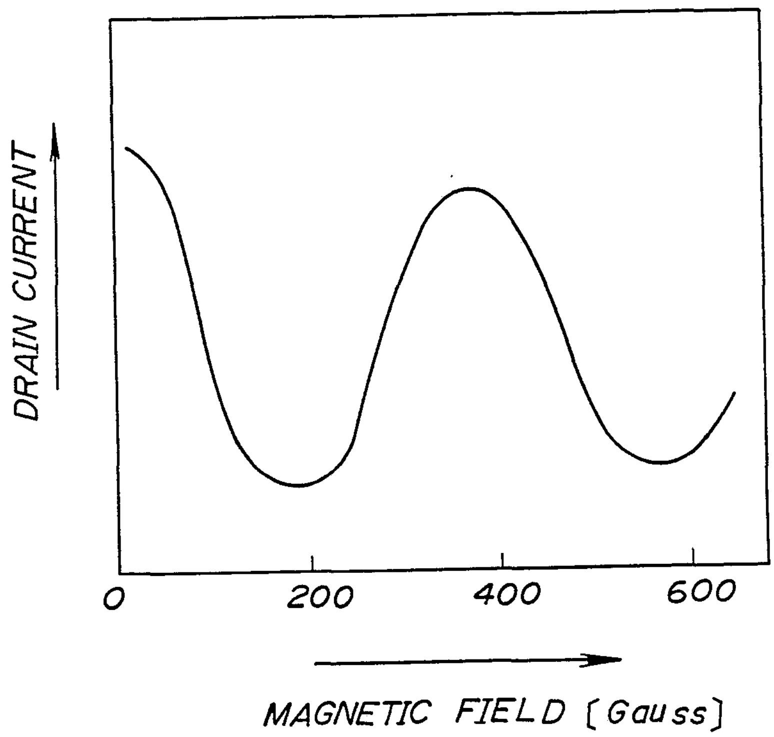

FIG. 16

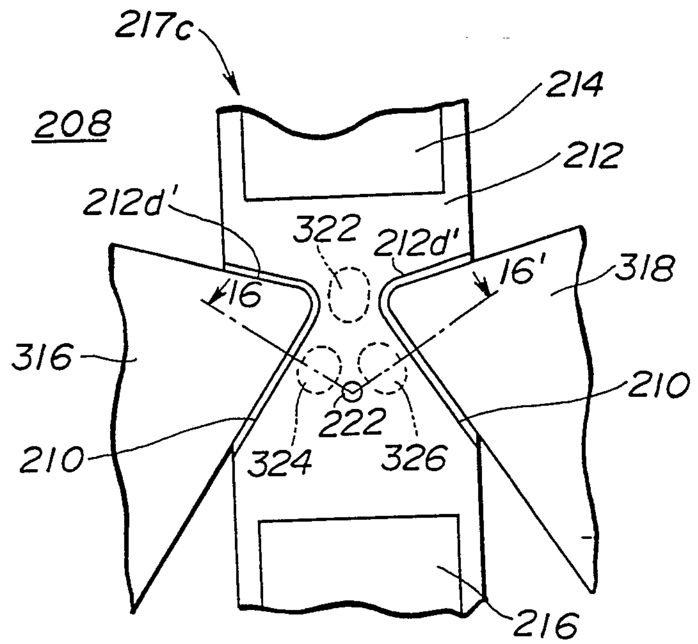
217c
214
208
212
212d'
322
212d'
318
16'
16
316
210
222
210
324
326
216

FIG. 17

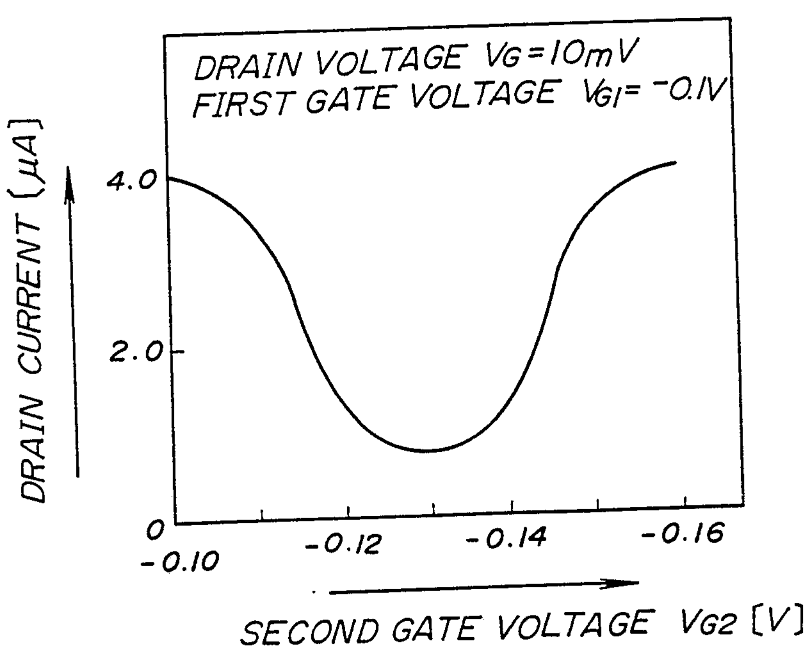
DRAIN VOLTAGE VG=10mV
FIRST GATE VOLTAGE VG1= -0.1V
DRAIN CURRENT [μA]
4.0
2.0
0
-0.10
-0.12
-0.14
-0.16
SECOND GATE VOLTAGE VG2 [V]

FIG.18

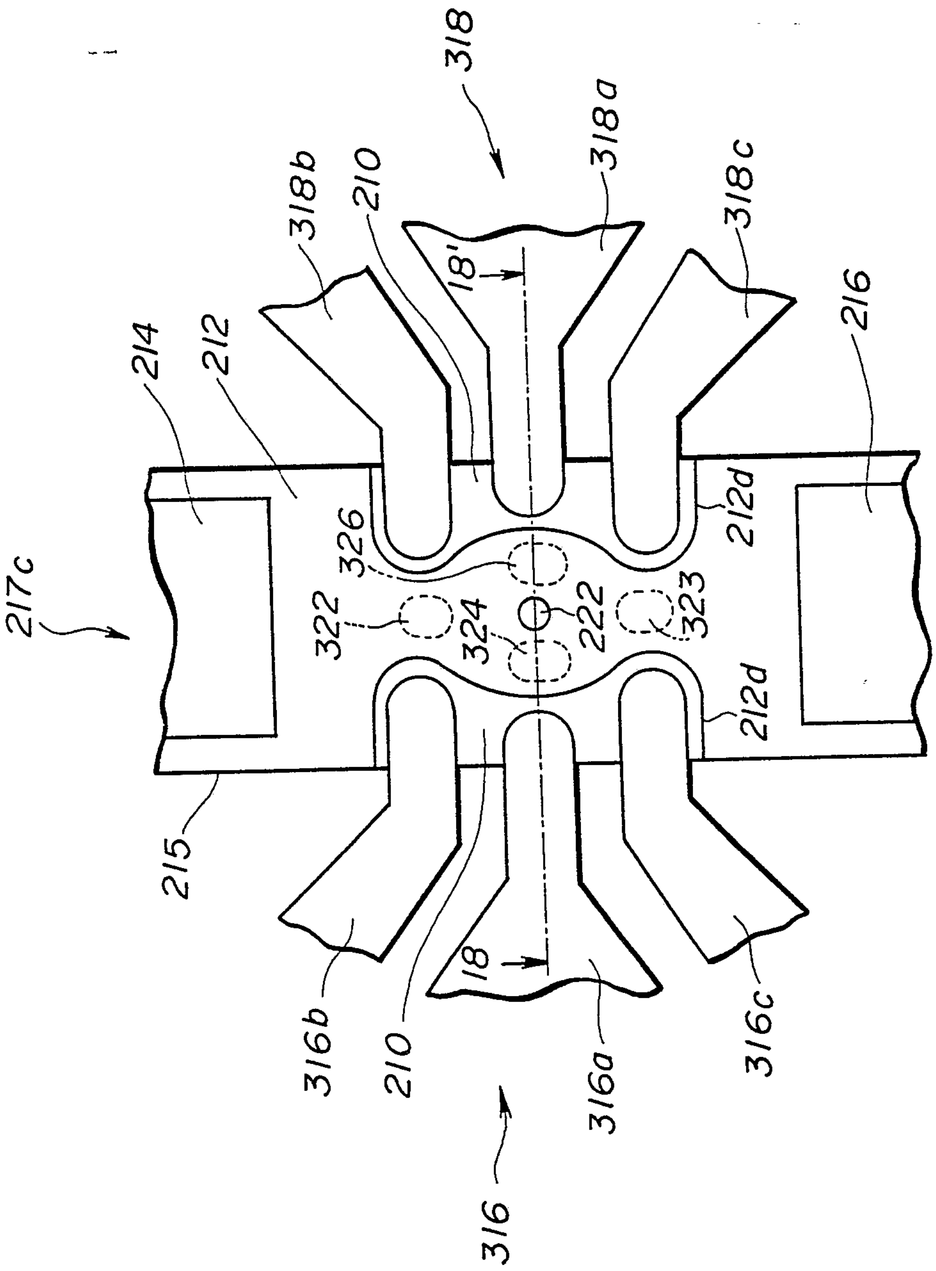
217c
214
212
215
318
318a
318b
318c
210
18'
216
212d
326
322
324
222
323
212d
210
18
316
316a
316b
316c

FIG. 19

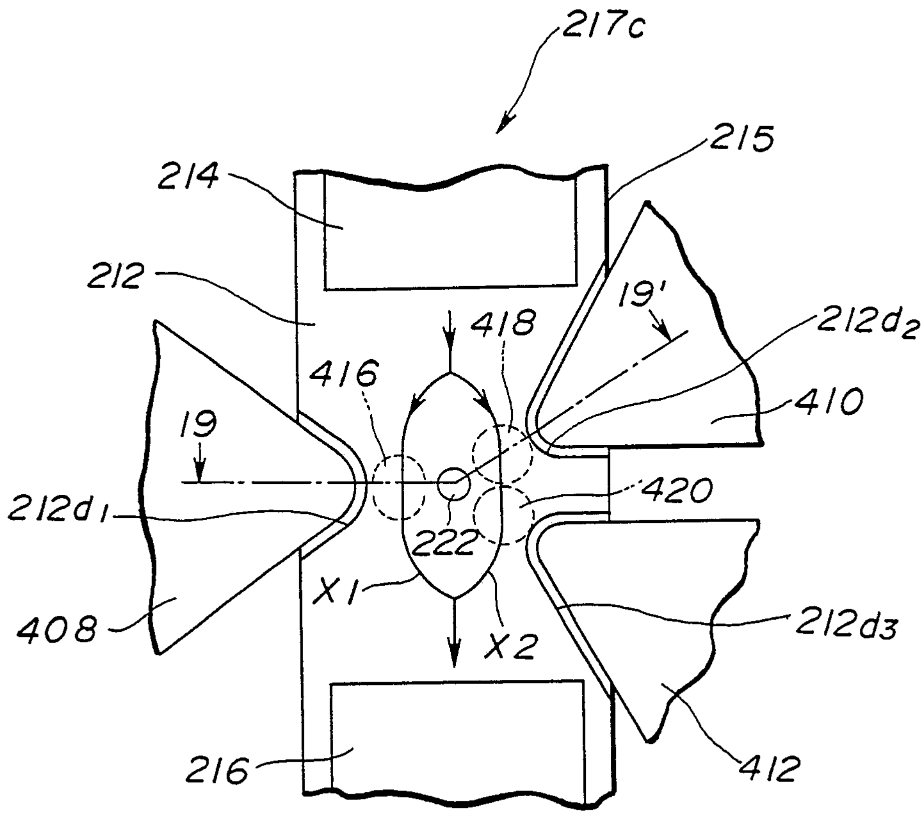
217c
215
214
212
19'
418
212d2
416
410
19
420
212d1
222
X1
408
X2
212d3
216
412

FIG. 20A

| GATE 410 | GATE 412 | PHASE DIFF ACROSS X1, X2 | OUTPUT STATE |
|---|---|---|---|
| 0 | 0 | 0 | 0 |
| 0 | 1 | $\pi$ | 1 |
| 1 | 0 | $\pi$ | 1 |
| 1 | 1 | $2\pi$ | 0 |

FIG. 20B

| GATE 410 | GATE 412 | PHASE DIFF ACROSS X1, X2 | OUTPUT STATE |
|---|---|---|---|
| 0 | 0 | 0 | 0 |
| 0 | 1 | $\pi/2$ | 1 |
| 1 | 0 | $\pi/2$ | 1 |
| 1 | 1 | $\pi$ | 1 |

FIG. 20C

| GATE 410 | GATE 412 | PHASE DIFF ACROSS X1, X2 | OUTPUT STATE |
|---|---|---|---|
| 0 | 0 | 0 | 0 |
| 0 | 1 | $\pi/2$ | 0 |
| 1 | 0 | $\pi/2$ | 0 |
| 1 | 1 | $\pi$ | 1 |

FIG. 21A

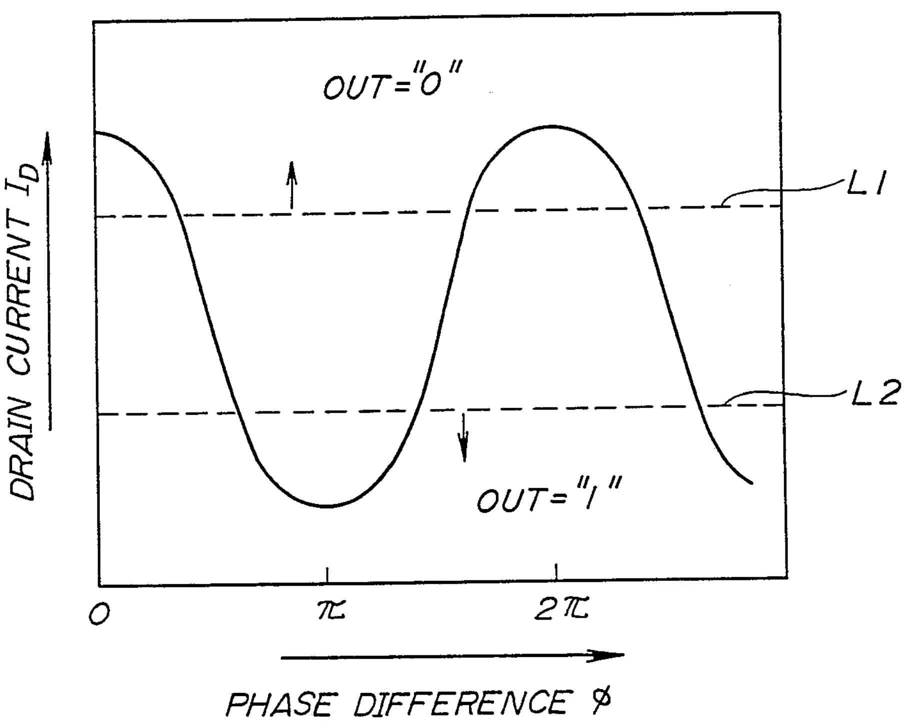

FIG. 21B

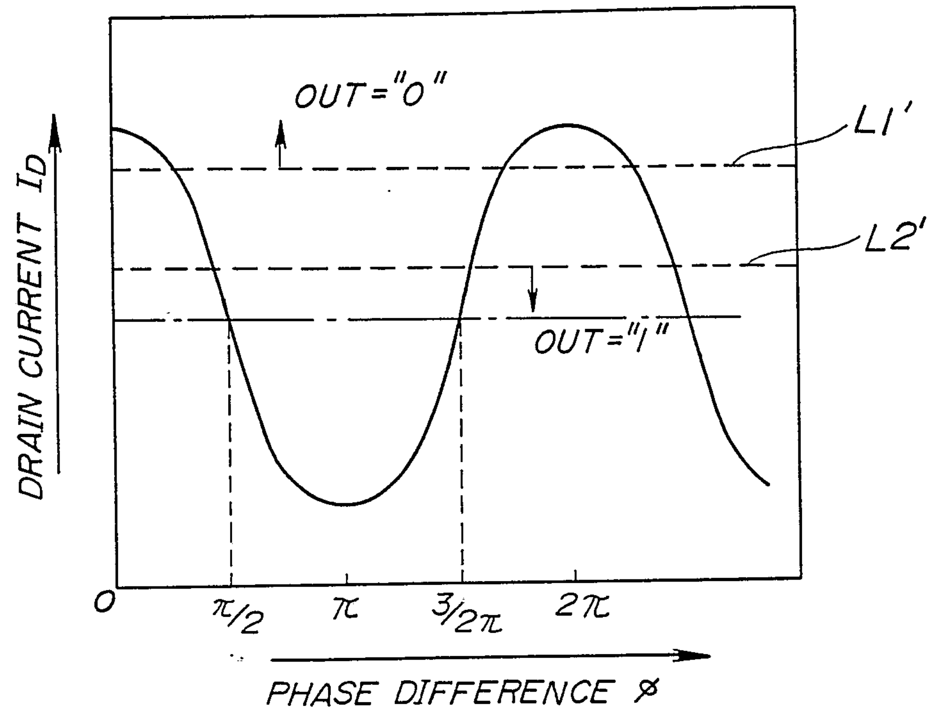


FIG. 21C

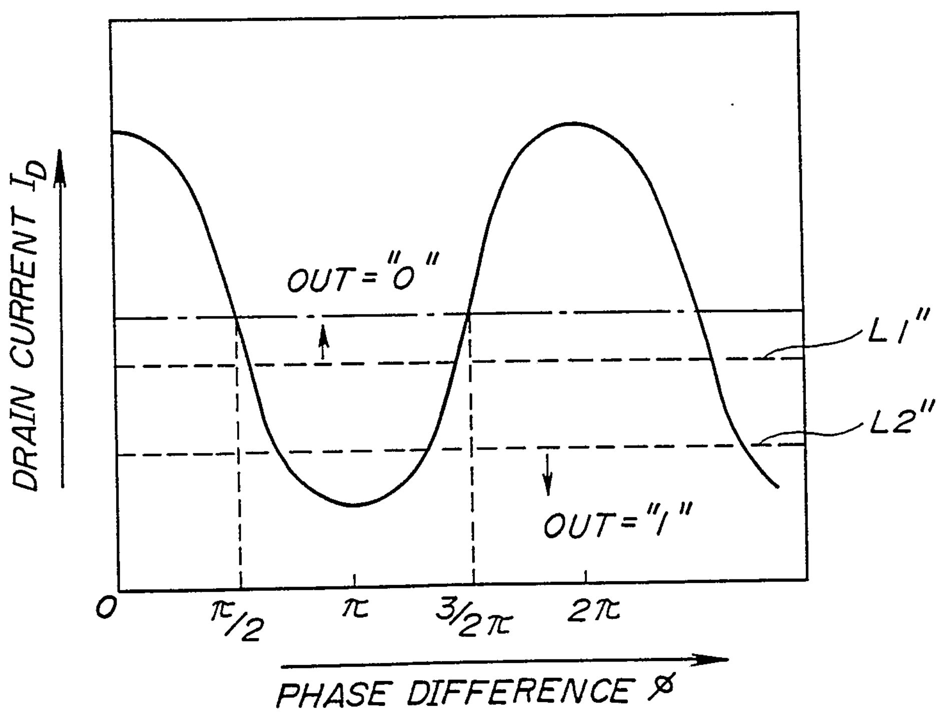

FIG.22

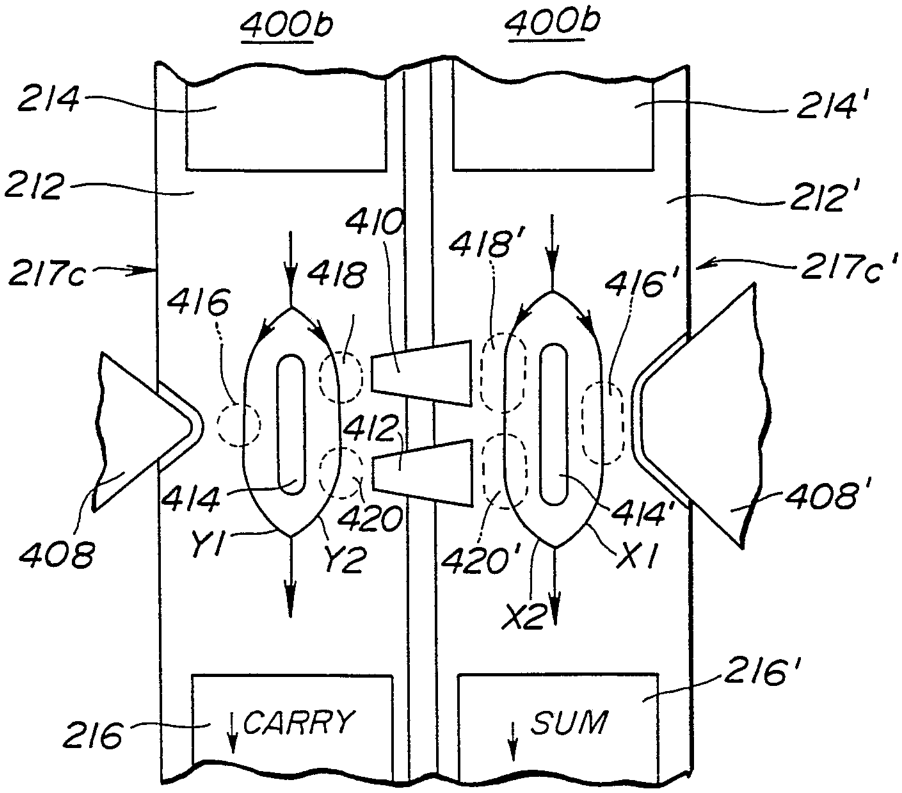


FIG.23

| GATE 410 | GATE 412 | PHASE DIFF ACROSS X1 , X2 | PHASE DIFF ACROSS Y1 , Y2 | SUM | CARRY |
|---|---|---|---|---|---|
| 0 | 0 | 0 | 0 | 0 | 0 |
| 0 | 1 | $\pi$ | $\pi/2$ | 1 | 0 |
| 1 | 0 | $\pi$ | $\pi/2$ | 1 | 0 |
| 1 | 1 | $2\pi$ | $\pi$ | 0 | 1 |

FIG.24

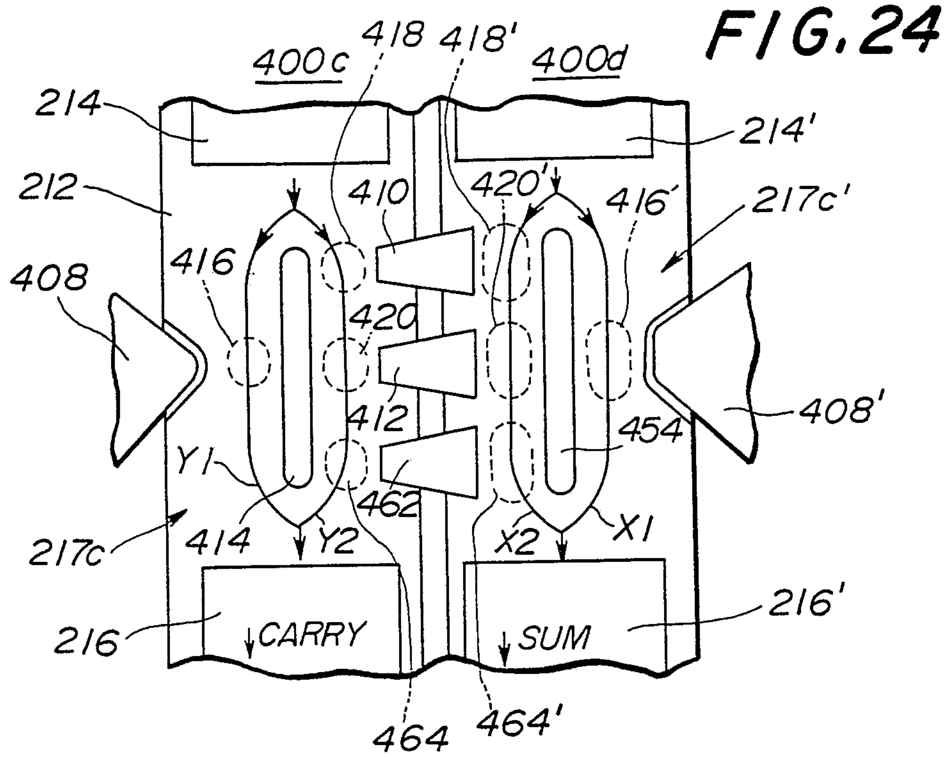


FIG.25

| GATE 410 | GATE 412 | GATE 462 | PHASE DIFF ACROSS X1 & X2 | PHASE DIFF ACROSS Y1 & Y2 | SUM OUT (400d) | CARRY OUT (400c) |
|---|---|---|---|---|---|---|
| 0 | 0 | 0 | 0 | 0 | 0 | 0 |
| 0 | 0 | 1 | $\pi$ | $\pi/3$ | 1 | 0 |
| 0 | 1 | 0 | $\pi$ | $\pi/3$ | 1 | 0 |
| 1 | 0 | 0 | $\pi$ | $\pi/3$ | 1 | 0 |
| 0 | 1 | 1 | $2\pi$ | $2\pi/3$ | 0 | 1 |
| 1 | 0 | 1 | $2\pi$ | $2\pi/3$ | 0 | 1 |
| 1 | 1 | 0 | $2\pi$ | $2\pi/3$ | 0 | 1 |
| 1 | 1 | 1 | $3\pi$ | $\pi$ | 1 | 1 |

FIG.26

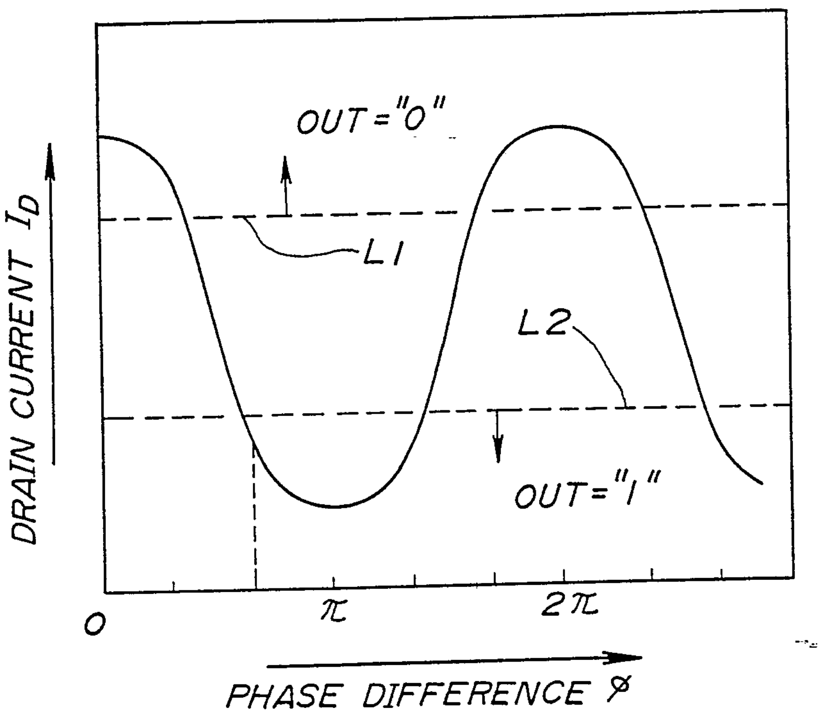
OUT="0"
L1
L2
OUT="1"
DRAIN CURRENT $I_D$
0
π
2π
PHASE DIFFERENCE φ

FIG.27

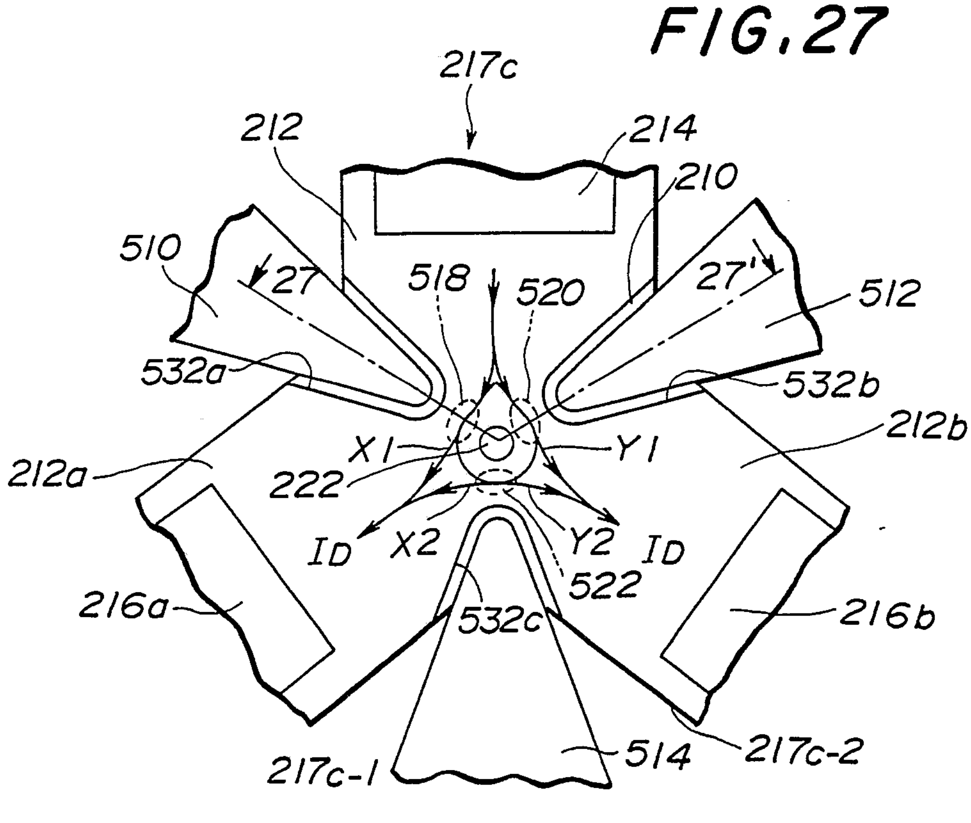
217c
212
214
210
510
27
518
520
27'
512
532a
532b
212b
X1
Y1
212a
222
ID
X2
Y2
ID
522
216a
532c
216b
217c-1
514
217c-2

FIG. 28A

| GATE 510 | GATE 512 | GATE 514 | PHASE DIFF X1, X2 | PHASE DIFF Y1, Y2 | DRAIN 216a OUT | DRAIN 216b OUT |
|---|---|---|---|---|---|---|
| 1 | 0 | 1 | 0 | π | 1($I_{DH}$) | 0($I_{DL}$) |
| 0 | 1 | 1 | π | 0 | 0($I_{DL}$) | 1($I_{DH}$) |

FIG. 28B

| GATE 510 bias | GATE 512 bias | GATE 514 | PHASE DIFF X1, X2 | PHASE DIFF Y1, Y2 | DRAIN 216a OUT | DRAIN 216b OUT |
|---|---|---|---|---|---|---|
| $V_G$ | 0 | 1 | π | 0 | 0 | 1 |
| $V_G$ | 0 | 0 | 0 | π | 1 | 0 |

FIG.29

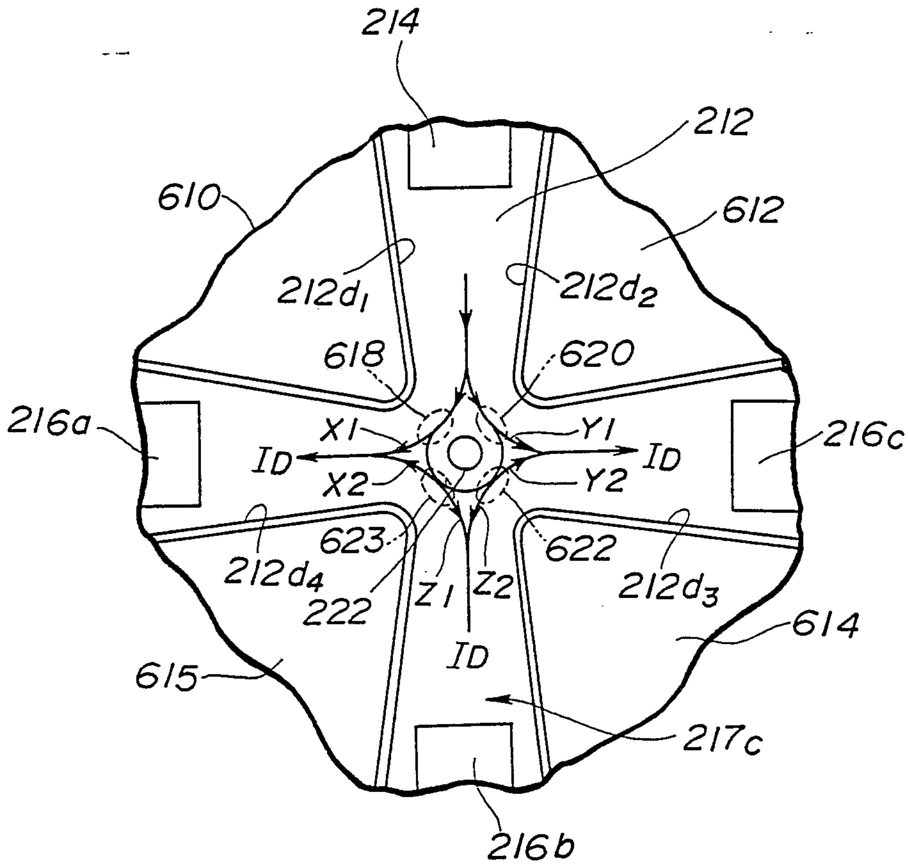


FIG.30

| GATE | | | | PHASE DIFF | | | DRAIN OUT | | |
|---|---|---|---|---|---|---|---|---|---|
| 610 | 612 | 614 | 615 | X1,X2 | Y1,Y2 | Z1,Z2 | 216a | 216c | 216b |
| 1 | 0 | 0 | 1 | 0 | π | π | 1($I_{DH}$) | 0($I_{DL}$) | 0($I_{DL}$) |
| 0 | 1 | 1 | 0 | π | 0 | π | 0($I_{DL}$) | 1($I_{DH}$) | 0($I_{DL}$) |
| 0 | 0 | 1 | 1 | π | π | 0 | 0($I_{DL}$) | 0($I_{DL}$) | 1($I_{DL}$) |

FIG. 31

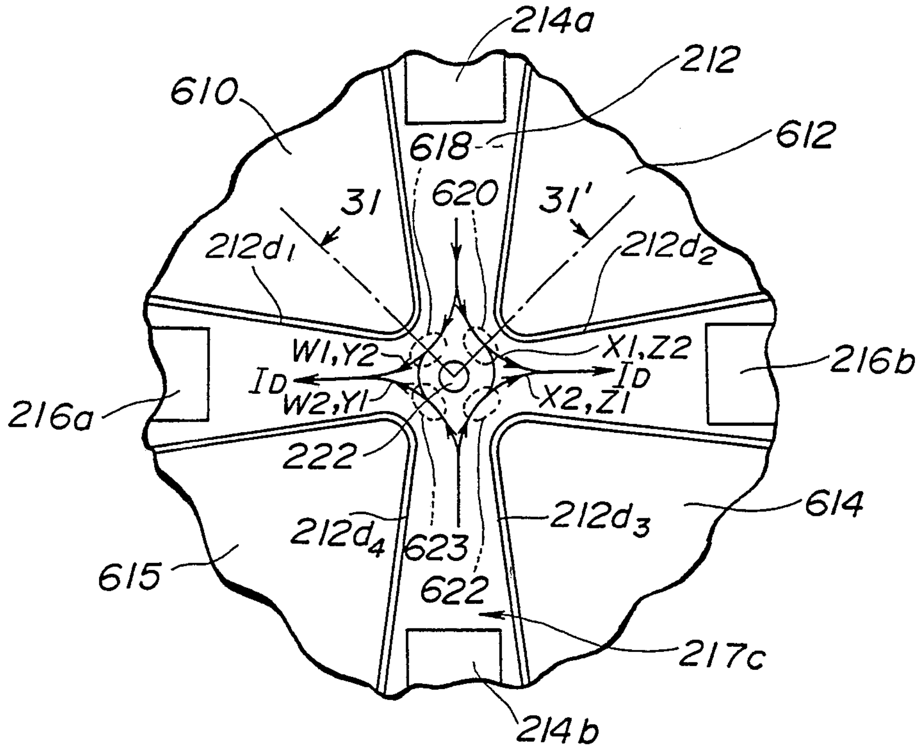


FIG. 32

| GATE | | | | PHASE DIFF | | | | 214a to 216a | 214a to 216b | 214b to 216a | 214b to 216b |
|---|---|---|---|---|---|---|---|---|---|---|---|
| 610 | 612 | 614 | 615 | W1, W2 | X1, X2 | Y1, Y2 | Z1, Z2 | | | | |
| 1 | 0 | 1 | 0 | 0 | π | π | 0 | 1($I_{DH}$) | 0($I_{DL}$) | 0($I_{DL}$) | 1($I_{DH}$) |
| 0 | 1 | 0 | 1 | π | 0 | 0 | π | 0($I_{DL}$) | 1($I_{DH}$) | 1($I_{DH}$) | 0($I_{DL}$) |

FIG.33A

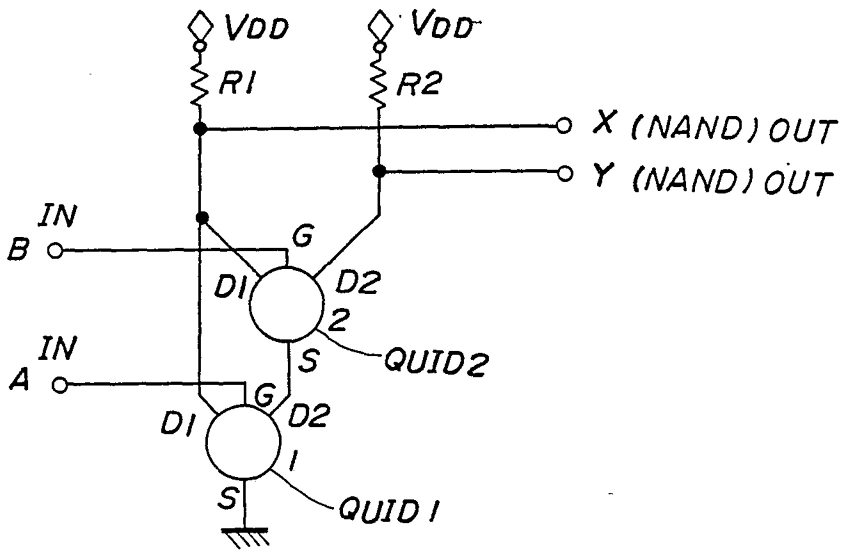


FIG.33B

| A | B | X | Y |
|---|---|---|---|
| 0 | 0 | 1 | 0 |
| 0 | 1 | 1 | 0 |
| 1 | 0 | 1 | 0 |
| 1 | 1 | 0 | 1 |

FIG.34A

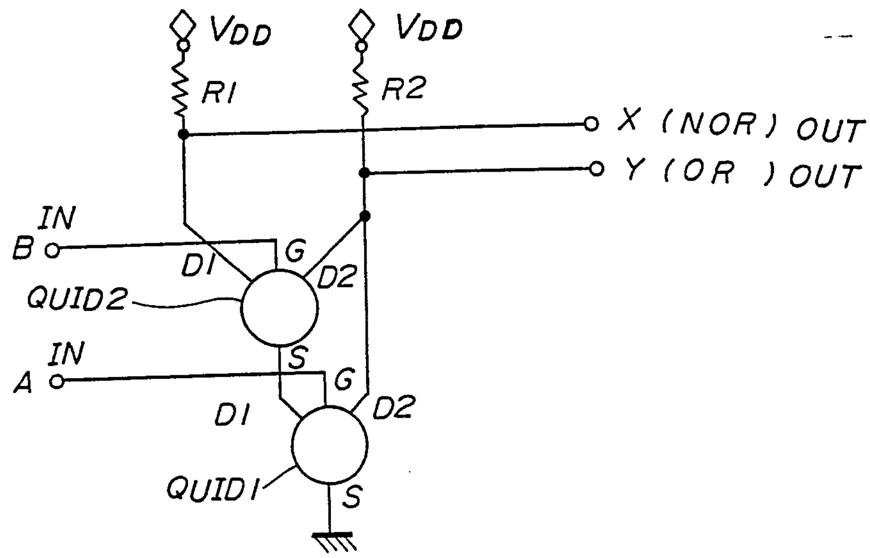


FIG.34B

| A | B | X | Y |
|---|---|---|---|
| 0 | 0 | 1 | 0 |
| 0 | 0 | 0 | 1 |
| 1 | 0 | 0 | 1 |
| 1 | 1 | 0 | 1 |

FIG.35

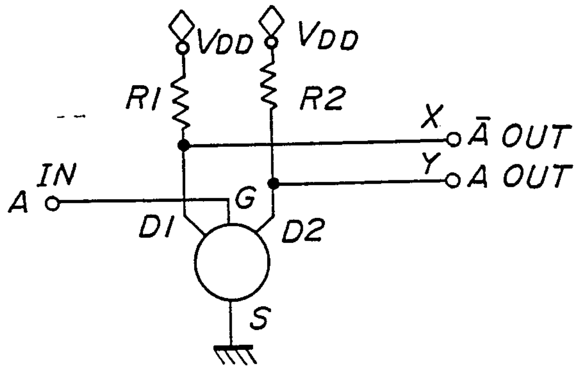


FIG.36A

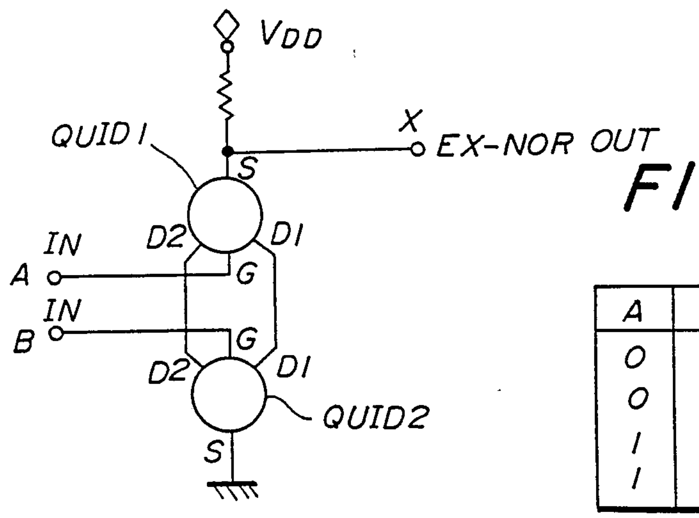


FIG.36B

| A | B | OUT |
|---|---|---|
| 0 | 0 | 1 |
| 0 | 1 | 0 |
| 1 | 0 | 0 |
| 1 | 1 | 1 |

FIG.37A

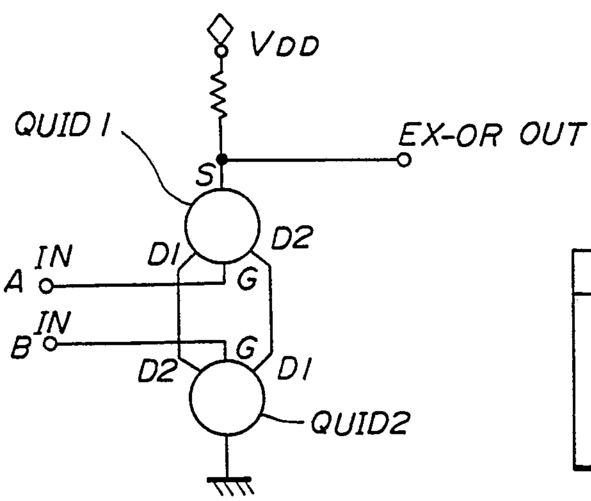


FIG.37B

| A | B | OUT |
|---|---|---|
| 0 | 0 | 0 |
| 0 | 1 | 1 |
| 1 | 0 | 1 |
| 1 | 1 | 0 |

FIG. 38A

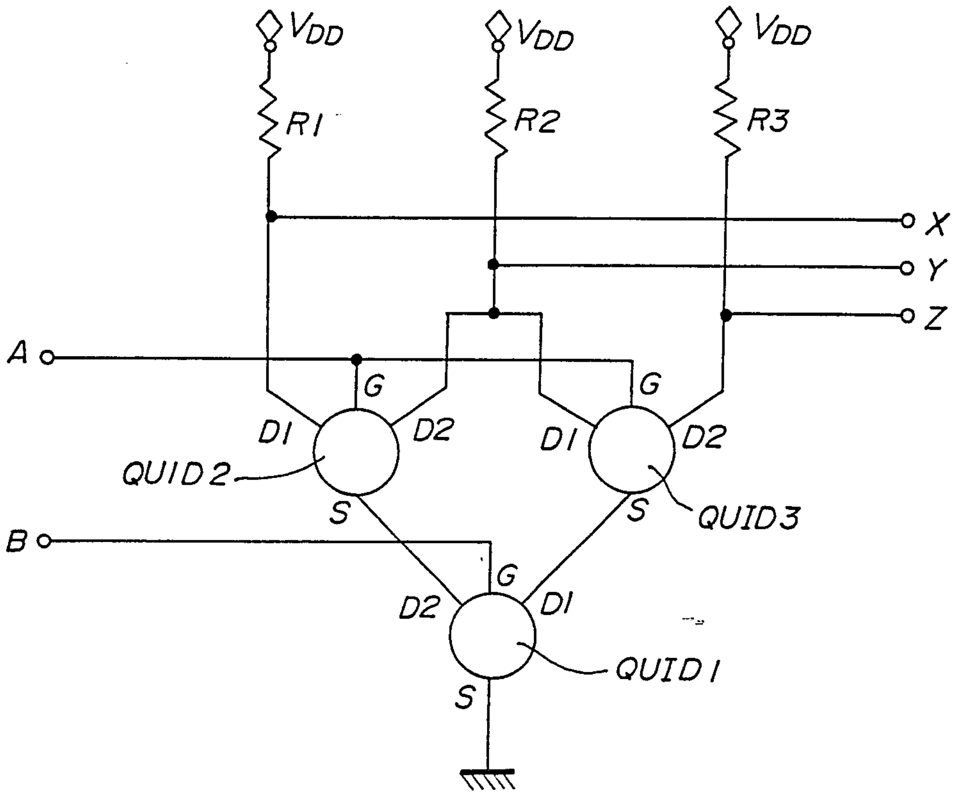


FIG. 38B

| IN | | OUT | | |
|---|---|---|---|---|
| A | B | X | Y | Z |
| 0 | 0 | 0 | 1 | 0 |
| 0 | 1 | 0 | 0 | 1 |
| 1 | 0 | 1 | 0 | 0 |
| 1 | 1 | 0 | 1 | 0 |

FIG.39A

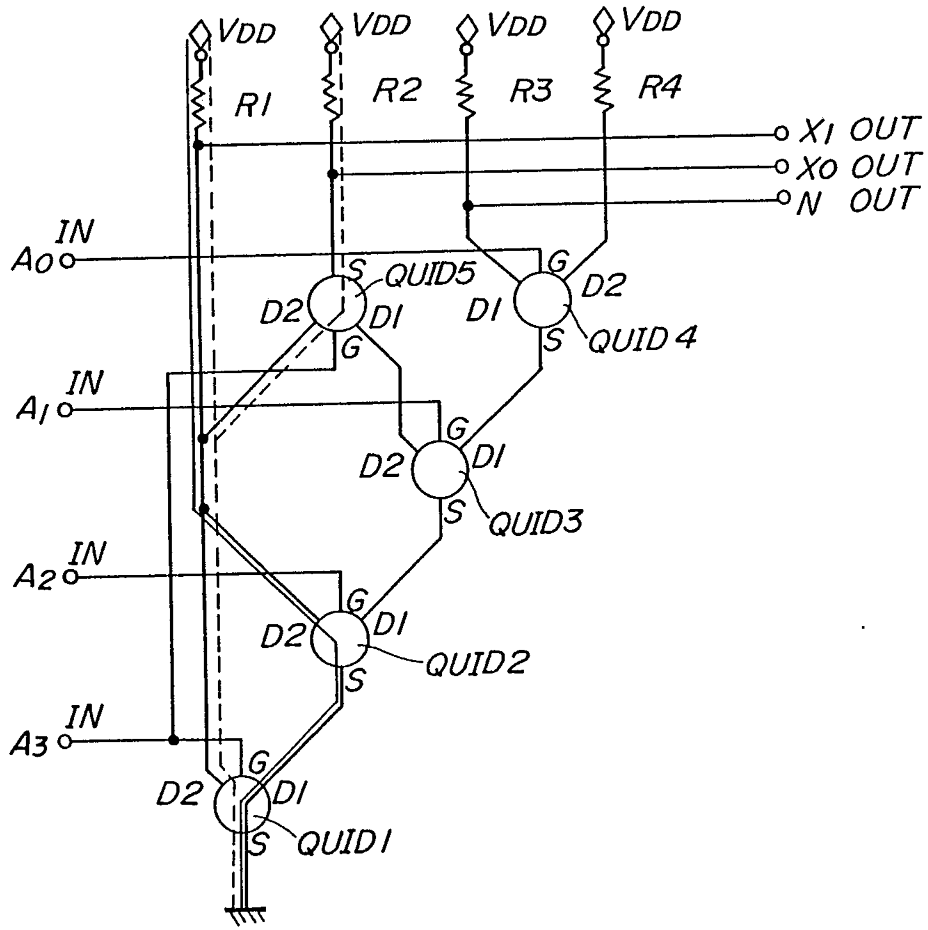


FIG.39B

| IN | | | | OUT | | |
|---|---|---|---|---|---|---|
| A3 | A2 | A1 | A0 | X1 | X0 | N |
| 0 | 0 | 0 | 0 | 0 | 0 | 1 |
| 0 | 0 | 0 | 1 | 0 | 0 | 0 |
| 0 | 0 | 1 | 0 | 0 | 1 | 0 |
| 0 | 0 | 1 | 1 | 0 | 1 | 0 |
| 0 | 1 | 0 | 0 | 1 | 0 | 0 |
| 0 | 1 | 0 | 1 | 1 | 0 | 0 |
| 0 | 1 | 1 | 0 | 1 | 0 | 0 |
| 0 | 1 | 1 | 1 | 1 | 0 | 0 |
| 1 | 0 | 0 | 0 | 1 | 1 | 0 |
| 1 | 0 | 0 | 1 | 1 | 1 | 0 |
| 1 | 0 | 1 | 0 | 1 | 1 | 0 |
| 1 | 0 | 1 | 1 | 1 | 1 | 0 |
| 1 | 1 | 0 | 0 | 1 | 1 | 0 |
| 1 | 1 | 0 | 1 | 1 | 1 | 0 |
| 1 | 1 | 1 | 0 | 1 | 1 | 0 |
| 1 | 1 | 1 | 1 | 1 | 1 | 0 |

FIG. 40A

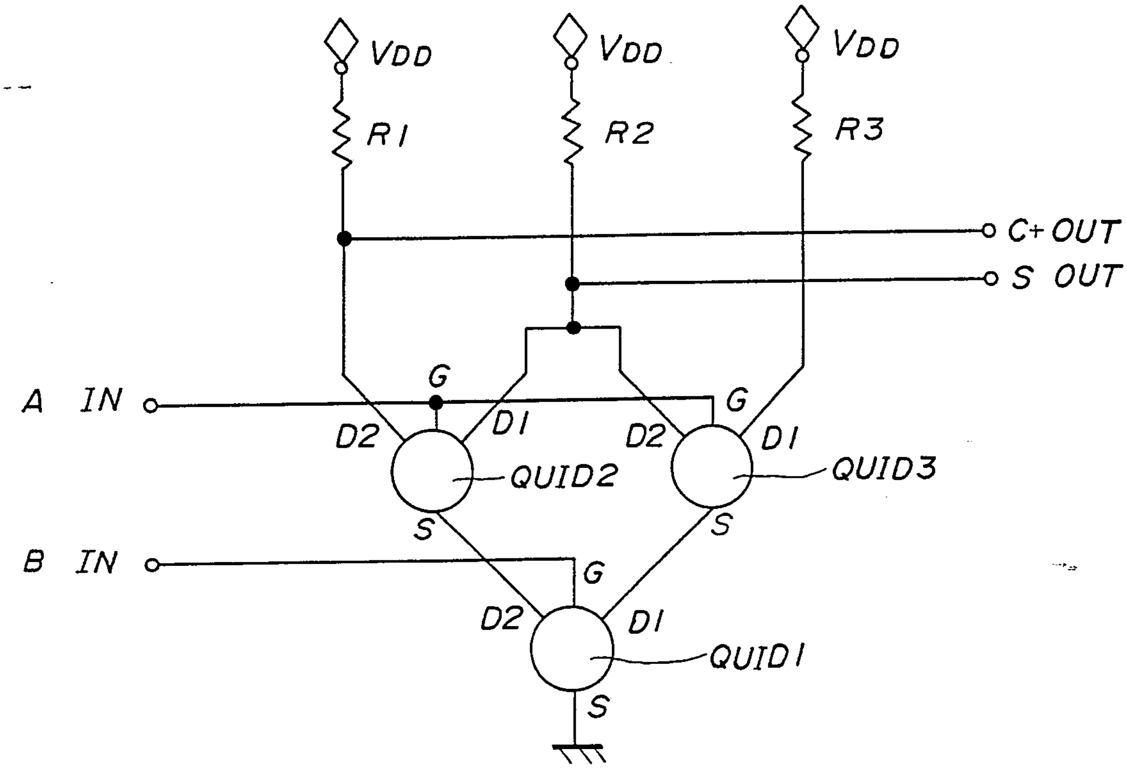


FIG. 40B

| IN | | OUT | |
|---|---|---|---|
| A | B | S | C+ |
| 0 | 0 | 0 | 0 |
| 0 | 1 | 1 | 0 |
| 1 | 1 | 0 | 1 |
| 1 | 0 | 1 | 0 |

FIG.41A

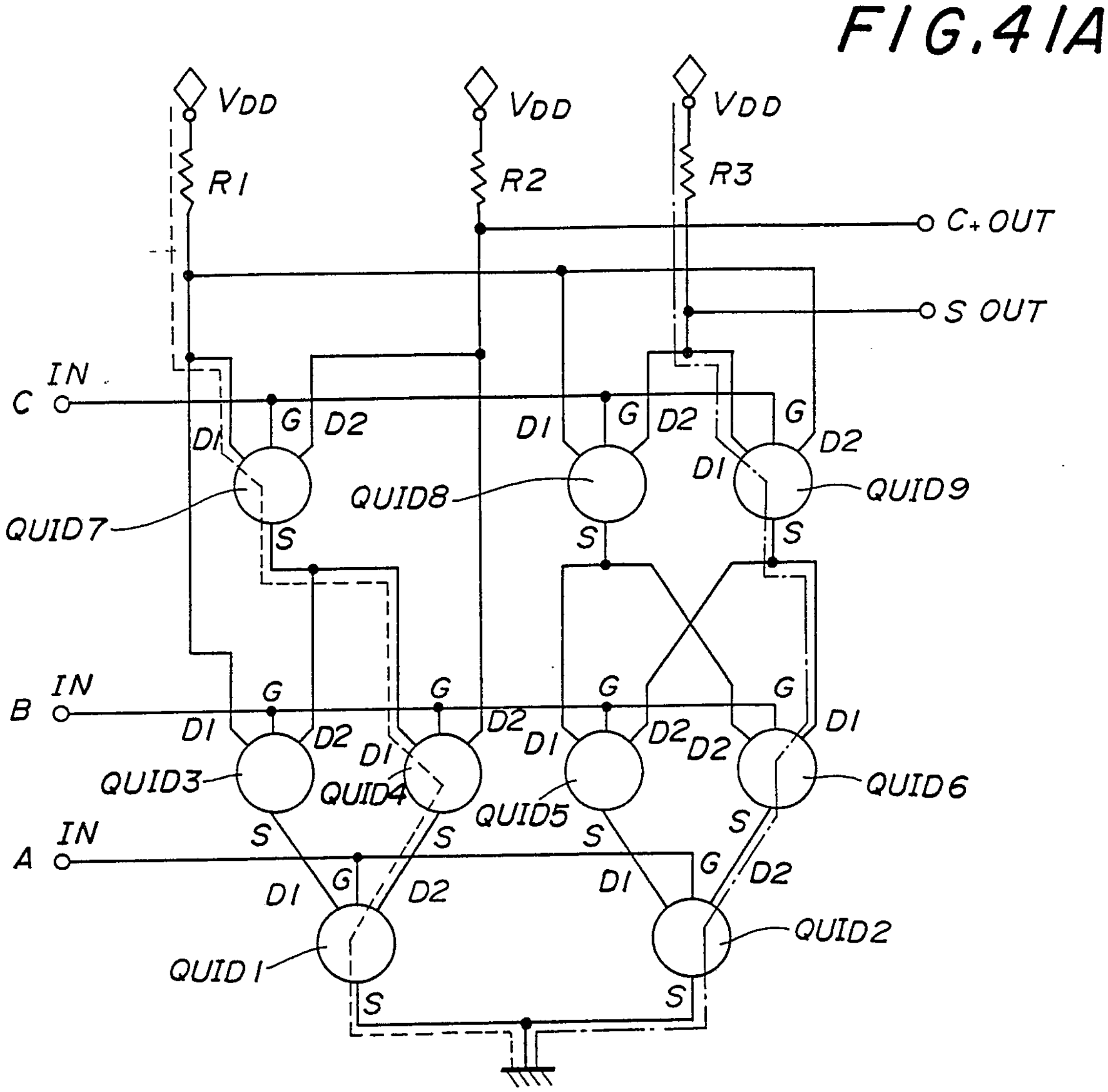


FIG.41B

| IN | | | OUT | |
|---|---|---|---|---|
| A | B | C | S | C+ |
| 0 | 0 | 0 | 0 | 0 |
| 0 | 0 | 1 | 1 | 0 |
| 0 | 1 | 1 | 0 | 1 |
| 0 | 1 | 0 | 1 | 0 |
| 1 | 1 | 0 | 0 | 1 |
| 1 | 1 | 1 | 1 | 1 |
| 1 | 0 | 1 | 0 | 1 |
| 1 | 0 | 0 | 1 | 0 |

FIG. 42A

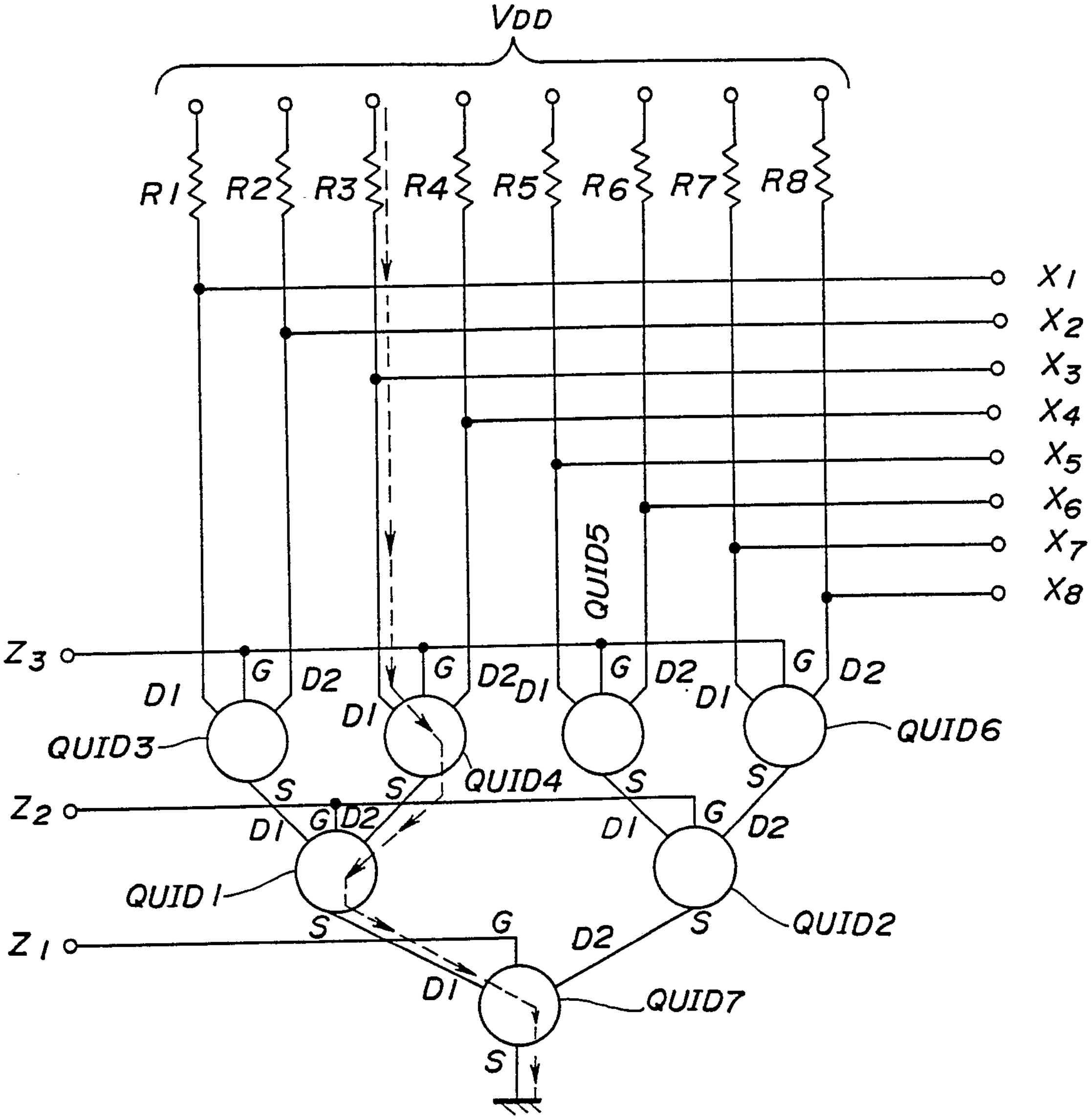


FIG. 42B

| IN | OUT | | | | | | | |
|---|---|---|---|---|---|---|---|---|
| $Z_1 Z_2 Z_3$ | $X_1$ | $X_2$ | $X_3$ | $X_4$ | $X_5$ | $X_6$ | $X_7$ | $X_8$ |
| 0 0 0 | 1 | | | | | | | |
| 0 0 1 | | 1 | | | | | | |
| 0 1 0 | | | 1 | | | 0 | | |
| 0 1 1 | | | | 1 | | | | |
| 1 0 0 | | | | | 1 | | | |
| 1 0 1 | | 0 | | | | 1 | | |
| 1 1 0 | | | | | | | 1 | |
| 1 1 1 | | | | | | | | 1 |

FIG.43A

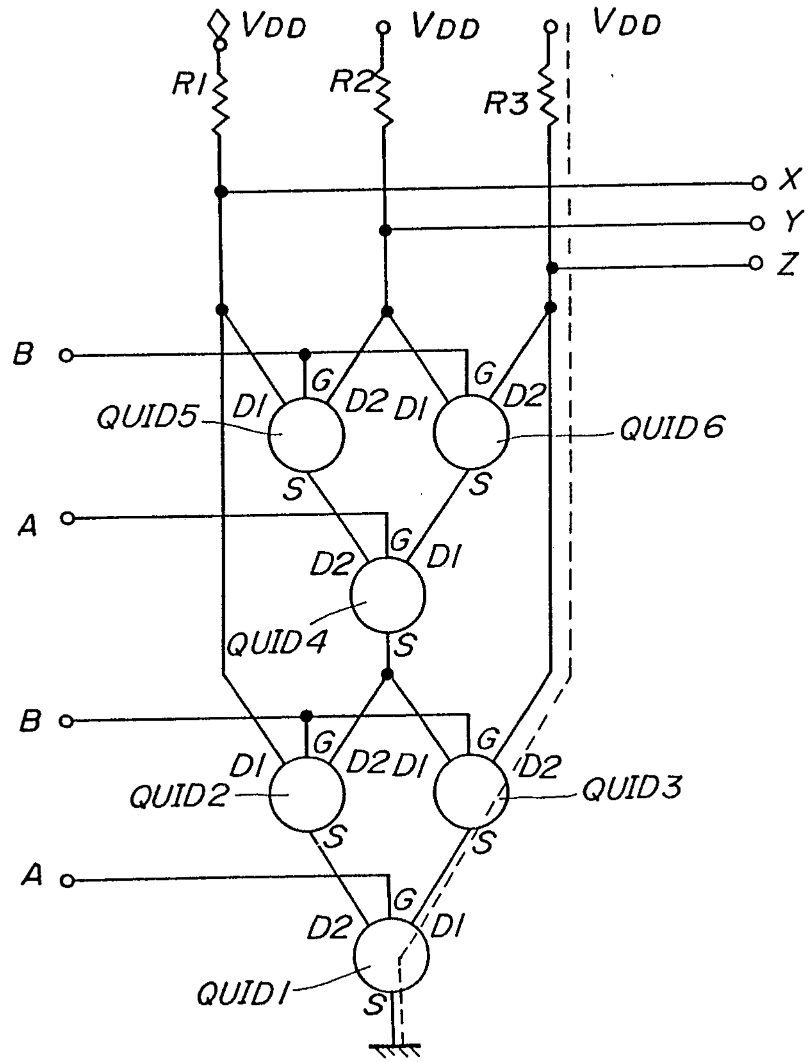


FIG.43B

| IN | | | | OUT | | |
|---|---|---|---|---|---|---|
| $A_1$ | $A_0$ | $B_1$ | $B_0$ | X | Y | Z |
| 0 | 0 | 0 | 0 | 0 | 1 | 0 |
| 0 | 0 | 0 | 1 | 0 | 0 | 1 |
| 0 | 0 | 1 | 0 | 0 | 0 | 1 |
| 0 | 0 | 1 | 1 | 0 | 0 | 1 |
| 0 | 1 | 0 | 0 | 1 | 0 | 0 |
| 0 | 1 | 0 | 1 | 0 | 1 | 0 |
| 0 | 1 | 1 | 0 | 0 | 0 | 1 |
| 0 | 1 | 1 | 1 | 0 | 0 | 1 |
| 1 | 0 | 0 | 0 | 1 | 0 | 0 |
| 1 | 0 | 0 | 1 | 1 | 0 | 0 |
| 1 | 0 | 1 | 0 | 0 | 1 | 0 |
| 1 | 0 | 1 | 1 | 0 | 0 | 1 |
| 1 | 1 | 0 | 0 | 1 | 0 | 0 |
| 1 | 1 | 0 | 1 | 1 | 0 | 0 |
| 1 | 1 | 1 | 0 | 1 | 0 | 0 |
| 1 | 1 | 1 | 1 | 0 | 1 | 0 |